# EUROPEAN PATENT APPLICATION

(11) **EP 2 042 309 A2**
(43) Date of publication of application: **01.04.2009**
(21) Application number: 08017056.6
(22) Date of filing: 26.09.2008
(51) Int. Cl.: B41C 1/10, G03F 7/32

(54) **Method of producing a negative planographic printing plate**

(30) Priority: 28.09.2007 JP 2007256872
(71) Applicant: FUJIFILM Corporation, Minato-ku Tokyo (JP)
(72) Inventor: Nakamura, Takashi, Haibara-gun Shizuoka-ken (JP)
(74) Representative: HOFFMANN EITLE

(57) **Abstract**

The invention a method of producing a negative planographic printing plate of the invention including: exposing, to an infrared laser, a negative planographic printing plate precursor at least having a hydrophilic support, and on the hydrophilic support, a polymerizable recording layer including (A) an infrared absorber, (B) an onium salt, (C) a polymerizable compound having a urethane bond and a plurality of ethylenically unsaturated bonds, and (D) a polyurethane binder, and developing the precursor by using a developer which has a pH of from 11.5 to 12.8 and includes an alkali silicate and an anionic surfactant, the alkali silicate having an SiO₂/M₂O molar ratio of 0.75 to 4.0 wherein M represents an alkali metal or an ammonium group.

## Description

### BACKGROUND OF THE INVENTION

### Technical Field

The present invention relates to a method of producing a negative planographic printing plate having a polymerizable recording layer, the negative planographic printing plate having high sensitivity and high printing durability and on which direct drawing with an infrared laser light can be performed. In particular, the invention relates to a method of producing a negative planographic printing plate, which is free of deterioration in development characteristics even after long-term storage or repeated use, prevents generation of development scums, has excellent developability with respect to a non-image region (light-unexposed region) of the planographic printing plate, prevents generation of printing stains during printing, forms a strong image on an image region (light-exposed region) with less development damage, and uses a developer highly suited for a photopolymerizable planographic printing plate, realizing high printing durability.

### Related Art

In a negative planographic printing plate, an image is formed generally by a process wherein a photosensitive composition is applied onto a support such as an aluminum plate having a roughened surface, and then exposed to desired imagewise light to polymerize or crosslink a light-exposed region, thereby causing the light-exposed region to be insolubilized in a developer; the light-unexposed region is then dissolved and removed by a developer. As compositions used conventionally for the negative planographic printing plate, photopolymerizable compositions are well-known, and several are used in practice. Recently, high-sensitivity photopolymers highly sensitive to visible light, which are obtained by photo-initiation technology, are so sensitive that they are usable in direct plate-making using visible-light lasers, and are used in "Computer to Plate" (CTP) plates.

However, image formation using the photopolymerizable compositions has insufficient workability, and there is an increasing demand for improvement in handleability under yellow light or white light, that is, handleability in a light room, as opposed to a dark room. To cope with this demand, much research has been directed to high-sensitivity photopolymerizable compositions that may be used in an exposing method in combination with ultraviolet (UV) lasers or purple lasers with wavelengths of 300 to 450, nm or infrared (IR) lasers with wavelengths of 800 to 1200 nm (see, for example, Japanese Patent Application Laid-Open (JP-A) Nos. 2000-147763 and 2001-133969).
As CPT plates are increasingly used in a wide range of fields, further improvement in printing durability has also been demanded. For improvement in printing durability, the use of a polyurethane resin as a binder is known to be effective (see JP-A No. 11-352691).

As described above, there is a need for a negative planographic printing plate on which drawing with IR lasers can be performed, and which is excellent in handleability in a light room, and which has high sensitivity and high printing durability. In order to obtain a planographic printing plate having such characteristics, a photopolymerization initiation system including a urethane monomer, a polyurethane binder, an infrared absorber, and an onium salt may be used. However, when an infrared absorber containing an ion pair, or an onium salt, is introduced into a urethane compound having strong hydrogen bonding, the interaction therebetween is increased during long-term storage in particular, thereby causing deterioration in developability giving rise to problems of printing stains on a non-image region and development scums. Another problem is of development scums at the time of a running treatment because of the low solubility of the infrared absorber in a developer.

From the foregoing, it is clear that there is a demand for a method of making a plate from a negative planographic printing plate precursor on which direct drawing with an infrared laser can be performed, and which is free of development scums or printing stains at the time of running treatment and even after long-term storage, and which has high sensitivity and high printing durability.

### SUMMARY OF THE INVENTION

The present invention is directed to a method for making a plate from a negative planographic printing plate precursor on which direct drawing with an infrared laser can be performed, and which is free of development scums or printing stains at the time of running treatment and even after long-term storage, and which has high sensitivity and high printing durability.
According to an aspect of the invention, there is provided a method of producing a negative planographic printing plate of the invention, comprising:
exposing, to an infrared laser, a negative planographic printing plate precursor at least having a hydrophilic support, and on the hydrophilic support, a polymerizable recording layer including (A) an infrared absorber, (B) an onium salt, (C) a polymerizable compound having a urethane bond and a plurality of ethylenically unsaturated bonds, and (D) a polyurethane binder, and
developing the precursor by using a developer which has a pH of from 11.5 to 12.8 and includes an alkali silicate and an anionic surfactant, the alkali silicate having an SiO₂/M₂O molar ratio of 0.75 to 4.0, wherein M represents an alkali metal or an ammonium group.

### DETALIED DESCRITPTION OF THE INVENTION

The polymerizable recording layer of the negative planographic printing plate precursor in the invention is a thermal-type negative recording layer wherein polymerization or curing is caused by exposure to an infrared light laser and subsequent heat evolution of an infrared absorber.

Accordingly, there is provided a method for making a plate from a negative planographic printing plate precursor on which direct drawing with an infrared laser can be performed, and which is free of development scums or printing stains at the time of running treatment and even after long-term storage, and has high sensitivity and high printing durability.

A method of producing a negative planographic printing plate of the invention, includes:
exposing, to an infrared laser, a negative planographic printing plate precursor at least having a hydrophilic support, and on the hydrophilic support, a polymerizable recording layer including (A) an infrared absorber, (B) an onium salt, (C) a polymerizable compound having a urethane bond and a plurality of ethylenically unsaturated bonds, and (D) a polyurethane binder, and
developing the precursor by using a developer which has a pH of from 11.5 to 12.8 and includes an alkali silicate and an anionic surfactant, the alkali silicate having an SiO₂/M₂O molar ratio of 0.75 to 4.0 wherein M represents an alkali metal or an ammonium group.

Negative planographic printing plate precursor
First, the negative planographic printing plate precursor used in the invention is described.
The negative planographic printing plate precursor used in the invention (hereinafter referred to sometimes as "the specific planographic printing plate precursor") at least has, on a hydrophilic support, a polymerizable recording layer including (A) an infrared absorber, (B) an onium salt, (C) a polymerizable compound having a urethane bond and plural ethylenically unsaturated bonds, and (D) a polyurethane binder.
Hereinafter, these respective members and components used in the specific planographic printing plate precursor are described.

### Polymerizable recording layer

The polymerizable recording layer (hereinafter referred to sometimes as "the specific recording layer") in the specific planographic printing plate precursor may include (A) an infrared absorber, (B) an onium salt, (C) a polymerizable compound having a urethane bond and plural ethylenically unsaturated bonds, and (D) a polyurethane binder, and may further include, as necessary, a colorant or other optional components.

Since the specific recording layer is sensitive to infrared light, it may be used for recording with infrared lasers that are useful for CTP. The infrared absorber included in the recording layer is electronically excited with high sensitivity by irradiation with infrared laser light (light exposure). Phenomena accompanying the electronical excitation, such as electron transfer, energy transfer, and heat generation (photothermal conversion function), induce the onium salt included in the recording layer to cause chemical change to generate radicals.
An example of the mechanisms for generation of the radicals includes a mechanism in which the heat generated by the photothermal conversion function of the infrared absorber thermally decomposes the onium salt that will be described later (e.g., sulfonium salt), to generate radicals. Thereafter, the generated radicals initiate the polymerization reaction of the polymerizable compound, and the light-exposed region is cured to form an image region.

The specific planographic printing plate precursor includes an infrared absorber in the specific recording layer, thus making the precursor particularly suitable for making a plate on which direct drawing can be performed by using an infrared laser light having a wavelength of 750 nm to 1400 nm, and may exhibit high image formability as compared with the conventional planographic printing plate precursor.
Hereinafter, the respective components of the specific recording layer are described.

### (A) Infrared absorber

From the viewpoint of improvement in sensitivity, the specific recording layer includes an infrared absorber that is a compound having absorption maximum at 700 to 1200 nm. The specific recording layer includes the infrared absorber, whereby the specific planographic printing plate precursor has sensitivity to light in the infrared wavelength range.
From the viewpoint of compatibility with an easily available high-power laser, the infrared absorber used in the invention is preferably an infrared absorbing dye or an infrared absorbing pigment, which has an absorption maximum in wavelengths of from 760 to 1200 nm.

The infrared absorbing dye may be any one of commercial dyes including known dyes described in e.g. "Senryo Binran" (Dye Handbook) (published in 1970 and compiled by Society of Synthetic Organic Chemistry, Japan). Examples of the dyes include azo dyes, metal complex salt azo dyes, pyrazolone azo dyes, naphthoquinone dyes, anthraquinone dyes, phthalocyanine dyes, carbonium dyes, quinone imine dyes, methine dyes, cyanine dyes, squarylium colorants, pyrylium salts, metal thiolate complexes, oxonol dyes, diimonium dyes, aminium dyes and croconium dyes.

Preferable examples of the infrared absorbing dyes include: cyanine dyes described in JP-A No. 58-125246, JP-A No. 59-84356, JP-A No. 59-202829, JP-A No. 60-78787, and the like; methine dyes described in JP-A No. 58-173696, JP-A No. 58-181690, JP-A No. 58-194595, and the like; naphthoquinone dyes described in JP-A No. 58-112793, JP-A No. 58-224793, JP-A No. 59-48187, JP-A No. 59-73996, JP-A No. 60-52940, JP-A No. 60-63744, and the like; squarylium colorants described in JP-A No. 58-112792, and the like; and cyanine dyes described in UK Patent No. 434,875 and the like.

Near infrared ray-absorbing sensitizers described in US Patent No. 5,156,938 may also be preferably used. Also preferably used are: substituted aryl benzo(thio) pyrylium salts described in US Patent No. 3,881,924; trimethine thiapyrylium salts described in JP-A No. 57-142645 (US Patent No. 4,327,169); pyrylium compounds described in JP-A No. 58-181051, JP-A No. 58-220143, JP-A No. 59-41363, JP-A No. 59-84248, JP-A No. 59-84249, JP-A No. 59-146063, and JP-A No. 59-146061; cyanine colorants described in JP-A No. 59-216146; pentamethine thiopyrylium salts described in US Patent No. 4,283,475; and pyrylium compounds described in JP-B No. 5-13514 and JP-B No. 5-19702.

Other preferable examples of the infrared absorbing dyes include the near infrared absorbing dyes of Formulae (I) and (II) shown in U.S. Patent No. 4,756,993.

Particularly preferable examples among these dyes include cyanine colorants, phthalocyanine dyes, oxonol dyes, squarylium colorants, pyrylium salts, thiopyrylium dyes, and nickel thiolate complexes. From the viewpoint of sensitivity, preferable among these dyes are those represented by the following Formulae (a) to (e), and cyanine colorants represented by the following Formula (a) are most preferable because they give high polymerization activity and are excellent in stability and economical efficiency when used in the recording layer in the invention.

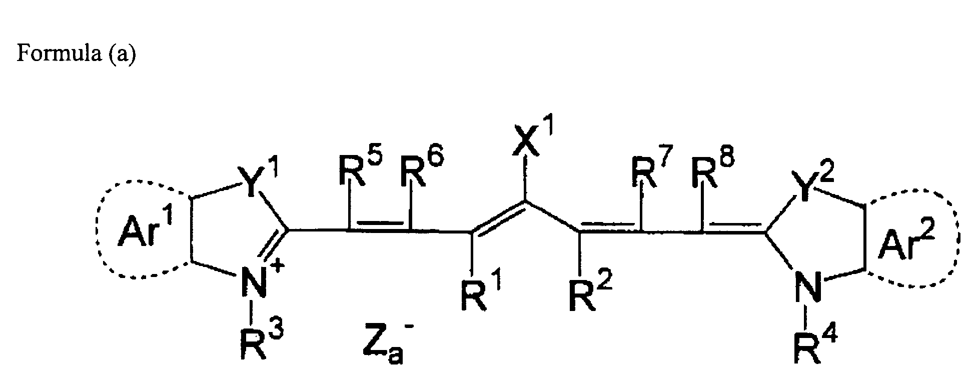

In Formula (a), X¹ represents a hydrogen atom, halogen atom, -NAr^{x}₂, X²-L¹ or the group shown below. Ar^{x} represents an aromatic hydrocarbon group which has 6 to 14 carbon atoms and which may have one or more substituents selected from the group consisting of halogen atoms, alkyl groups, allyl groups, alkenyl groups, alkynyl groups, cyano groups, carboxy groups, nitro groups, amide groups, ester groups, alkoxy groups, amino groups and heterocyclic groups, and these substituents may themselves be substituted by such a substituent as those described above. X² represents an oxygen atom, a sulfur atom or -N(R^{x})- wherein R^{x} represents a hydrogen atom or a hydrocarbon group having 1 to 10 carbon atoms. L¹ represents a hydrocarbon group having 1 to 12 carbon atoms, an aromatic ring having a heteroatom, or a hydrocarbon group which has 1 to 12 carbon atoms and which has a heteroatom. The term "heteroatom" used herein refers to an atom selected from N, S, O, a halogen atom or Se.

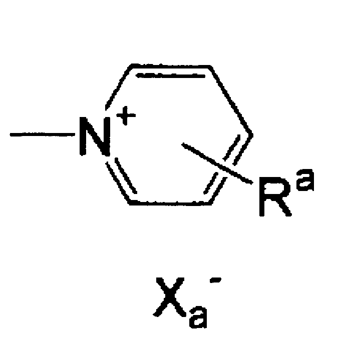

In the above formula, Xa⁻ has the same definition as that of Zₐ⁻ defined later, and R^{a} represents a hydrogen atom or a substituent selected from an alkyl group, an aryl group, a substituted or unsubstituted amino group, or a halogen atom.
R¹ and R² each independently represent a hydrocarbon group having 1 to 12 carbon atoms. For the storage stability of a recording layer coating liquid, each of R¹ and R² is preferably a hydrocarbon group having two or more carbon atoms, and more preferably, R¹ and R² are bound to each other to form a 5- or 6-memberred ring.

Ar¹ and Ar² may be the same as or different from each other, and each independently represent an aromatic hydrocarbon group which may have a substituent. The aromatic hydrocarbon group is preferably a benzene ring or a naphthalene ring. Examples of the substituent preferably include a hydrocarbon group having 12 or less carbon atoms, a halogen atom, and an alkoxy group having 12 or less carbon atoms. Y¹ and Y² may be the same as or different from each other, and each independently represent a sulfur atom or a dialkyl methylene group having 12 or less carbon atoms. R³ and R⁴ may be the same as or different from each other, and each independently represent a hydrocarbon group which has 20 or less carbon atoms and which may have a substituent. Examples of the substituent preferably include an alkoxy group having 12 or less carbon atoms, a carboxyl group and a sulfo group. R⁵, R⁶, R⁷ and R⁸ may be the same as or different from one another, and each independently represent a hydrogen atom or a hydrocarbon group having 12 or less carbon atoms. Each of R⁵, R⁶, R⁷ and R⁸ is preferably a hydrogen atom because the starting material is easily available. Za⁻ represents a counter anion. However, when the cyanine colorant represented by Formula (a) has an anionic substituent in its structure and does not necessitate neutralization of the charge, Zₐ⁻ is not necessary. Because of the storage stability of the recording layer coating liquid, Zₐ⁻ is preferably a halogen ion, a perchlorate ion, a tetrafluoroborate ion, a hexafluorophosphate ion or a sulfonate ion, particularly preferably a perchlorate ion, a hexafluorophosphate ion or an aryl sulfonate ion.

Specific examples of the cyanine colorants represented by Formula (a), which can be used preferably in the invention, include not only those illustrated below, but also those described in paragraph numbers (0017) to (0019) in JP-A No. 2001-133969, paragraph numbers (0012) to (0038) in JP-A No. 2002-40638, and paragraph numbers (0012) to (0023) in JP-A No. 2002-23360.

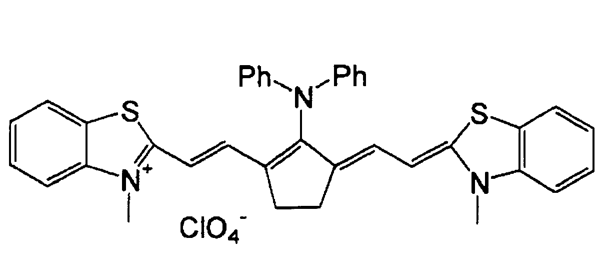

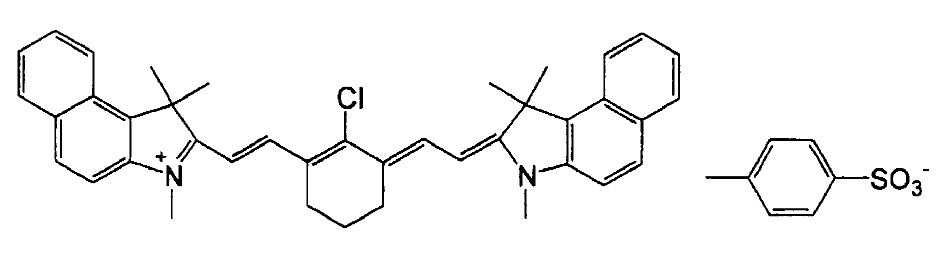

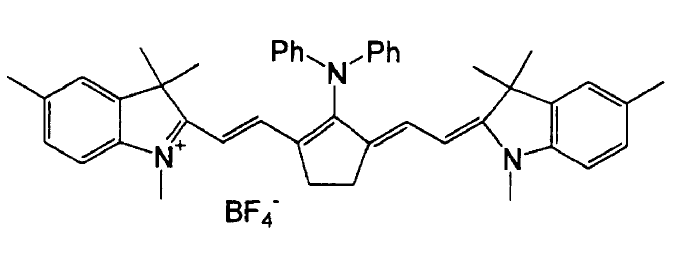

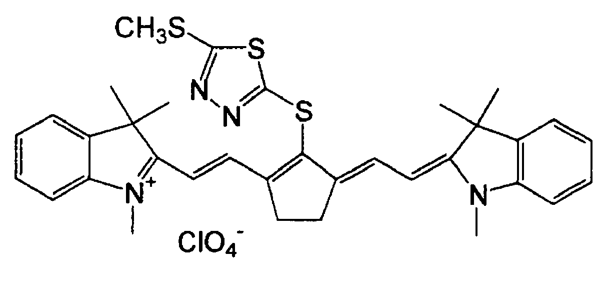

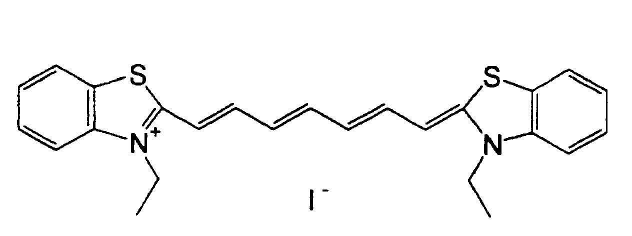

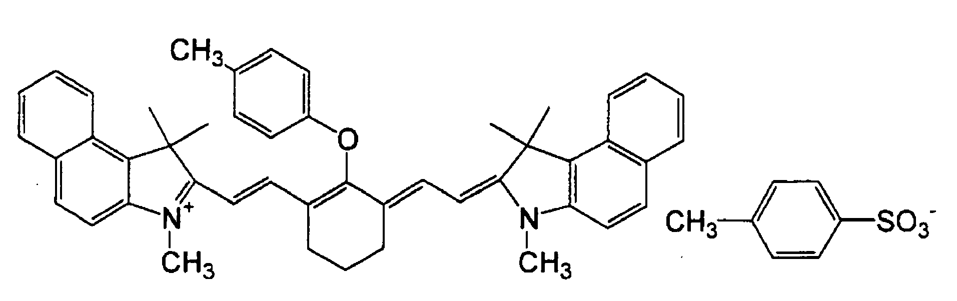

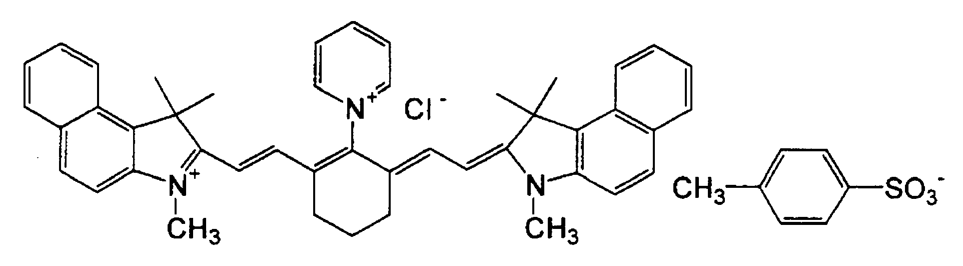

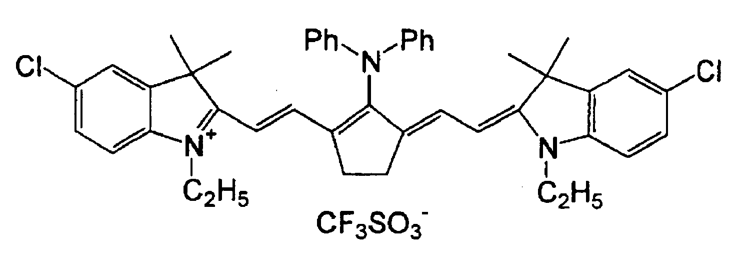

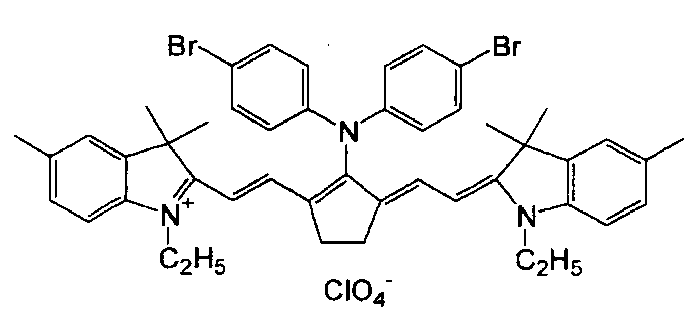

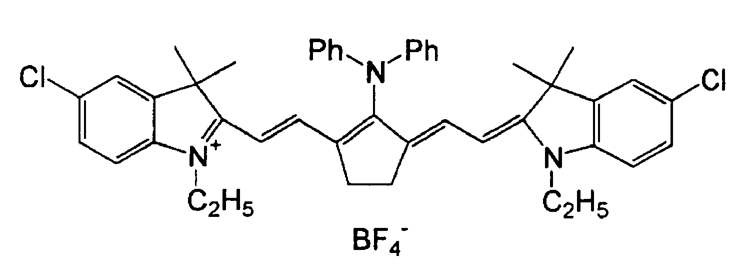

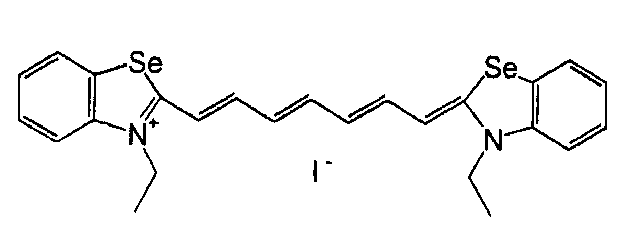

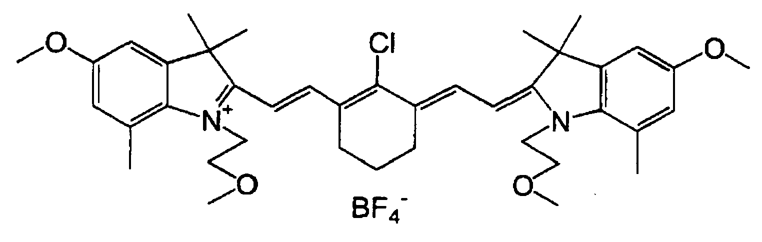

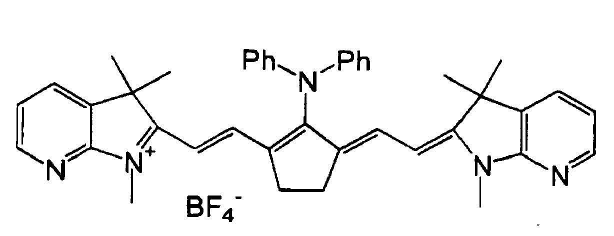

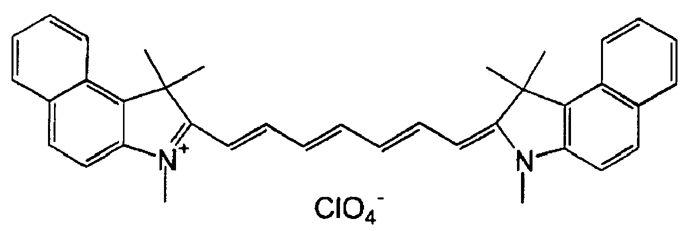

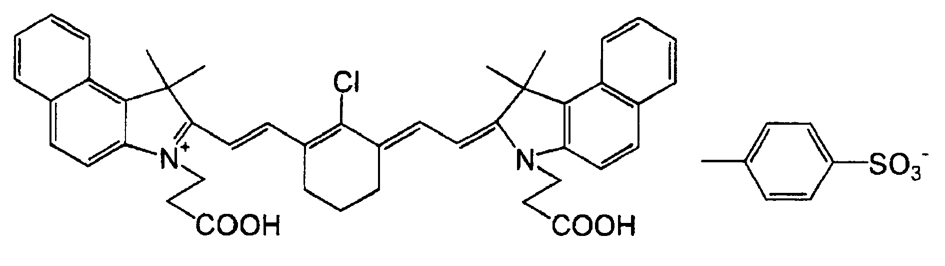

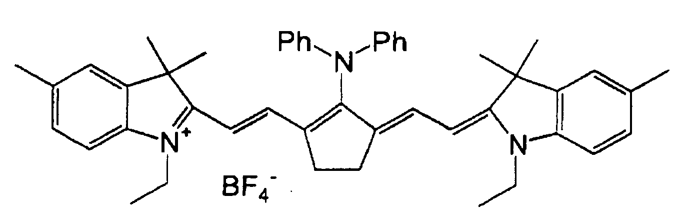

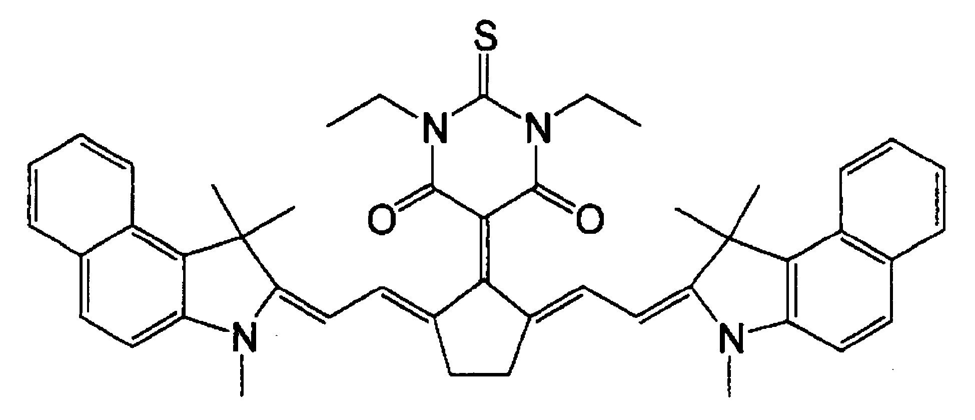

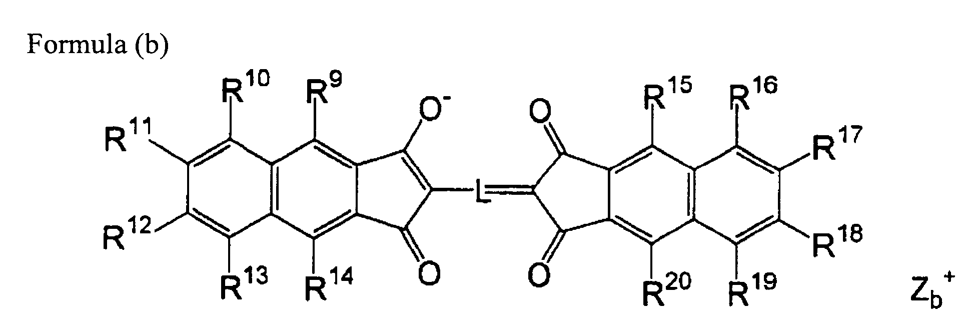

In Formula (b), L represents a methine chain having 7 or more conjugated carbon atoms, and the methine chain may have a substituent, and the substituents may be bound to each other to form a ring structure. Z_{b}⁺ represents a counter cation. The counter cation is preferably ammonium, iodonium, sulfonium, phosphonium, pyridinium or an alkali metal cation (Ni⁺, K⁺, Li⁺). R⁹ to R¹⁴ and R¹⁵ to R²⁰ each independently represent a hydrogen atom or a substituent selected from a halogen atom, a cyano group, an alkyl group, an aryl group, an alkenyl group, an alkynyl group, a carbonyl group, a thio group, a sulfonyl group, a sulfinyl group, an oxy group or an amino group, or a substituent composed of a combination of two or three such substituents which may be bound to each other to form a ring structure. Among the compounds of Formula (b), those having a methine chain having 7 conjugated carbon atoms as L, and those in which each of R⁹ to R¹⁴ and R¹⁵ to R²⁰ represents a hydrogen atom, are preferable from the viewpoint of easy availability and effects.

Examples of the dyes represented by Formula (b), which can be used preferably in the invention, include those illustrated below.

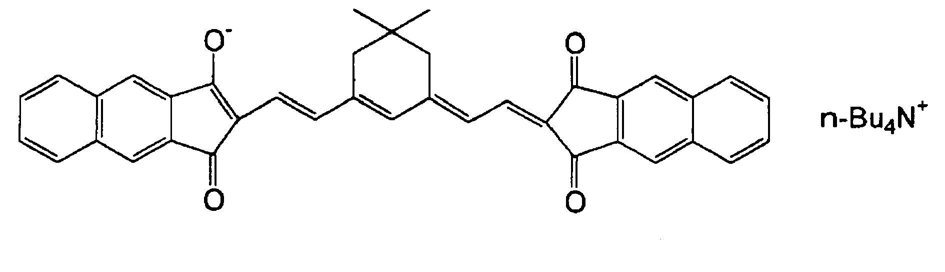

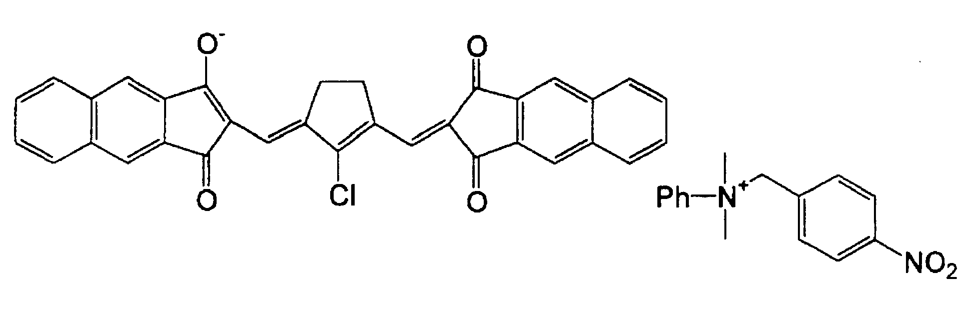

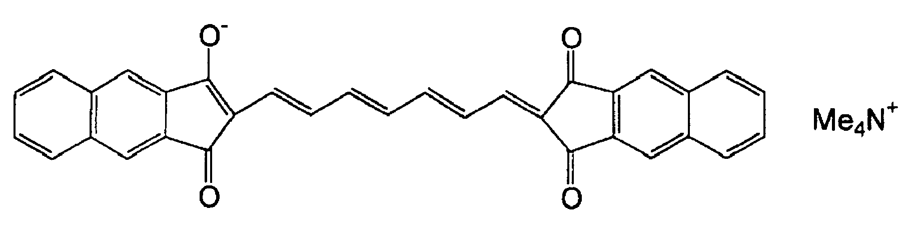

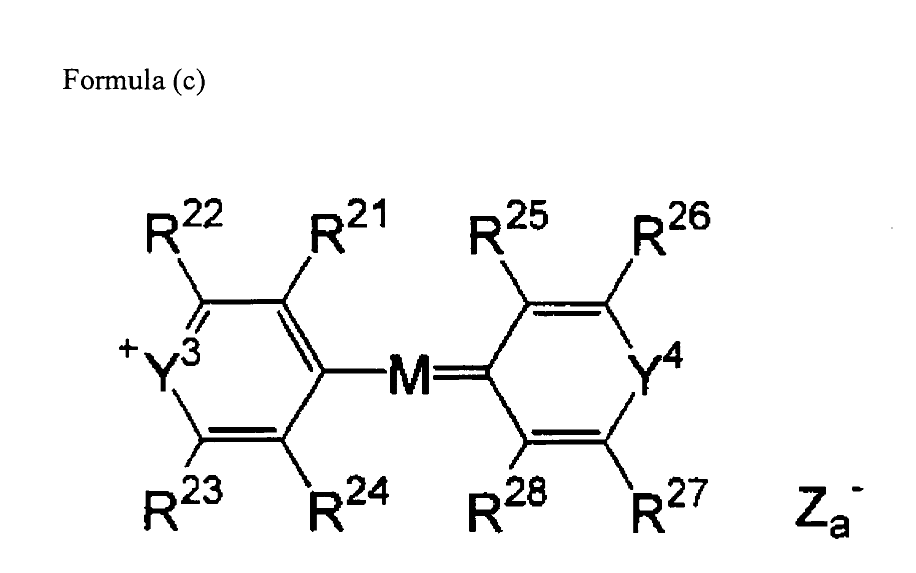

In Formula (c), Y³ and Y⁴ each independently represent an oxygen atom, a sulfur atom, a selenium atom or a tellurium atom; M represents a methine chain having 5 or more conjugated carbon atoms; R²¹ to R²⁴ and R²⁵ to R²⁸ may be the same as or different from one another, and each independently represent a hydrogen atom, a halogen atom, a cyano group, an alkyl group, an aryl group, an alkenyl group, an alkynyl group, a carbonyl group, a thio group, a sulfonyl group, a sulfmyl group, an oxy group or an amino group; and Zₐ⁻ represents a counter anion and has the same definition as that of Zₐ⁻ in Formula (a) above.

Specific examples of the dyes represented by Formula (c), which can be used preferably in the invention, include those illustrated below.

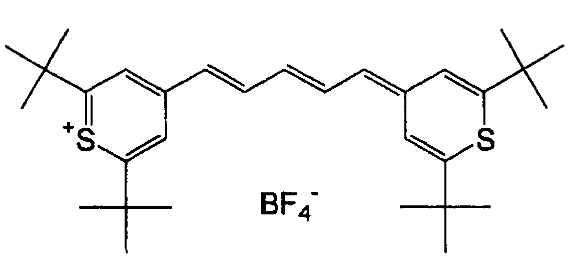

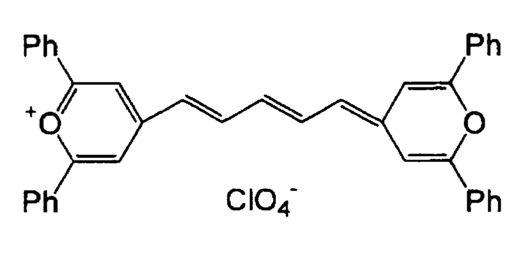

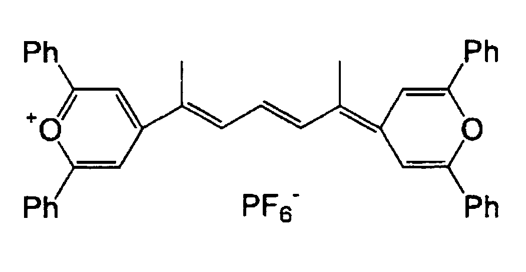

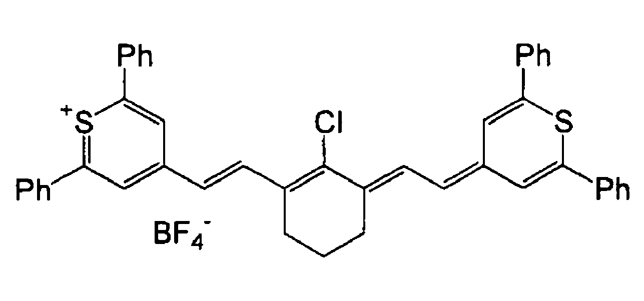

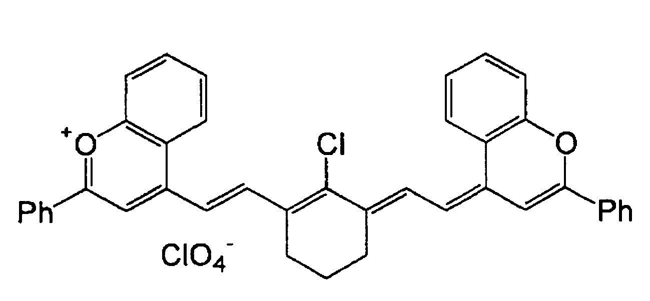

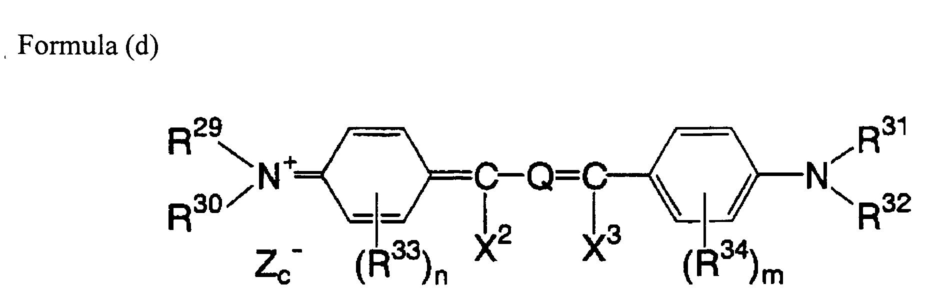

In Formula (d), R²⁹ to R³² each independently represent a hydrogen atom, an alkyl group or an aryl group; R³³ and R³⁴ each independently represent an alkyl group, a substituted oxy group or a halogen atom; n and m each independently represent an integer of 0 to 4; R²⁹ and R³⁰, or R³¹ and R³², may be bound to each other to form a ring; R²⁹ and/or R³⁰ may be bound to R³³ to form a ring; R³¹ and/or R³² may be bound to R³⁴ to form a ring; when plural R³³s are present, some of R³³s may be mutually bound to form a ring; when plural R³⁴s are present, some of R³⁴ may be mutually bound to form a ring; X² and X³ each independently represent a hydrogen atom, an alkyl group or an aryl group, and at least one of X² and X³ represents a hydrogen atom or an alkyl group; Q is an optionally substituted trimethine group or pentamethine group which may form a ring structure with a divalent organic group; and Z_{c}⁻ represents a counter anion and has the same definition as that of Za⁻ in Formula (a) above.

Specific examples of the dyes represented by Formula (d), which can be used preferably in the invention, include those illustrated below.

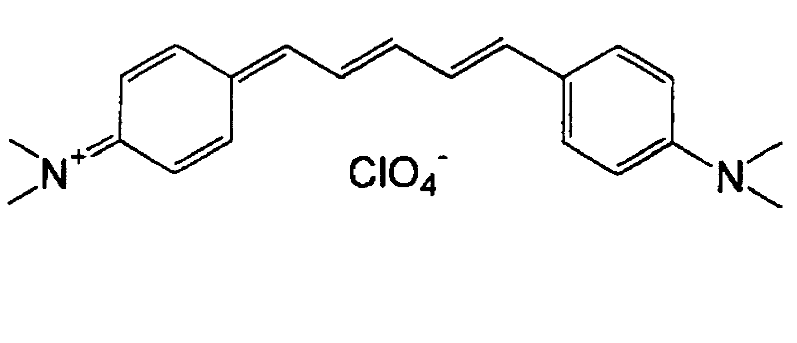

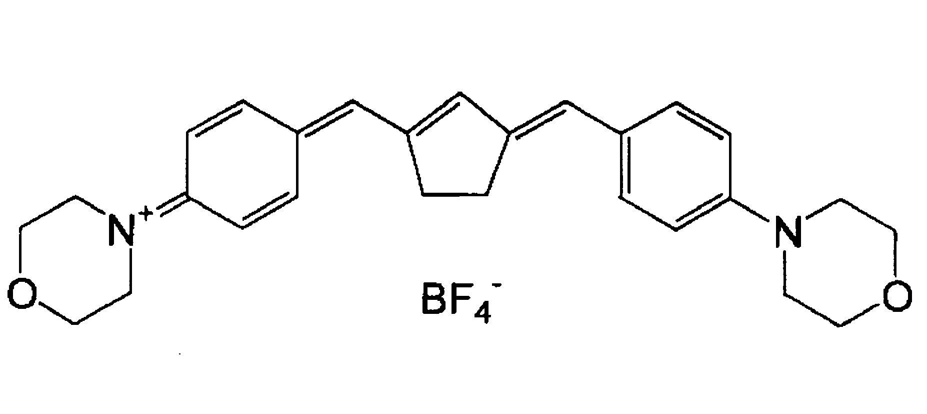

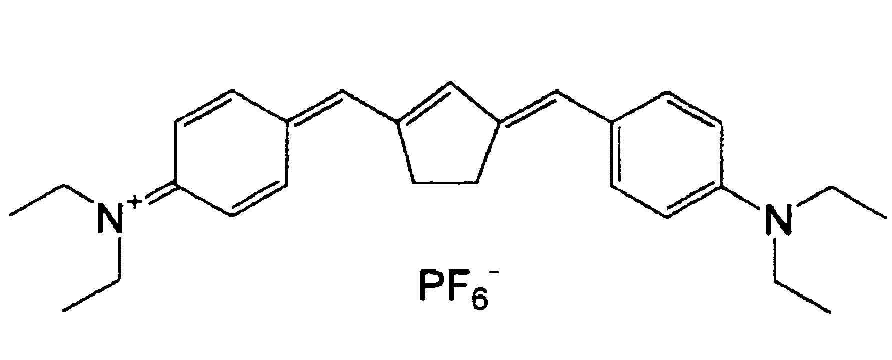

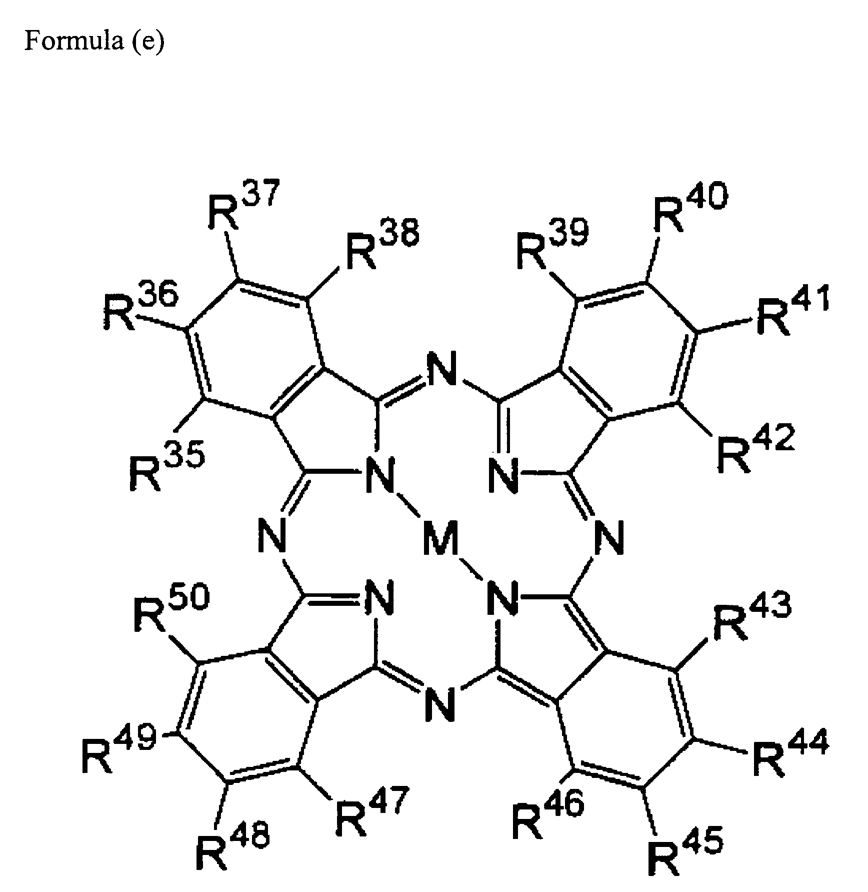

In Formula (e), R³⁵ to R⁵⁰ each independently represent a hydrogen atom, halogen atom, cyano group, alkyl group, aryl group, alkenyl group, alkynyl group, hydroxyl group, carbonyl group, thio group, sulfonyl group, sulfinyl group, oxy group, amino group, or onium salt structure, which may have a substituent; and M represents two hydrogen atoms, a metal atom, a halometal group or an oxymetal group, and examples of the metal atom included therein include the groups IA, IIA, IIIB and IVB atoms in the periodic table, the transition metals in the first, second and third periods, and lanthanoid elements, among which copper, magnesium, iron, zinc, cobalt, aluminum, titanium and vanadium are preferable.

Specific examples of the dyes represented by Formula (e), which can be used preferably in the invention, include those illustrated below.

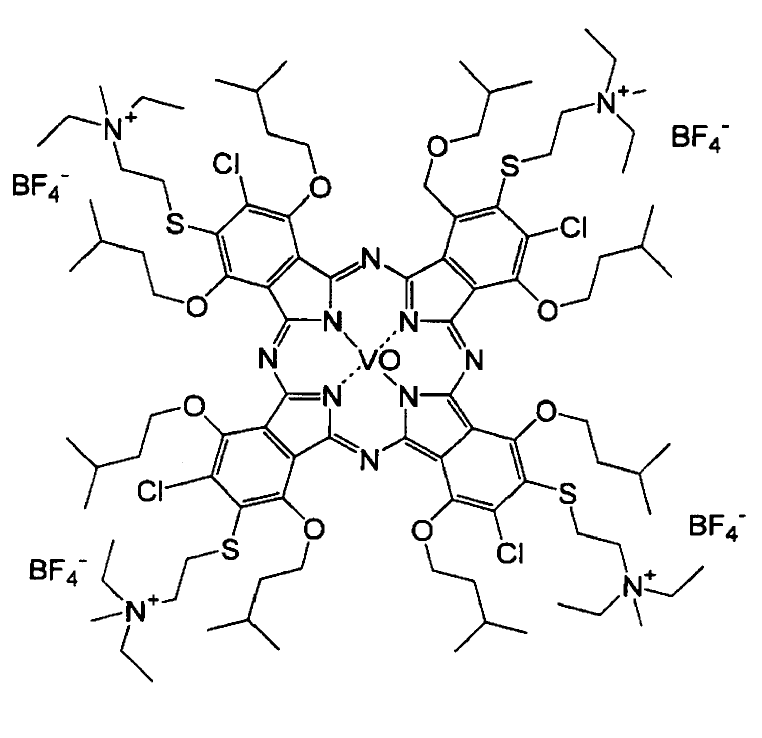

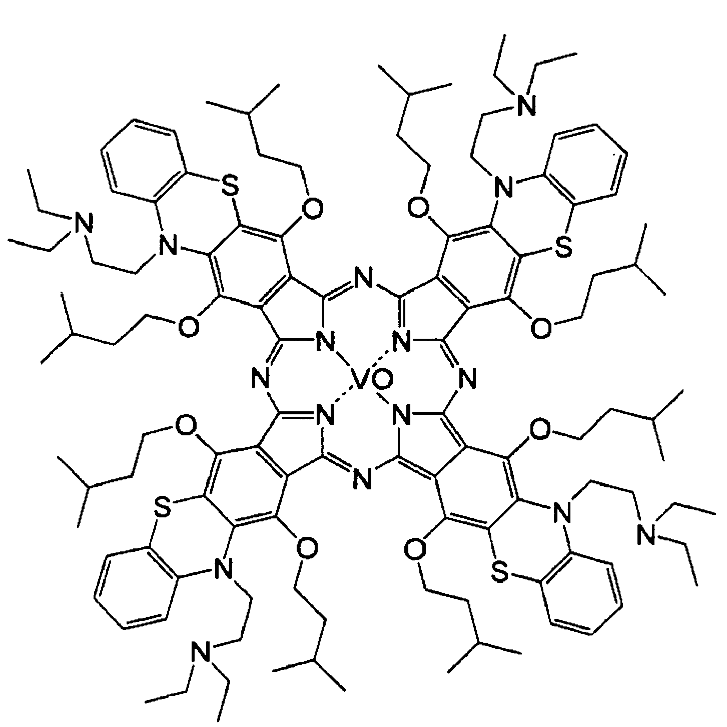

Examples of the pigment used as the infrared absorbing pigment in the invention include commercial pigments and those described in Color Index (C. I.) Handbook, "Saishin Ganryo Binran" (Newest Dye Handbook) (published in 1977 and compiled by Japanese Society of Pigment Technology), "Saishin Ganryo Oyo Gijyutsu" (Newest Pigment Applied Technology) (published in 1986 by CMC), and "Insatsu Inki Gijyutsu" (Printing Ink Technology) (published in 1984 by CMC).

As to the type of the infrared absorbing pigment, examples of usable pigments include black pigments, yellow pigments, orange pigments, brown pigments, red pigments, violet pigments, blue pigments, green pigments, fluorescent pigments, metallic powder pigments, and other pigments such as polymer-binding colorants. Specific examples thereof include insoluble azo pigments, azo lake pigments, condensed azo pigments, chelate azo pigments, phthalocyanine pigments, anthraquinone pigments, perylene pigments, perinone pigments, thioindigo pigments, quinacridone pigments, dioxazine pigments, isoindolinone pigments, quinophthalone pigments, dyed lake pigments, azine pigments, nitroso pigments, nitro pigments, natural pigments, fluorescent pigments, inorganic pigments, and carbon black. A preferable pigment among those is carbon black.

Such pigments may be used with or without being subjected to surface treatment. Examples of the method of surface treatment include a method of coating the surface with a resin or a wax, a method of allowing a surfactant to adhere to the surface, and a method of bonding a reactive substance (e.g., a silane coupling agent, an epoxy compound, a polyisocyanate etc.) onto the surface of the pigment. These methods of surface treatment are described in "Kinzoku Sekken No Seishitsu To Oyo" (Properties and Application of Metallic Soap) (Sachi Shobo), "Insatsu Inki Gijyutsu" (Printing Ink Technology) (published in 1984 by CMC Shuppan) and "Saishin Ganryo Oyo Gijyutsu" (Newest Pigment Applied Technology) (published in 1986 by CMC Shuppan).

The particle diameter of the infrared absorbing pigment is preferably in the range of from 0.01 to 10 µm, more preferably in the range of from 0.05 to 1 µm, and still more preferably in the range of from 0.1 to 1 µm. A pigment particle diameter of less than 0.01 µm is not preferable in respect of the stability of a pigment dispersion in the image recording layer coating liquid, whereas a particle diameter of more than 10 µm is not preferable in respect of the uniformity of the image recording layer.

As the method of dispersing the pigments, any known dispersion techniques used in production of inks or toners can be used. Examples of the dispersing machine include a supersonic dispersing device, a sand mill, an attritor, a pearl mill, a super mill, a ball mill, an impeller, a disperser, a KD mill, a colloid mill, a dynatron, a triple roll mill, and a press kneader. Details thereof are described in "Saishin Ganryo Oyo Gijyutsu" (Newest Pigment Applied Technology) (published in 1986 by CMC Shuppan).

In the invention, the infrared absorbers may be used alone or in combination of two or more thereof.
The infrared absorber (A) in the invention is preferably a cyanine dye. From the viewpoint of sensitivity, the infrared absorber is more preferably one of cyanine dyes represented by Formula (a). Among the dyes represented by Formula (a), cyanine dyes in which X¹ represents a diarylamino group or X²-L¹ are preferable, and those having a diarylamino group are more preferable.
As the infrared absorber (A) in the invention, a cyanine dye having an electron-withdrawing group or a heavy atom-containing substituent at each of indolenine sites at both terminals is also preferable, and for example, the one described in Japanese Patent Application No. 2001-6323 is preferably used. A cyanine dye having a diarylamino group as X¹ and having an electron-withdrawing group at each of indolenine sites at both terminals is most preferable.

The infrared absorber (A) is preferably added in an amount in the range of from 0.5 to 5% by mass with respect to the total solid content of a recording layer. In this range, excellent sensitivity may be achieved due to change in physical properties caused by light exposure, whereby sufficient uniformity and strength of the layer may be maintained.

### (B) Onium salt

The specific recording layer includes an onium salt as a polymerization initiator having a function of initiating and promoting the curing reaction of (C) a polymerizable compound having a urethane bond and plural ethylenically unsaturated bonds, which is described later. Among the onium salts, a sulfonium salt is particularly preferable in the invention.

Examples of the sulfonium salt (sulfonium salt polymerization initiator) used preferably as the polymerization initiator in the invention include sulfonium salts each represented by the following Formula (I).

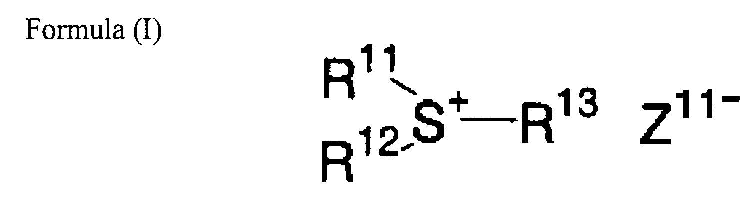

In Formula (I), R¹¹, R¹² and R¹³ may be the same as or different from one another, and each represent a hydrocarbon group which has 20 or less carbon atoms and which may have a substituent. Preferable examples of the substituent include a halogen atom, a nitro group, an alkyl group having 12 or less carbon atoms, an alkoxy group having 12 or less carbon atoms, and an aryloxy group having 12 or less carbon atoms. Z¹¹⁻ represents a counter ion selected from the group consisting of a halogen ion, a perchlorate ion, a tetrafluoroborate ion, a hexafluorophosphate ion, a carboxylate ion, and a sulfonate ion. Z¹¹⁻ is preferably a perchlorate ion, a hexafluorophosphate ion, a carboxylate ion, or an arylsulfonate ion.

Hereinafter, specific examples of the sulfonium salt represented by Formula (I), that is, [OS-1] to [OS-12], are shown. However, the sulfonium salt used in the invention is not limited by those.

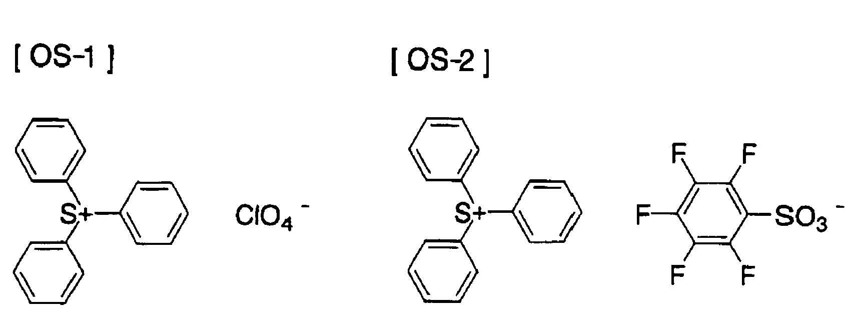

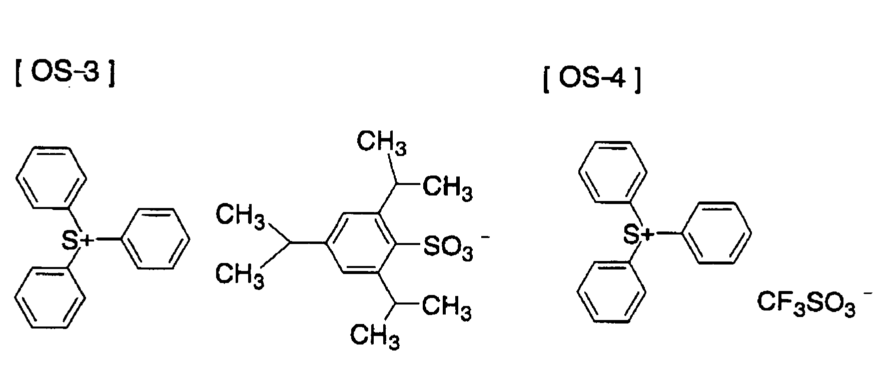

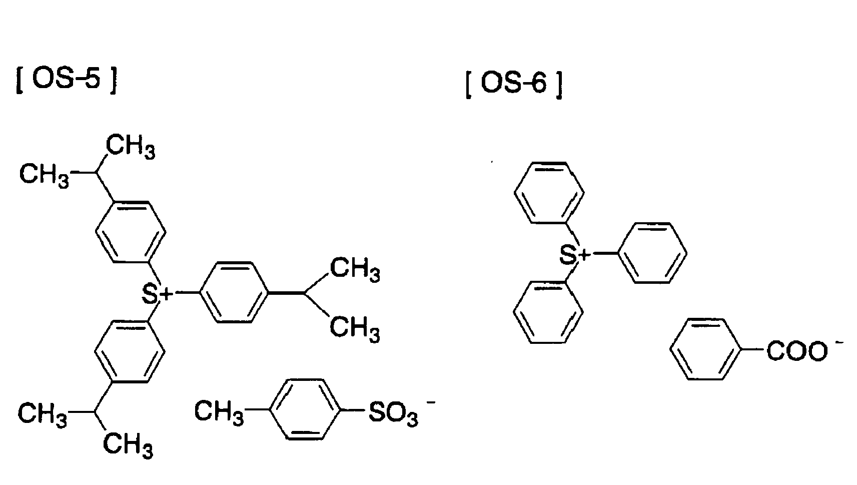

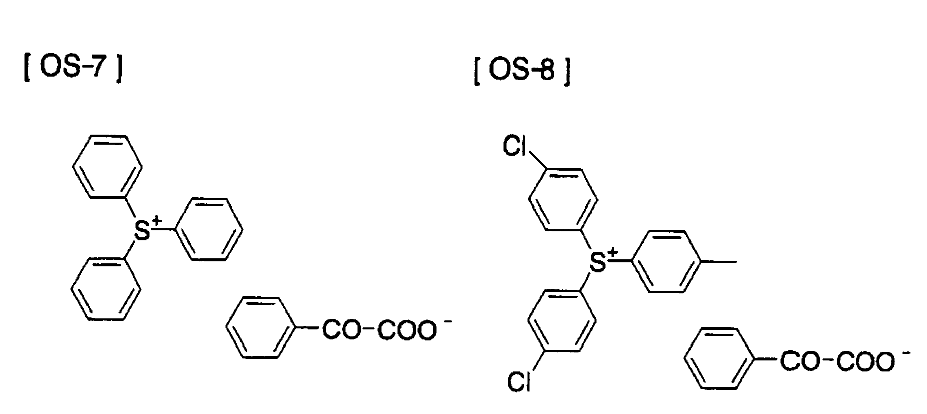

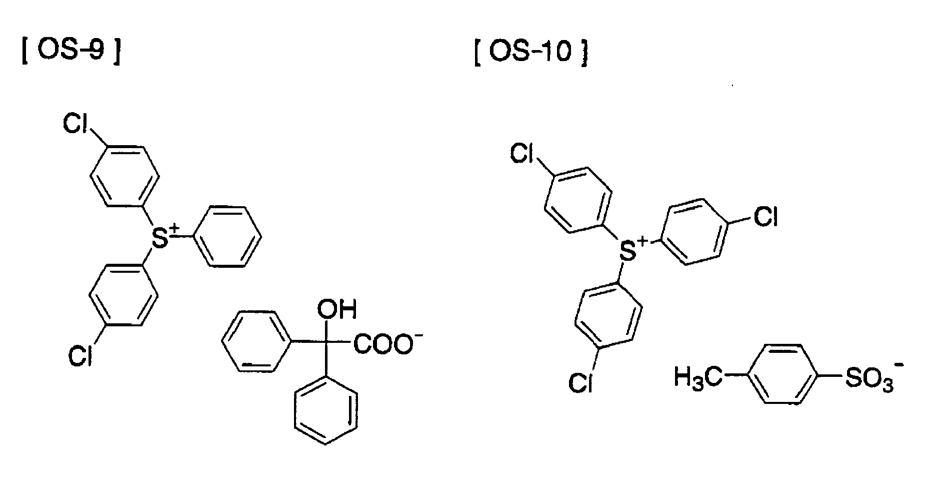

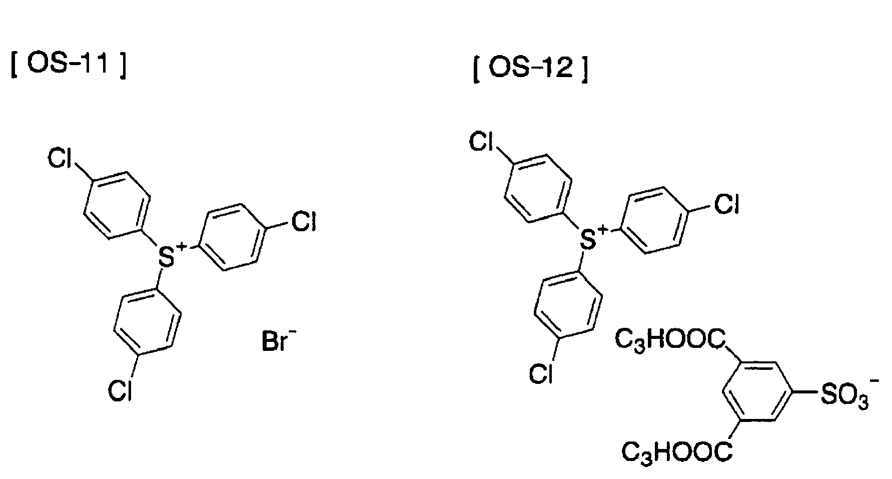

In addition, specific aromatic sulfonium salts described in JP-ANo. 2002-148790, JP-A No. 2002-350207 and JP-A No. 2002-6482 are also preferably used as the polymerization initiator.

In the invention, not only the sulfonium salt polymerization initiator, but also other polymerization initiators (other radical generators) may be used.
Examples of the other radical generators include onium salts other than sulfonium salts, triazine compounds having a trihalomethyl group, peroxides, azo polymerization initiators, azide compounds, quinone diazide, oxime ester compounds, and triaryl monoalkyl borate compounds.

Examples of the other onium salts which may be used preferably in the invention include iodonium salts and diazonium salts. In the invention, these onium salts function as radical polymerization initiators rather than as acid generating agents.
Specific examples of the other onium salts in the invention include onium salts represented by the following Formulae (II) and (III).

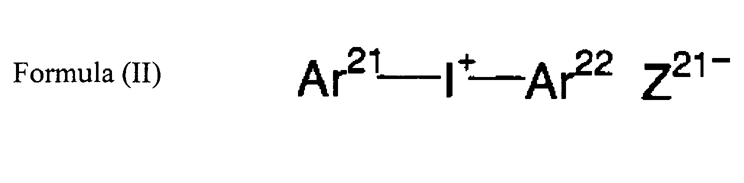

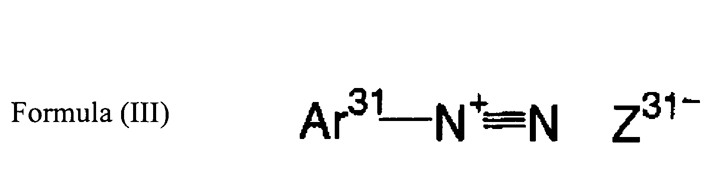

In Formula (II), Ar²¹ and Ar²² each independently represent an aryl group which has 20 or less carbon atoms and may have a substituent. When the aryl group has a substituent, preferable examples of the substituent include a halogen atom, a nitro group, an alkyl group having 12 or less carbon atoms, an alkoxy group having 12 or less carbon atoms, and an aryloxy group having 12 or less carbon atoms. Z²¹⁻ represents a counter ion and has the same definition as that of Z¹¹⁻.

In Formula (III), Ar³¹ represents an aryl group which has 20 or less carbon atoms and may have a substituent. Preferable examples of the substituent include a halogen atom, a nitro group, an alkyl group having 12 or less carbon atoms, an alkoxy group having 12 or less carbon atoms, an aryloxy group having 12 or less carbon atoms, an alkylamino group having 12 or less carbon atoms, a dialkylamino group having 12 or less carbon atoms, an arylamino group having 12 or less carbon atoms, and a diarylamino group having 12 or less carbon atoms. Z³¹⁻ represents a counter ion and has the same definition as that of Z¹¹-.

Specific examples of the onium salt represented by Formula (II), that is, [OI-1] to [OI-10], and specific examples of the onium salt represented by Formula (III), that is, [ON-1] to [ON-5], which may be used preferably in the invention, are shown below. However, the onium salts which may be used in the invention are not limited by those.

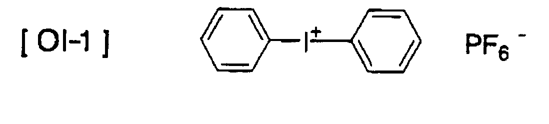

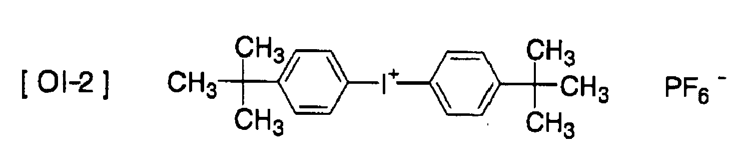

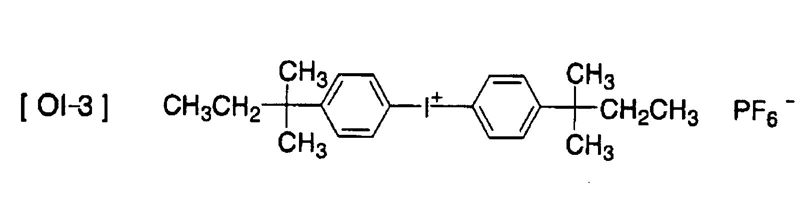

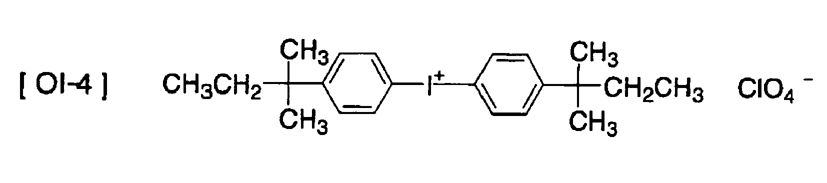

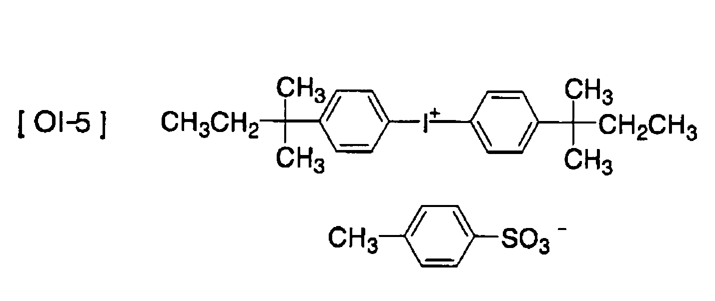

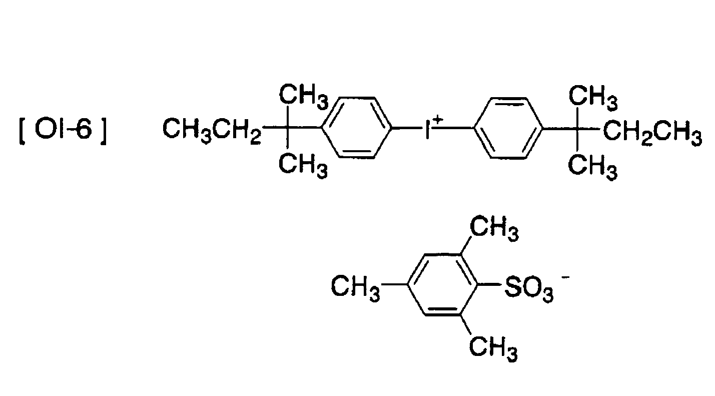

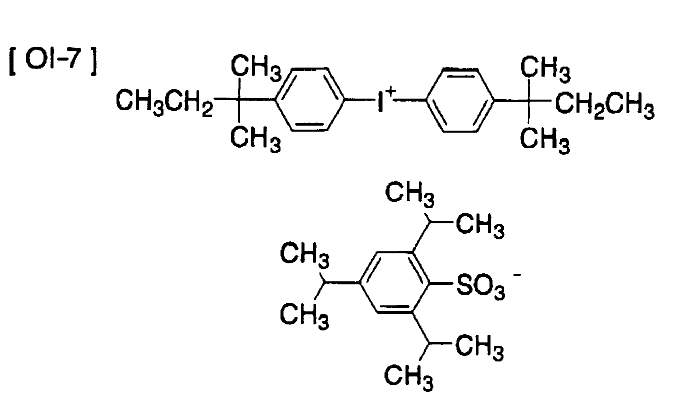

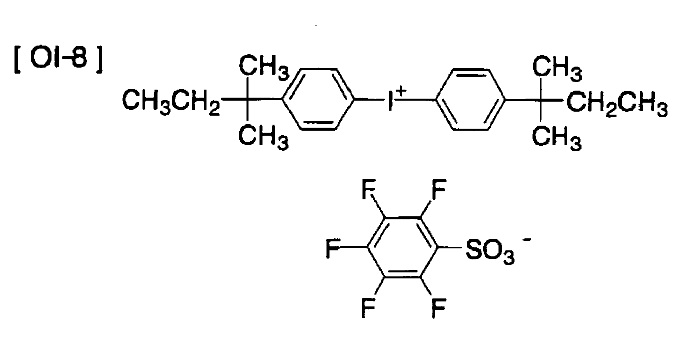

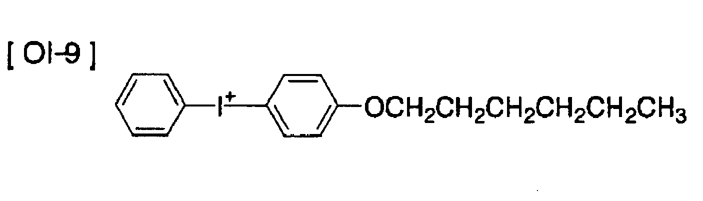

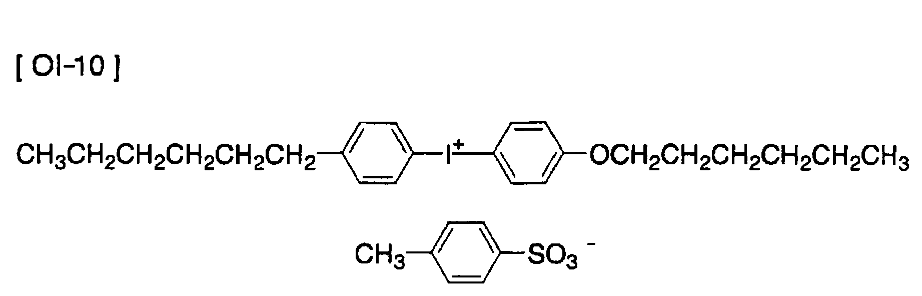

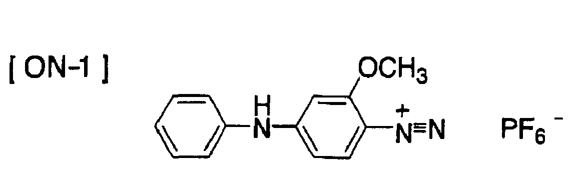

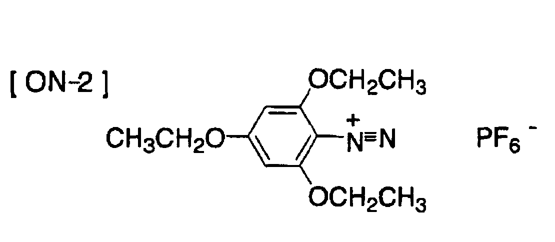

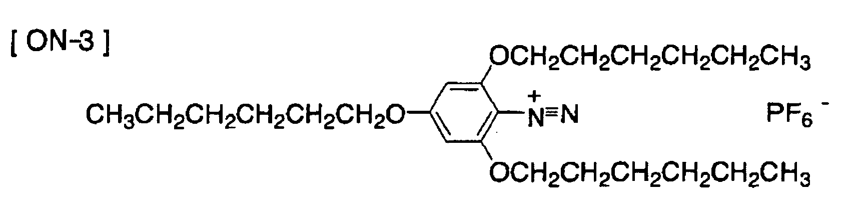

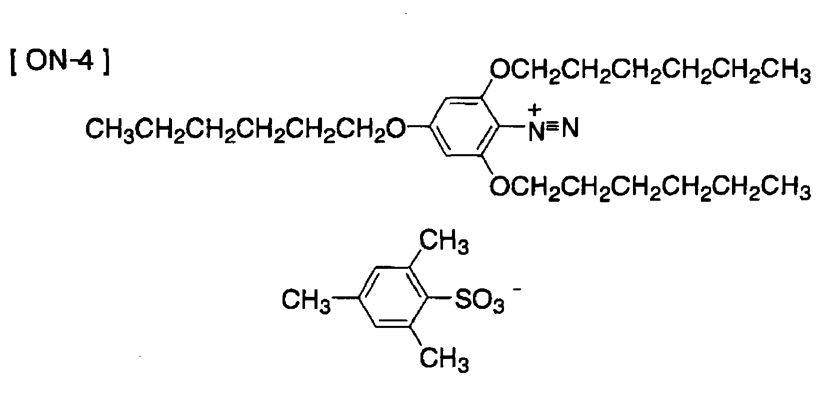

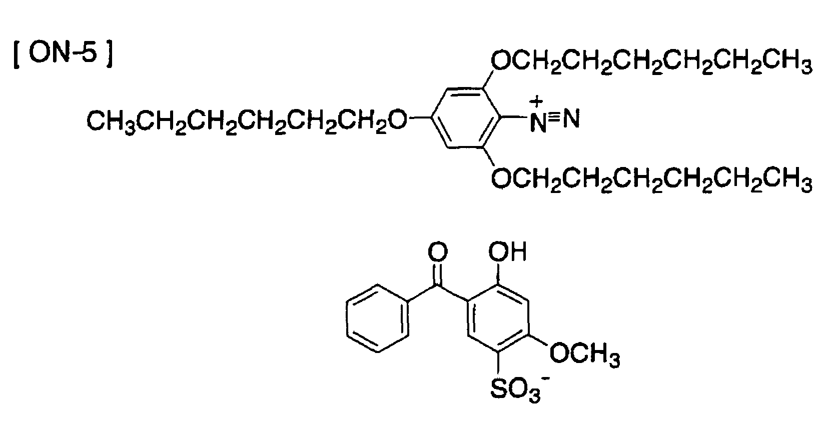

Specific examples of the onium salts preferably used as the polymerization initiator (radical generator) in the invention include those described in JP-A No. 2001-133696.

The onium salt used in the invention has a maximum absorption wavelength of preferably 400 nm or less, more preferably 360 nm or less. When the polymerization initiator has an absorption wavelength in the UV range, the planographic printing plate precursor may be handled under a white lamp.

The total amount of the onium salts in the invention is 0.1 to 50% by mass, preferably 0.5 to 30% by mass, and more preferably 1 to 20% by mass with respect to the total solid content of the recording layer, from the viewpoints of sensitivity and prevention of stains on the non-image portion during printing.

A sulfonyl salt polymerization initiator is preferably included as the onium salt in the invention. Such polymerization initiators may be used alone or in combination of two or more thereof. When two or more polymerization initiators are used in combination, a combination of two or more sulfonium salt polymerization initiators may be used, or a combination of a sulfonium salt polymerization initiator and any other polymerization initiators may be used.
When the combination of a sulfonium salt polymerization initiator and any other polymerization initiators is used, the mass ratio of these initiators is preferably 100/1 to 100/50, and more preferably 100/5 to 100/25.
The polymerization initiator and other components may be included in the same layer or in different layers.

When the highly sensitive sulfonium salt polymerization initiator is used in the recording layer in the invention, the radical polymerization reaction proceeds effectively and the strength of a formed image portion is extremely high. In an embodiment wherein a specific planographic printing plate precursor has a protective layer on a recording layer, a planographic printing plate having an extremely strong image portion together with a high oxygen-blocking function of the protective layer may be produced, and the printing durability of the plate may further be improved thereby. Further, the sulfonium salt polymerization initiator has superior stability over time, so that when the planographic printing plate precursor including the sulfonium salt polymerization initiator is stored, an undesirable polymerization reaction may effectively be suppressed.

### (C) Polymerizable compound having a urethane bond and plural ethylenically unsaturated bonds

The polymerizable compound having a urethane bond and plural ethylenically unsaturated bonds (hereinafter referred to sometimes as "specific polymerizable compound) is described by referring to the compounds having 2 ethylenically unsaturated bonds and the compounds having 3 or more ethylenically unsaturated bonds.
The polymerizable compound having a urethane bond and 2 ethylenically unsaturated bonds (hereinafter referred to sometimes as "bifunctional polymerizable compound") is represented by the following Formula (1).

X-R-U-A-U-R-X Formula (1)

In Formula (1), A represents an alkylene group, an aralkylene group, an arylene group or an oxyalkylene group; U represents a urethane bond; X represents a methacryloyl group, an acryloyl group or a vinyl group; and R represents a divalent linking group such as an oxyalkylene group, an alkyleneoxy group or an aralkylene group.

In Formula (1), A preferably represents a 2,2,4-trimethylhexyl group, an ethylene oxide group, a propylene oxide group, a cyclohexyl group, or the like.
In Formula (1), X preferably represents a methacryloyl group.

Preferable examples of the oxyalkylene group, alkyleneoxy group and aralkylene group each represented by R in Formula (1) are the same as the preferable examples of the oxyalkylene group, alkyleneoxy group and aralkylene group each represented by A.

Specific examples of the bifunctional polymerizable compounds include polymerizable compounds having the following structures (M-1 to M-39).

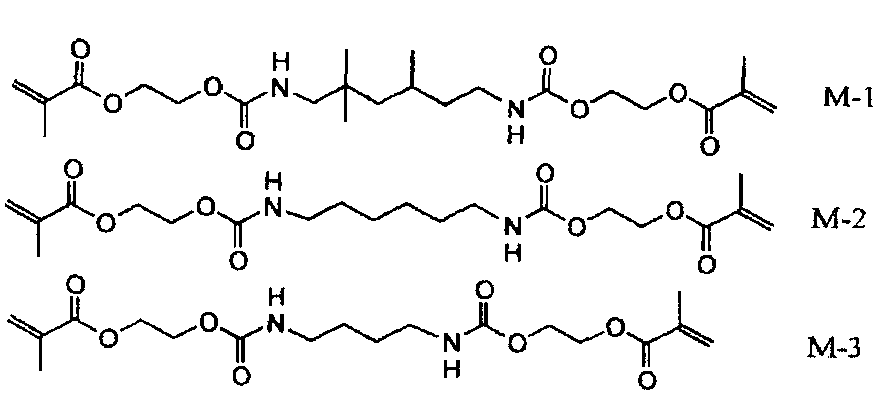

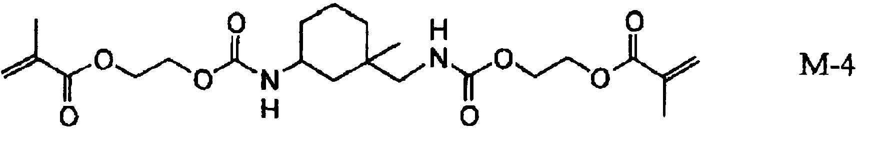

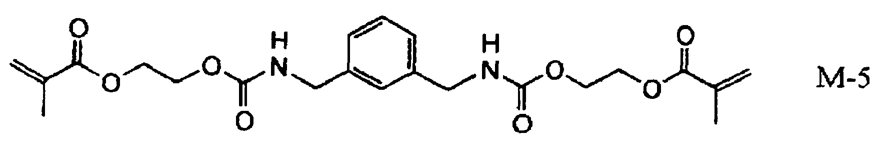

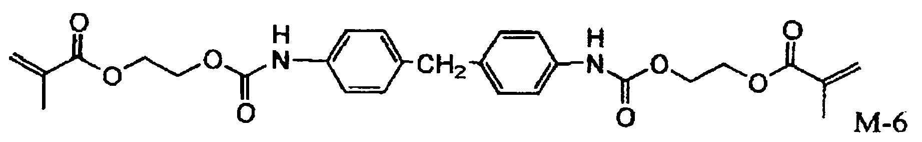

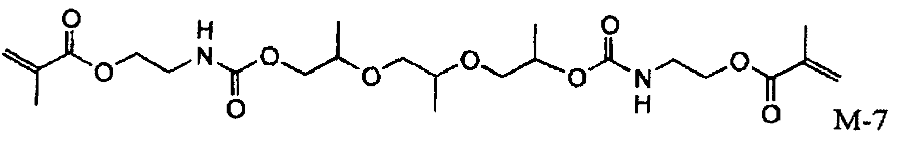

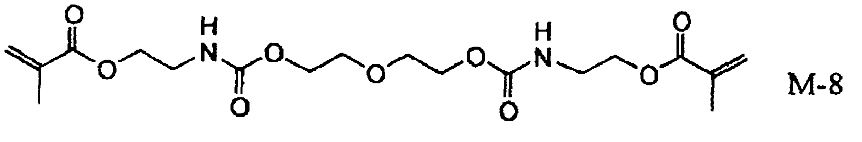

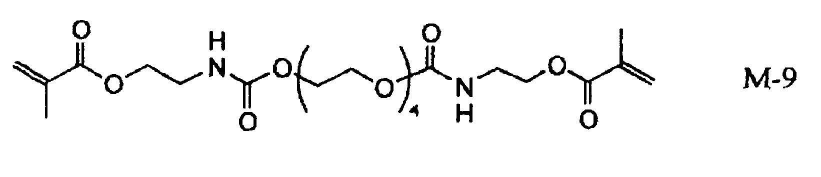

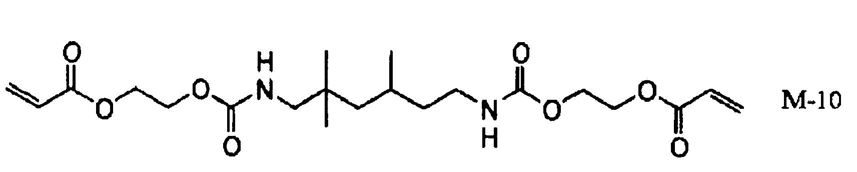

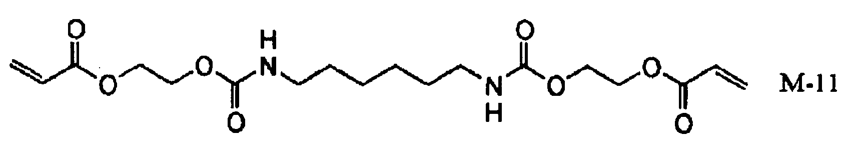

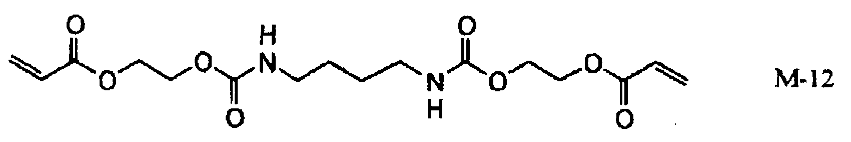

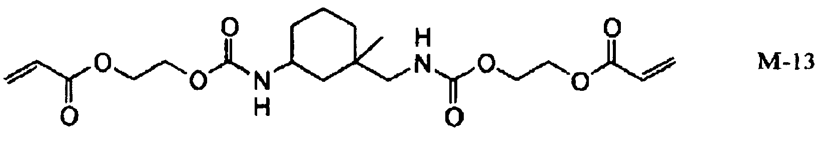

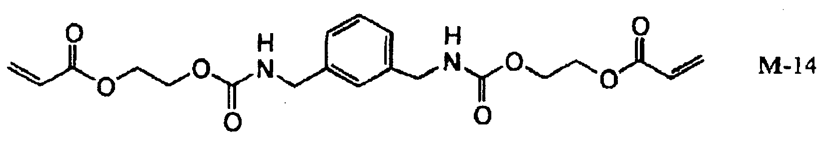

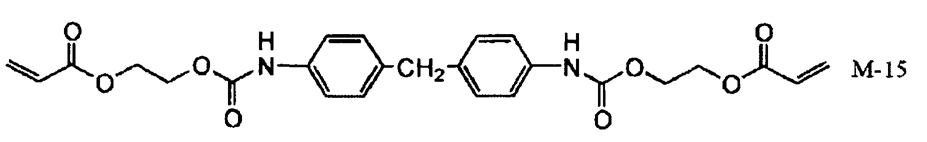

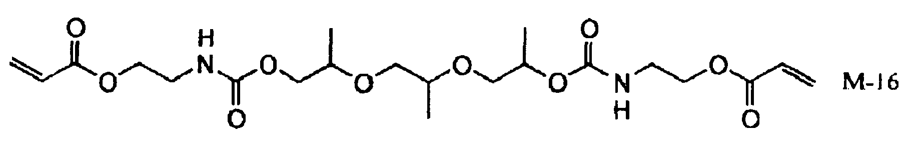

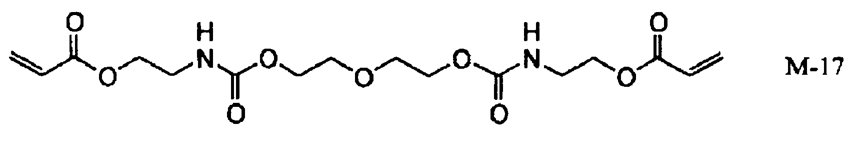

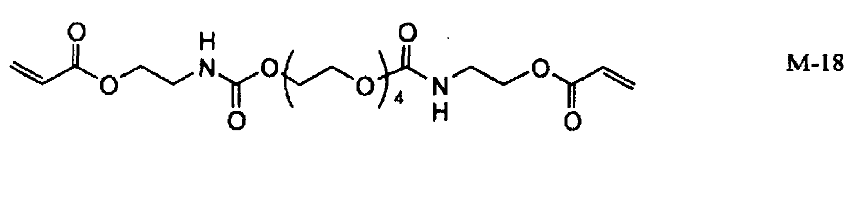

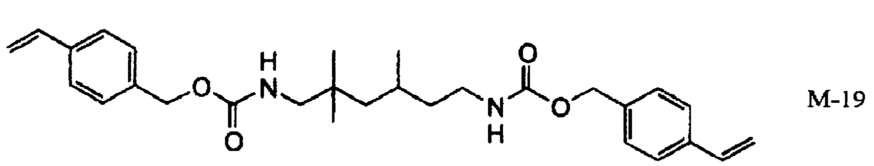

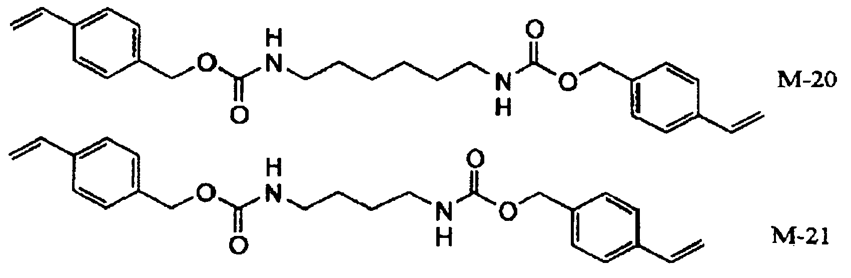

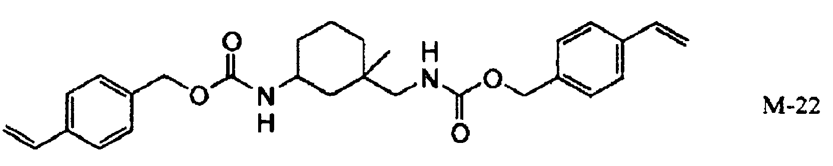

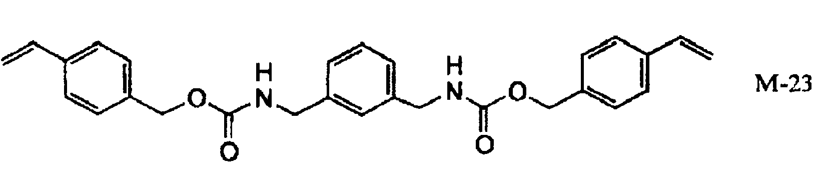

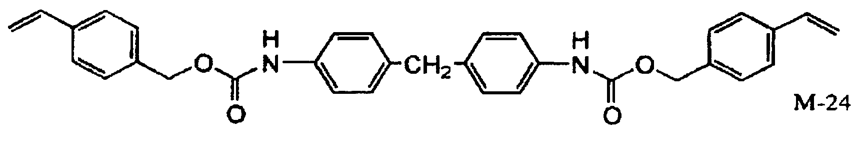

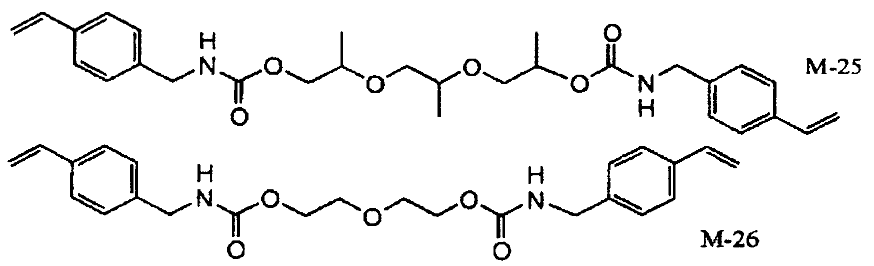

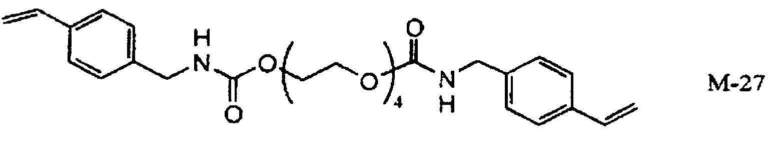

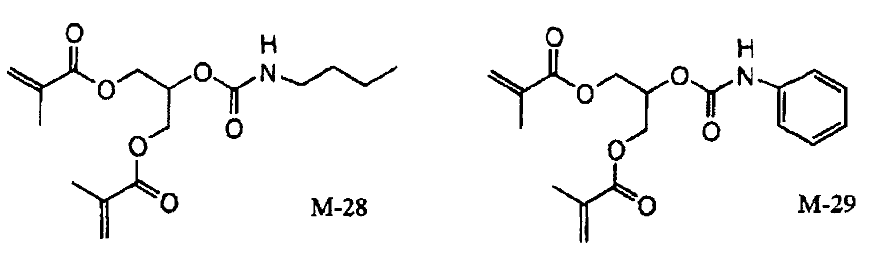

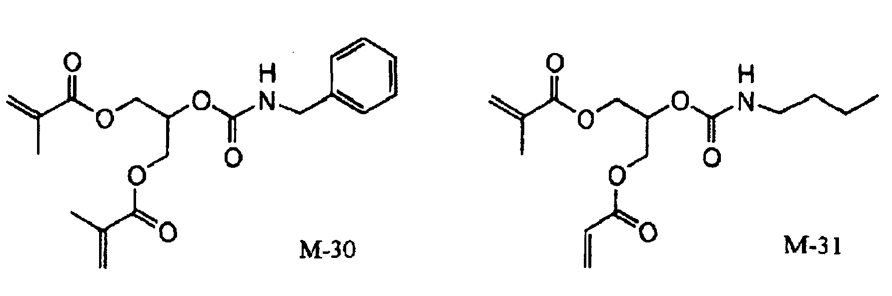

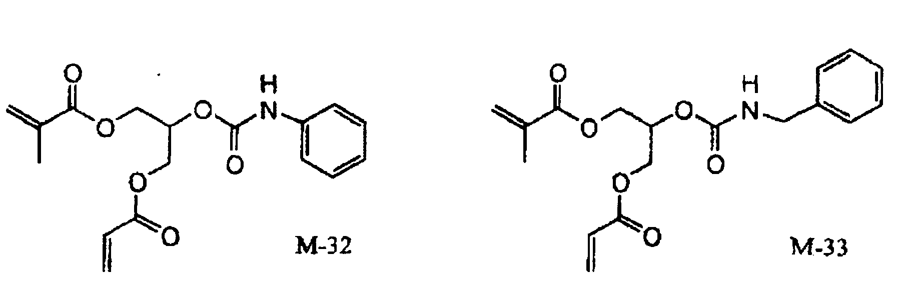

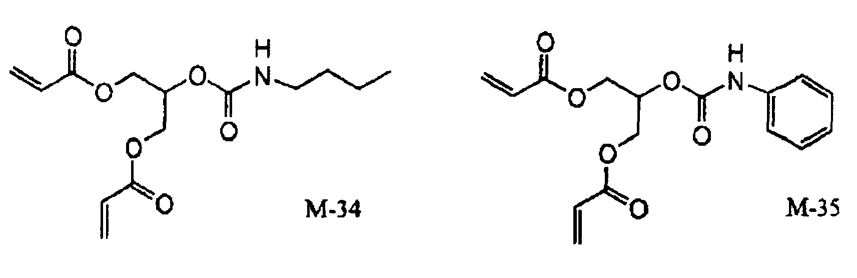

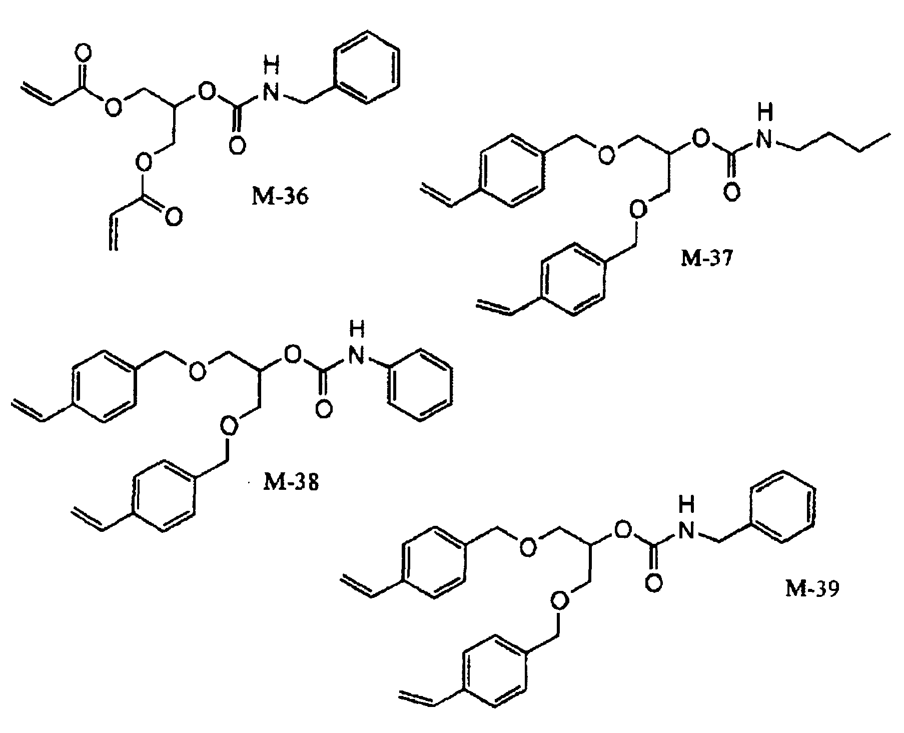

The specific polymerizable compound may have a structure having 3 or more ethylenically unsaturated bonds in a molecule thereof. An example of a polymerizable compound having a urethane bond and 4 or more ethylenically unsaturated bonds is a compound represented by the following Formula (3).

D-(-U-R-(X)ₘ)ₙ (3)

In Formula (3), m represents 2 or 3; n represents 2 or 3; D represents a divalent or trivalent group; U represents a urethane bond; R represents a trivalent or tetravalent linking group including a carbon atom or a combination of carbon and oxygen atoms; and X represents a methacryloyl group, an acryloyl group or a vinyl group.
Specific examples of the specific polymerizable compound having 4 or more ethylenically unsaturated bonds in a molecule thereof include polymerizable compounds having the following structures (N-1 to N-7 and N-15 to N-25).

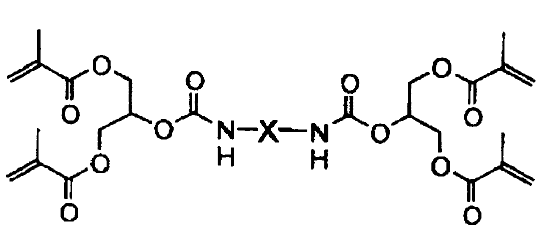

N-1 X : -(CH₂)₆-

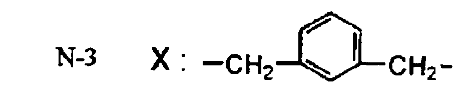

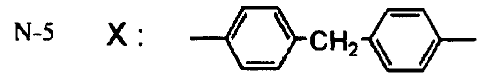

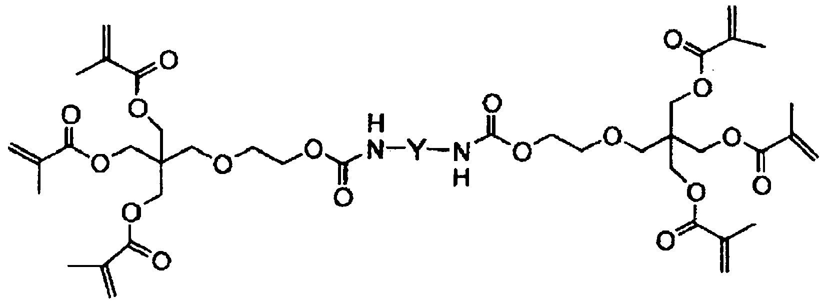

N-2 Y: -(CH₂)₆-

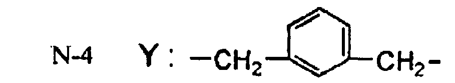

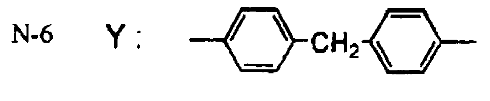

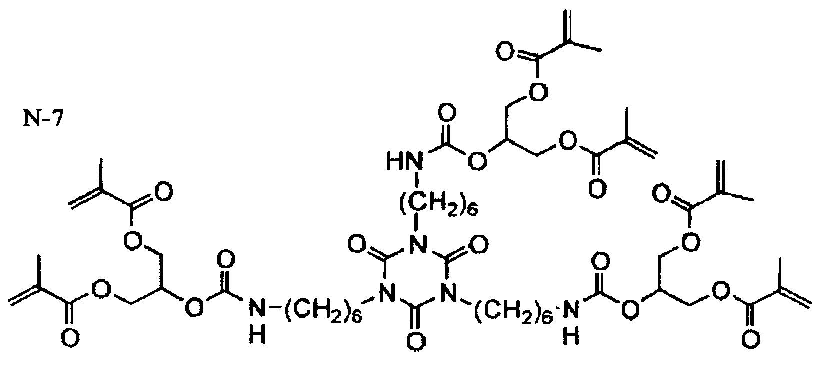

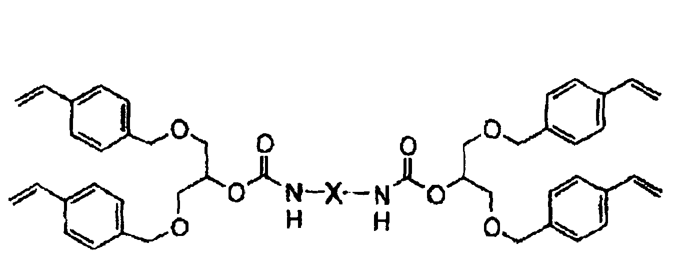

N-15 X : -(CH₂)₆-

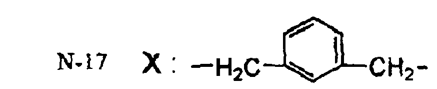

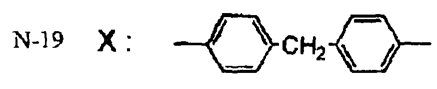

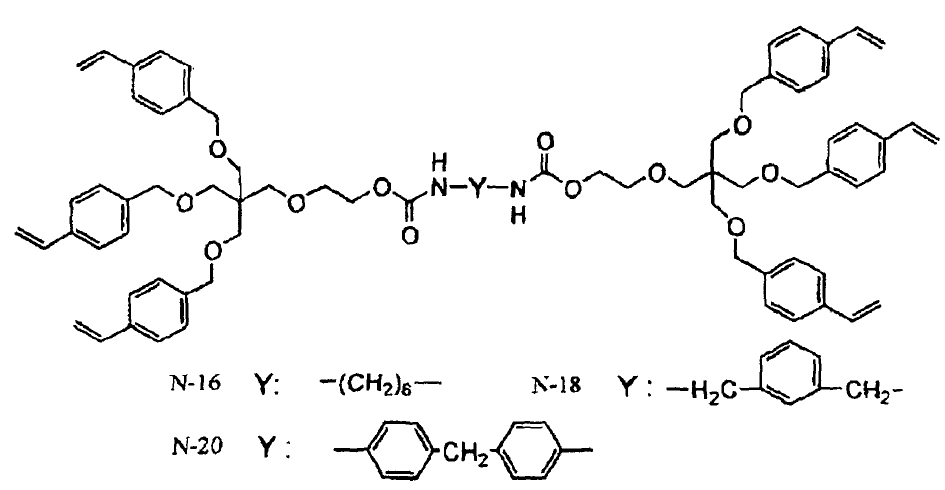

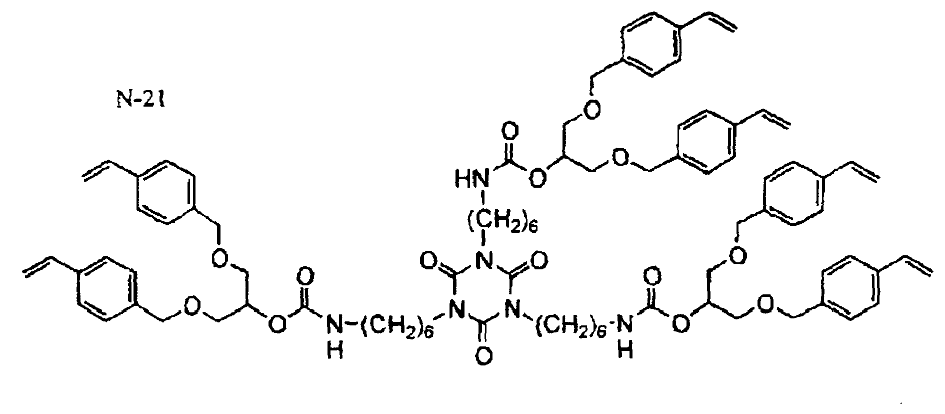

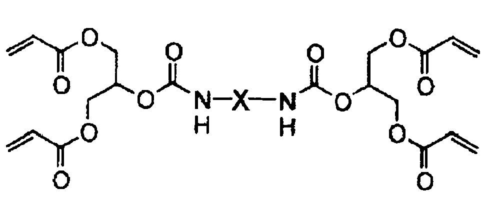

N-22 X : -(CH₂)₆-

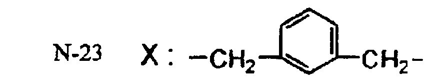

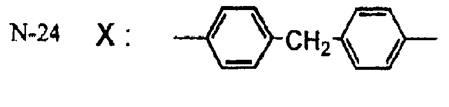

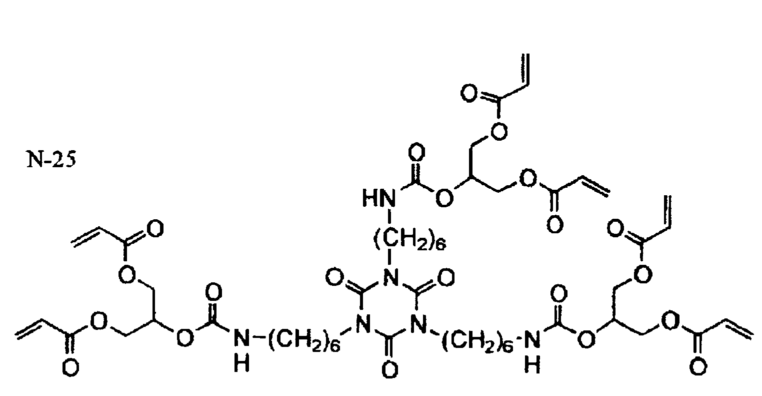

Among the specific examples, the specific polymerizable compound is preferably M-1.

The specific polymerizable compounds may be used alone or in combination of two or more thereof.
The amount (total amount) of the specific polymerizable compounds to be added is preferably 10 to 60% by mass, more preferably 20 to 50% by mass, and still more preferably 30 to 45% by mass, with respect to the total solid content of the recording layer. When the amount of the bifunctional polymerizable compound to be added is 10 to 60% by mass, sensitivity is not low, the recording layer is not sticky, and manufacturability is not inferior.

### (D) Polyurethane binder

The polyurethane binder used in the invention may be obtained by a polyaddition reaction of (i) a diisocyanate compound, (ii) a diol compound having at least one carboxyl group, and (iii) another diol compound not having a carboxyl group.
An example of the polyurethane binder used in the invention is a polyurethane resin having a polymerizable group (crosslinking group) in a side chain thereof. By introducing a crosslinking group into the side chain, high printing durability may be achieved.
The crosslinking group refers to a group that crosslinks the binder in a radical polymerization reaction process which occurs in the recording layer in the negative planographic printing plate upon exposure to light. The crosslinking group is not particularly limited insofar as it is a group having such functions, and examples thereof include functional groups capable of addition polymerization such as an ethylenically unsaturated binding group, an amino group, or an epoxy group. The crosslinking group may be a functional group capable of forming a radical upon irradiation with light, and examples of the crosslinking group include a thiol group, a halogen group, and an onium salt structure. In particular, an ethylenically unsaturated binding group is preferable, and functional groups represented by Formulae (41) to (43) are particularly preferable.

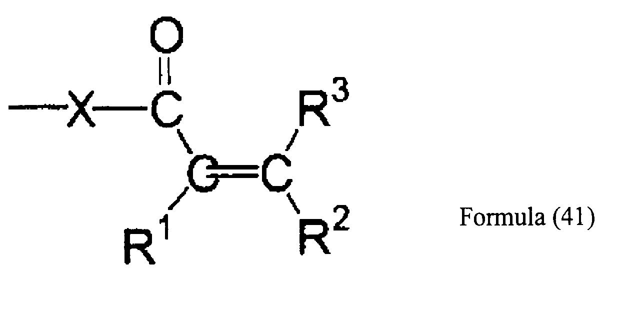

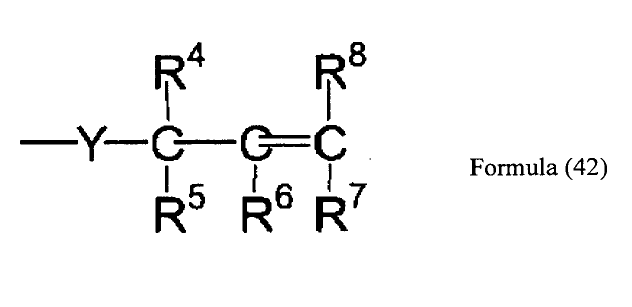

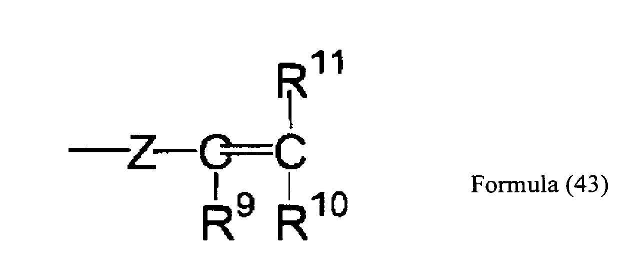

In Formula (41), R¹ to R³ each independently represent a hydrogen atom or a monovalent organic group. Preferable examples of R¹ include a hydrogen atom or an optionally substituted alkyl group, among which a hydrogen atom or a methyl group is particularly preferable from the viewpoint of higher radical reactivity. R² and R³ each independently represent a hydrogen atom, a halogen atom, an amino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group and an optionally substituted arylsulfonyl group, among which a hydrogen atom, a carboxyl group, an alkoxycarbonyl group, an optionally substituted alkyl group and an optionally substituted aryl group are preferable from the viewpoint of higher radical reactivity.

In Formula (41), X represents an oxygen atom, a sulfur atom or N(R¹²) wherein R¹² represents a hydrogen atom or a monovalent organic group. R¹² specifically represents a hydrogen atom, an optionally substituted alkyl group, or the like, among which a hydrogen atom, a methyl group, an ethyl group and an isopropyl group are preferable from the viewpoint of higher radical reactivity.

Examples of the substituent of the optionally substituted alkyl group include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.
In the formula (42), R⁴ to R⁸ each independently represent a hydrogen atom or a monovalent organic group. Preferable examples of R⁴ to R⁸ include a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group and an optionally substituted arylsulfonyl group, among which a hydrogen atom, a carboxyl group, an alkoxycarbonyl group, an optionally substituted alkyl group and an optionally substituted aryl group are preferable.

Examples of the substituents with which the groups represented by R⁴ to R⁸ are further substituted include those described as the substituents with which the groups in Formula (41) are further substituted. Y represents an oxygen atom, a sulfur atom, or N(R¹²). Examples of R¹² include the same groups as for R¹² in Formula (41), and preferable examples are also the same as those described therein.

In Formula (43), R⁹ is preferably a hydrogen atom or an optionally substituted alkyl group, among which a hydrogen atom or a methyl group is preferable from the viewpoint of higher radical reactivity. R¹⁰ to R¹¹ each independently represent a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group, among which a hydrogen atom, a carboxyl group, an alkoxycarbonyl group, an optionally substituted alkyl group, and an optionally substituted aryl group are preferable from the viewpoint of higher radical reactivity.

Examples of the substituents with which the groups represented by R¹⁰ and R¹¹ are further substituted are the same as the substituents with which the groups in Formula (41) are further substituted. Z represents an oxygen atom, a sulfur atom, N(R¹²) or an optionally substituted phenylene group. R¹² has the same definition as that of R¹² in Formula (41), and preferable examples are also the same.
Hereinafter, the diisocyanate compound and diol compound that are the materials of the polyurethane resin are described in detail.

### (i) Diisocyanate compound

Examples of the diisocyanate compound include diisocyanate compounds represented by the following Formula (4).

OCN-L-NCO (4)

In Formula (4), L represents an optionally substituted divalent aliphatic or aromatic hydrocarbon group. If necessary, L may have another functional group that does not react with an isocyanate group, such as a carbonyl group, an ester group, a urethane group, an amido group or a ureido group. Specifically, L represents a single bond or a divalent aliphatic or aromatic hydrocarbon group which may have a substituent (e.g., preferably an alkyl group, an aralkyl group, an aryl group, an alkoxy group or a halogeno group). L represents preferably an alkylene group having 1 to 20 carbon atoms, an allylene group having 6 to 15 carbon atoms, more preferably an alkylene group having 1 to 8 carbon atoms. If necessary, L may have another functional group that does not react with an isocyanate group, such as a carbonyl group, an ester group, a urethane group, an amido group, a ureido group or an ether group.

Specific examples of the diisocyanate compound include: aromatic diisocyanate compounds such as 2,4-tolylene diisocyanate, a 2,4-tolylene diisocyanate dimer, 2,6-tolylene diisocyanate, p-xylylene diisocyanate, m-xylylene diisocyanate, 4,4'-diphenylmethane diisocyanate, 1,5-naphthylene diisocyanate or 3,3'-dimethylbiphenyl-4,4'-diisocyanate; aliphatic diisocyanate compounds such as hexamethylene diisocyanate, trimethylhexamethylene diisocyanate, lysine diisocyanate or dimer acid diisocyanate; alicyclic diisocyanate compounds such as isophorone diisocyanate, 4,4'-methylenebis(cyclohexyl isocyanate), methylcyclohexane-2,4-diisocyanate, methylcyclohexane-2,6-diisocyanate or 1,3-(isocyanatomethyl) cyclohexane; and a diisocyanate compound that is a reaction product of a diol and a diisocyanate, such as an adduct of 1 mole of 1,3-butylene glycol and 2 moles of tolylene diisocyanate.

The diisocyanate compounds may be used alone or in combination of two or more thereof. From the viewpoint of balance between printing durability and staining resistance, the diisocyanate compounds are used preferably in combination of two or more thereof, and a combination of at least one aromatic diisocyanate compound (i.e., L represents an aromatic group) and at least one aliphatic diisocyanate compound (i.e., L represents an aliphatic group) is particularly preferably used.

The amount of the diisocyanate to be used is preferably 0.8 to 1.2 moles, more preferably 0.9 to 1.1 moles with respect to 1 mole of the diol compounds in total. When an excess amount of the diisocyanate compound is used and isocyanate groups remain at terminuses of the polymer molecules, the resultant polyurethane is preferably treated with an alcohol, an amine, or the like after completion of the urethane-forming reaction so that the final polyurethane resin has no residual isocyanate group.

### (ii) Diol compound having at least one carboxyl group

Examples of the diol compound having at least one carboxyl group include diol compounds of Formulae (5), (6) and (7) and compounds produced by ring-opening of tetracarboxylic dianhydride with the diol compound. Diol compounds used for ring-opening of tetracarboxylic dianhydride may be used.

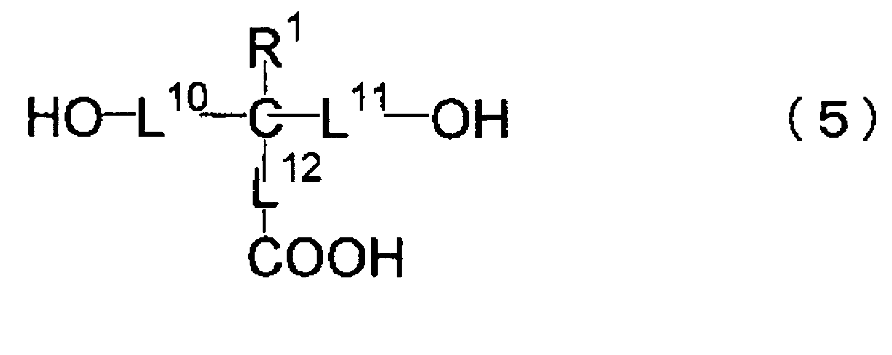

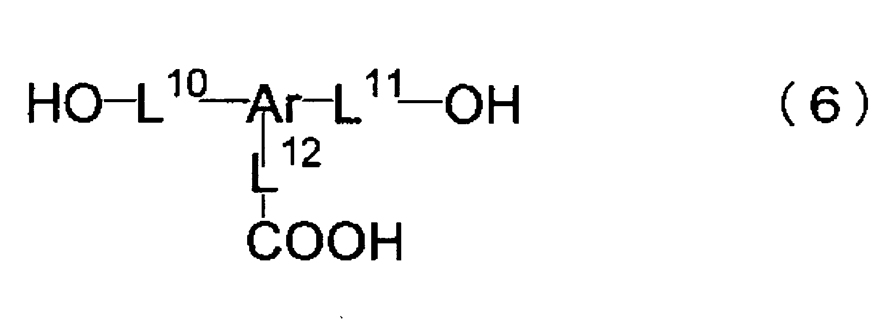

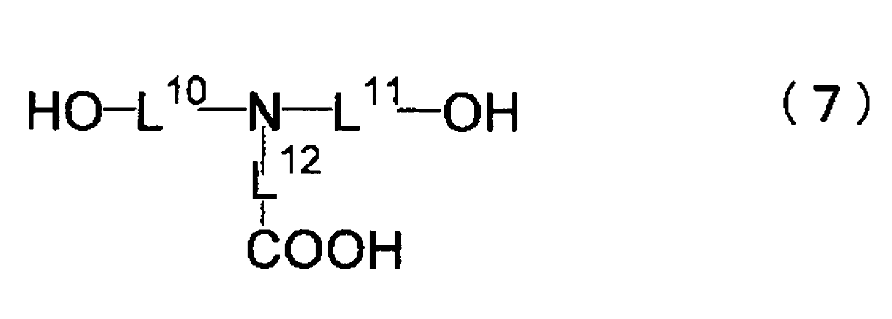

In Formulae (5) to (7), R¹ represents a hydrogen atom or an alkyl, aralkyl, aryl, alkoxy or aryloxy group which may have a substituent (for example, a cyano group, a nitro group, a halogen atom (-F, -Cl, -Br, -I), -CONH₂, -COOR¹¹³, -OR¹¹³, -NHCONHR¹¹³, -NHCOOR¹¹³, -NHCOR¹¹³ or -OCONHR¹¹³ wherein R¹¹³ represents an alkyl group having 1 to 10 carbon atoms or an aralkyl group having 7 to 15 carbon atoms). R¹ preferably represents a hydrogen atom, an alkyl group having 1 to 8 carbon atoms or an aryl group having 6 to 15 carbon atoms. L¹⁰, L¹¹ and L¹² may be the same as or different from one another and each represent a single bond or a divalent aliphatic or aromatic hydrocarbon group which may have a substituent (preferably an alkyl group, an aralkyl group, an aryl group, an alkoxy group or a halogeno group). L¹⁰, L¹¹ and L¹² each represent preferably an alkylene group having 1 to 20 carbon atoms, an allylene group having 6 to 15 carbon atoms, more preferably an alkylene group having 1 to 8 carbon atoms. If necessary, L¹⁰, L¹¹ and L¹² may have another functional group that does not react with an isocyanate group, such as a carbonyl group, an ester group, a urethane group, an amido group, a ureido group or an ether group. Two or three of R¹, L¹⁰, L¹¹ and L¹² may be bound to form a ring. Ar represents an optionally substituted trivalent aromatic hydrocarbon group, preferably an aromatic group having 6 to 15 carbon atoms.

Specific examples of the diol compound which has a carboxyl group and is represented by Formula (5), (6) or (7) include:

3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine, and N,N-bis(2-hydroxyethyl)-3-carboxy-propionamide.

Preferable examples of the tetracarboxylic dianhydride that is used in production of at least one diol compound having at least one carboxyl group include those represented by the following Formulae (8), (9) and (10).

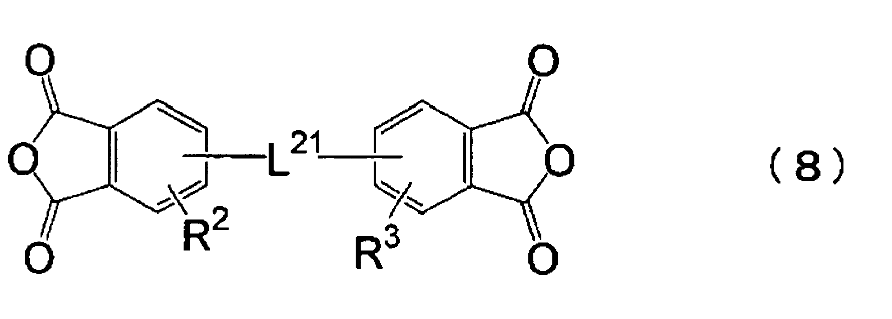

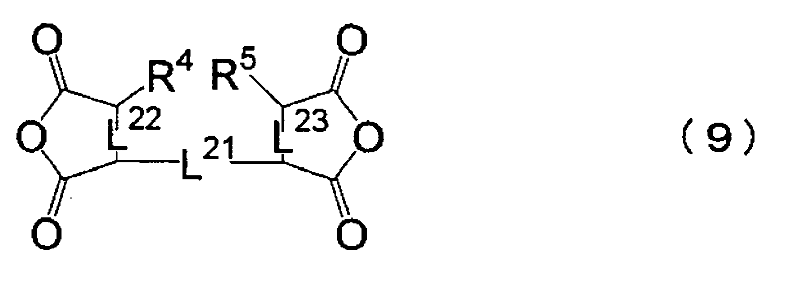

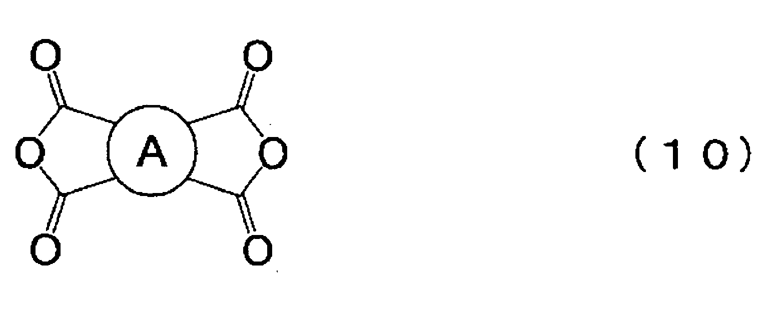

In Formulae (8) to (10), L²¹ represents a single bond, a divalent aliphatic or aromatic hydrocarbon group which may have a substituent (preferably an alkyl group, an aralkyl group, an aryl group, an alkoxy group, a halogeno group, an ester group or an amido group), -CO-, -SO-, -SO₂-, -O- or -S-. Preferably, L²¹ represents a single bond, a divalent aliphatic hydrocarbon group having 1 to 15 carbon atoms, -CO-, -SO₂-, -O- or -S-. R² and R³ may be the same as or different from each other and each represent a hydrogen atom, an alkyl group, an aralkyl group, an aryl group, an alkoxy group or a halogeno group. Preferably, R² and R³ each represent a hydrogen atom, an alkyl group having 1 to 8 carbon atoms, an aryl group having 6 to 15 carbon atoms, an alkoxy group having 1 to 8 carbon atoms, or a halogeno group. Two of L²¹ , R² and R³ may be bound to form a ring. R⁴ and R⁵ may be the same as or different from each other and each represent a hydrogen atom, an alkyl group, an aralkyl group, an aryl group, or a halogeno group. Preferably, R⁴ and R⁵ each represent a hydrogen atom, an alkyl group having 1 to 8 carbon atoms or an aryl group having 6 to 15 carbon atoms. Two of L²¹, R⁴ and R⁵ may be bound to form a ring. L²² and L²³ may be the same as or different from one another and each represent a single bond, a double bond or a divalent aliphatic hydrocarbon group. Preferably, L²² and L²³ each represent a single bond, a double bond or a methylene group. A represents a mononuclear or polynuclear aromatic ring. Preferably, A represents an aromatic ring having 6 to 18 carbon atoms.

Specific examples of the compounds represented by Formula (8), (9) or (10) include: aromatic tetracarboxylic dianhydrides such as pyromellitic dianhydride, 3,3',4,4'-benzophenonetetracarboxylic dianhydride, 3,3',4,4'-diphenyltetracarboxylic dianhydride, 2,3,6,7-naphthalenetetracarboxylic dianhydride, 1,4,5,8-naphthalenetetracarboxylic dianhydride, 4,4'-sulfonyldiphthalic dianhydride, 2,2-bis(3,4-dicarboxyphenyl)propane dianhydride, bis(3,4-dicarboxyphenyl)ether dianhydride, 4,4'-[3,3'-(alkylphosphoryldiphenylene)-bis(iminocarbonyl)]diphthalic dianhydride, a hydroquinone diacetate/trimellitic anhydride adduct or a diacetyl diamine/trimellitic anhydride adduct; alicyclic tetracarboxylic dianhydrides such as 5-(2,5-dioxotetrahydrofuryl)-3-methyl-3-cyclohexene-1,2-dicarboxylic anhydride (trade name: Epiclon B-4400, manufactured by Dainippon Ink And Chemicals, Inc.), 1,2,3,4-cyclopentanetetracarboxylic dianhydride, 1,2,4,5-cyclohexanetetracarboxylic dianhydride or tetrahydrofurantetracarboxylic dianhydride; and aliphatic tetracarboxylic dianhydrides such as 1,2,3,4-butanetetracarboxylic dianhydride or 1,2,4,5-pentanetetracarboxylic dianhydride.

By ring-opening the tetracarboxylic dianhydride with the diol compound, (ii) at least one diol compound having at least one carboxyl group may be synthesized. However, the polyurethane resin in the invention may be synthesized by first allowing a reaction between the diol compound and the diisocyanate compound (i), and then by allowing the reaction product to react with the tetracarboxylic dianhydride, and this method is also included in the invention. That is, examples of the method of introducing a structural unit derived from the tetracarboxylic dianhydride and the diol compound into a polyurethane resin include the following methods:

a) a method of reacting the diisocyanate compound with a compound having an alcohol group at its terminus, which is obtained by ring-opening the tetracarboxylic dianhydride with the diol compound; and
b) a method of reacting the tetracarboxylic dianhydride with an alcohol-terminated urethane compound obtained by reacting the diisocyanate compound with an excess amount of the diol compound.

As at least one diol compound having at least one carboxyl group, the compound represented by Formula (5) is more preferable because of its high solvent solubility and easy synthesis. At least one kind of diol compound having at least one carboxyl group is introduced into the polyurethane resin binder in such an amount that the polyurethane resin binder has carboxyl groups in the range of from 0.2 to 4.0 meq/g, preferably in the range of from 0.3 to 3.0 meq/g, more preferably in the range of from 0.4 to 2.0 meq/g, in the range of from still more preferably 0.5 to 1.5 meq/g, and most preferably in the range of from 0.6 to 1.2 meq/g. Accordingly, the amount of the structure derived from the at least one diol compound having at least one carboxyl group may be selected appropriately depending on the number of carboxyl groups, the type of another diol component, the acid value or molecular weight of the resulting polyurethane resin binder, the composition or pH of a developer, and the like, and the amount is, for example, 5 to 45 mol%, preferably 10 to 40 mol%, more preferably 15 to 35 mol% in the polyurethane resin binder.

### (iii) Diisocyanate compound having a crosslinking group

An example of the diisocyanate compound having a crosslinking group is a product obtained by addition reaction of a triisocyanate compound with 1 equivalent of a monofunctional alcohol having a crosslinking group or a monofunctional amine compound having a crosslinking group.
Examples of the triisocyanate compound include, but are not limited to, the following compounds.

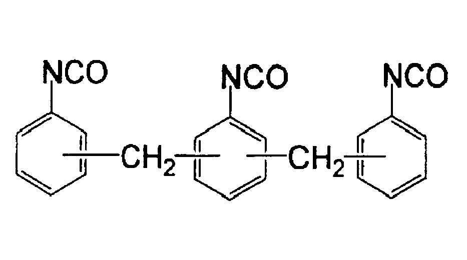

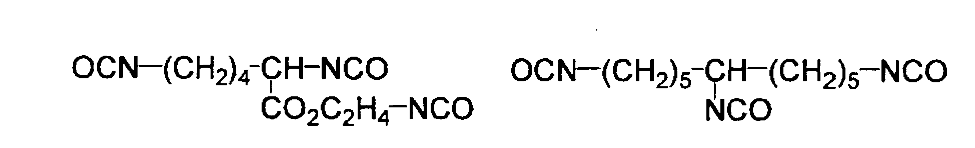

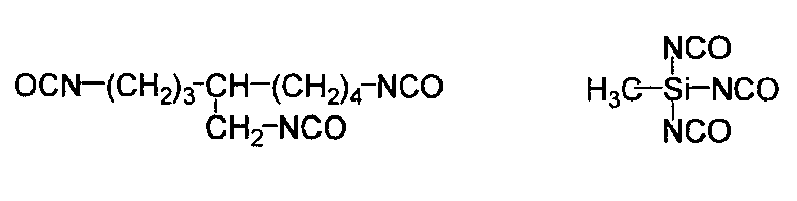

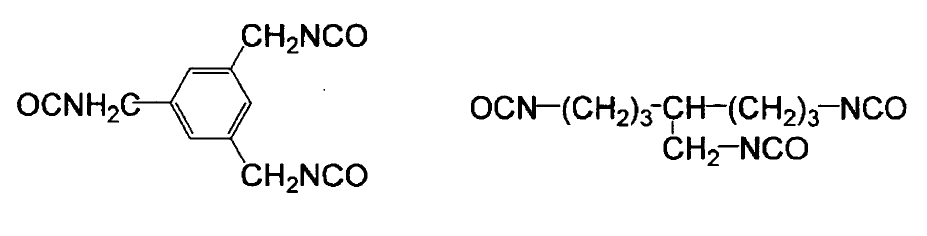

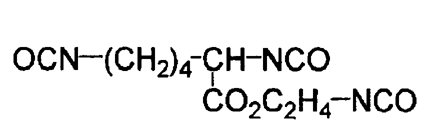

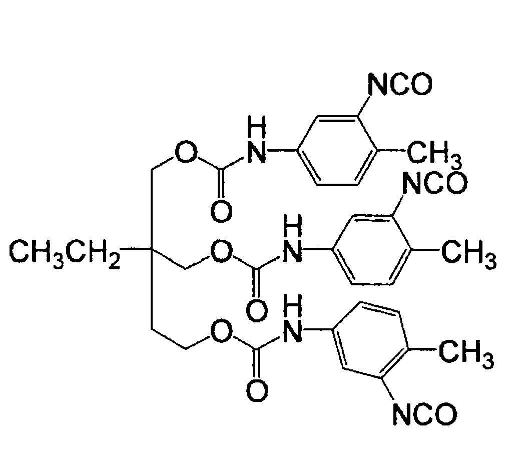

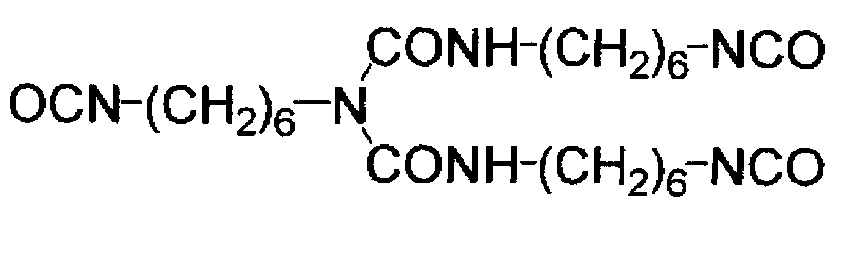

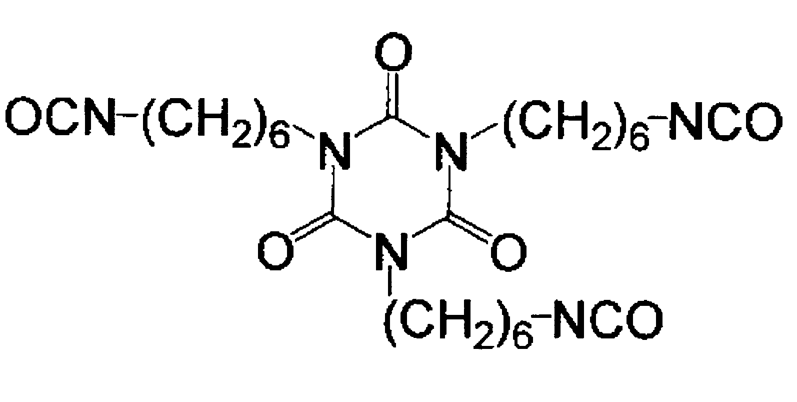

Examples of the monofunctional alcohol having a crosslinking group or the monofunctional amine compound having a crosslinking group include, but are not limited to, the following compounds.

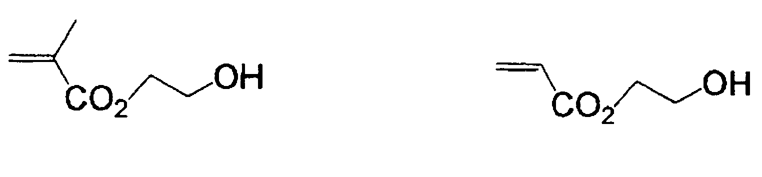

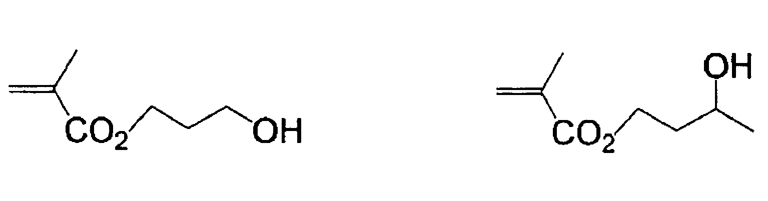

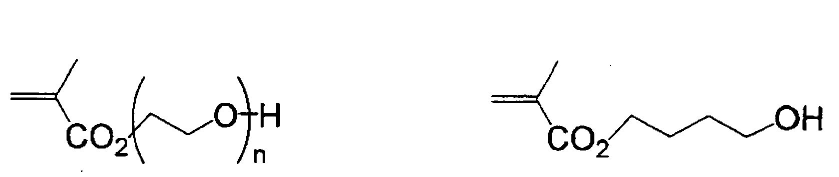

n is an integer of 2 to 10

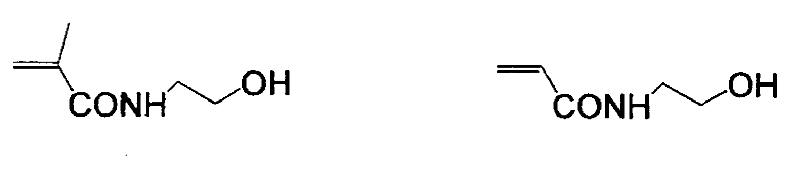

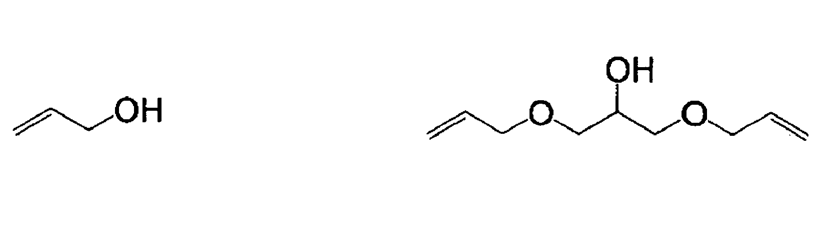

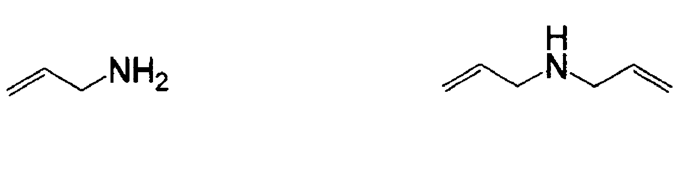

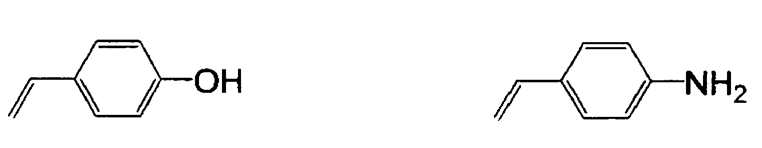

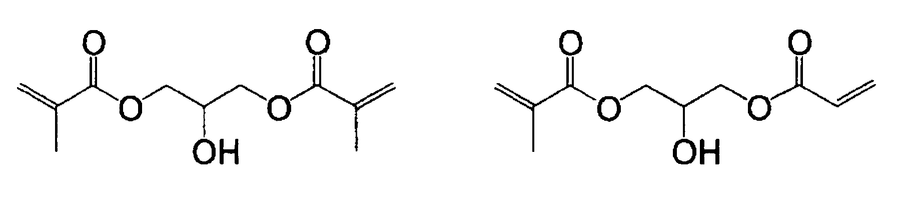

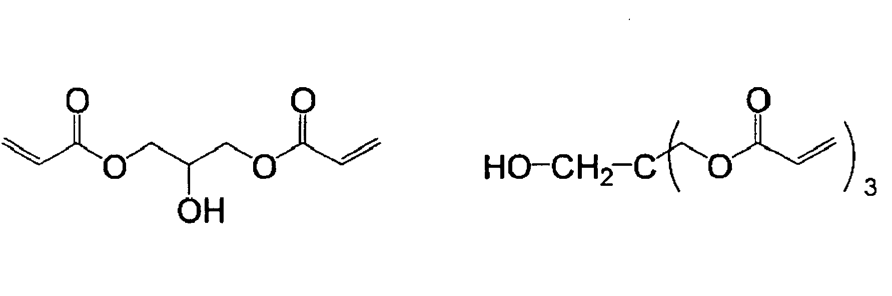

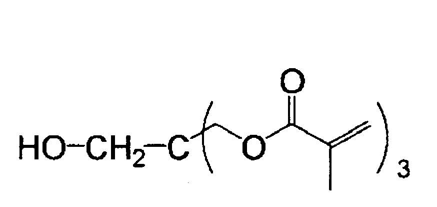

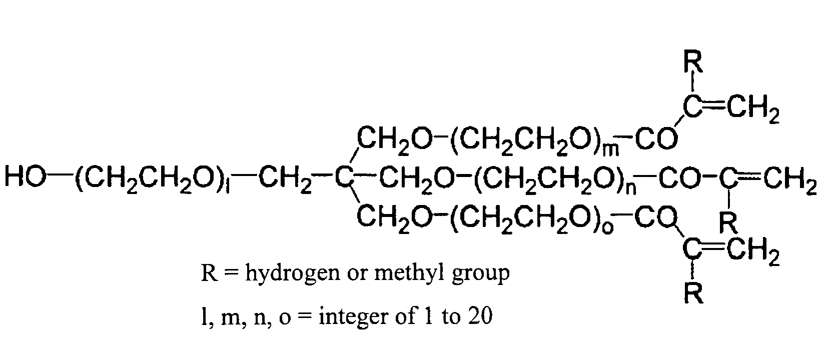

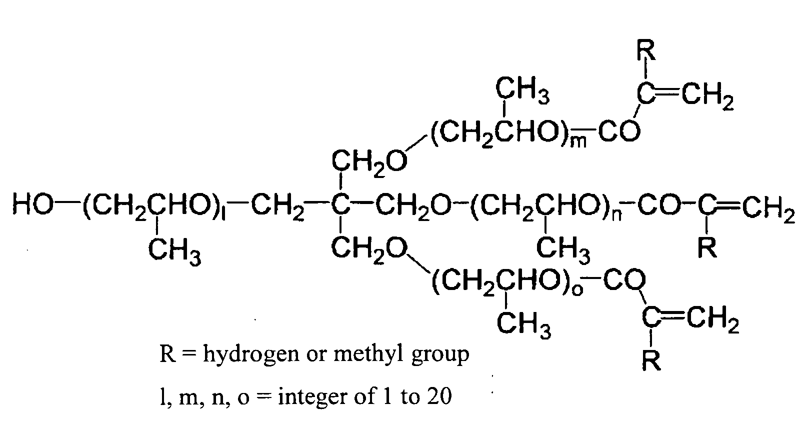

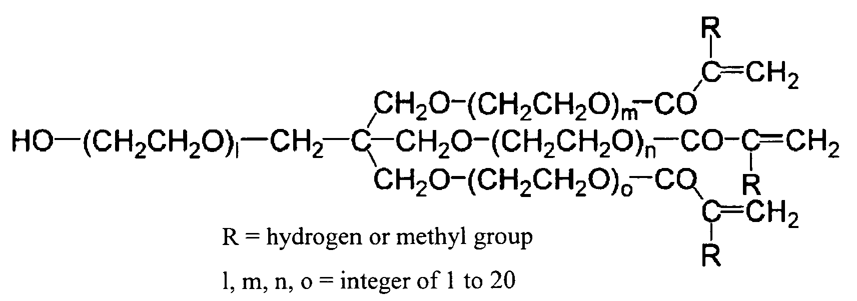

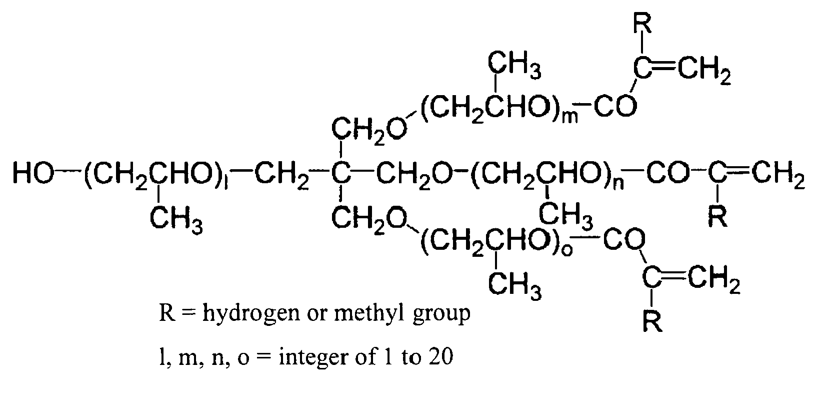

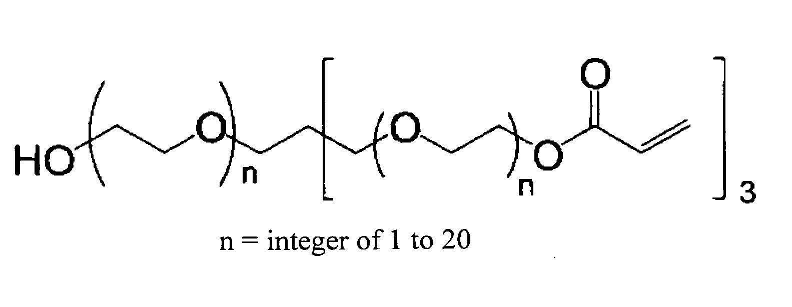

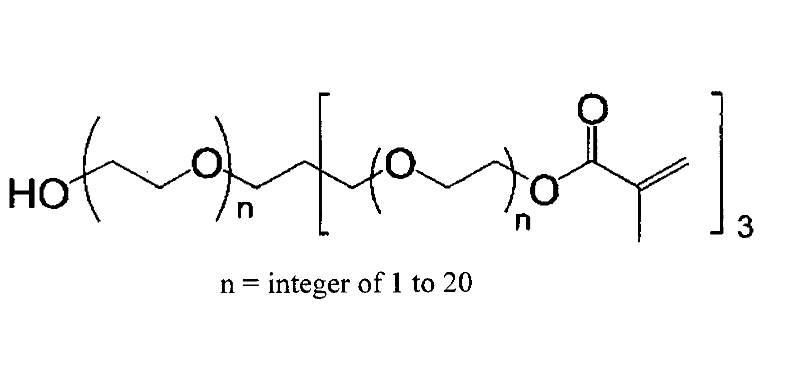

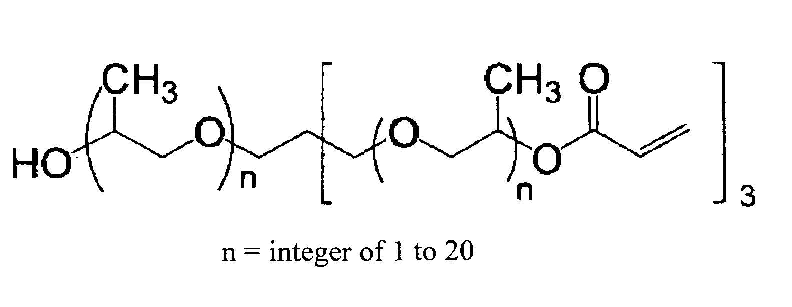

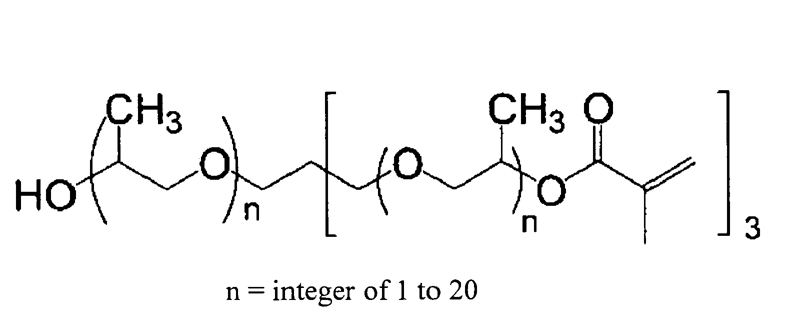

In the method of introducing a crosslinking group to a side chain of a polyurethane resin, a diisocyanate compound having a crosslinking group in a side chain thereof is preferably used as a starting material in the production of the polyurethane resin. Examples of the diisocyanate compound which has a crosslinking group in a side chain thereof and may be obtained by addition reaction of a triisocyanate compound with 1 equivalent of a monofunctional alcohol having a crosslinking group or a monofunctional amine compound having a crosslinking group, include, but are not limited to, the following compounds.

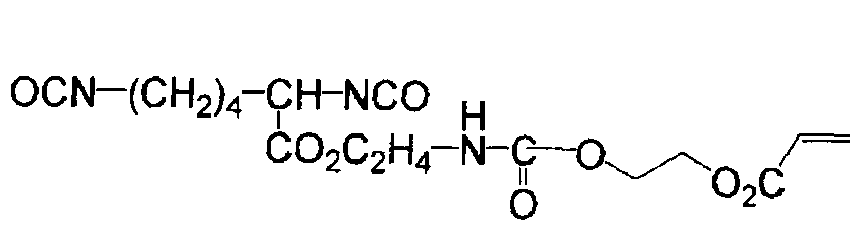

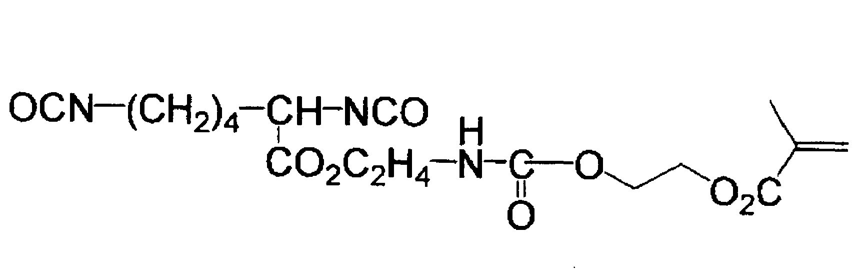

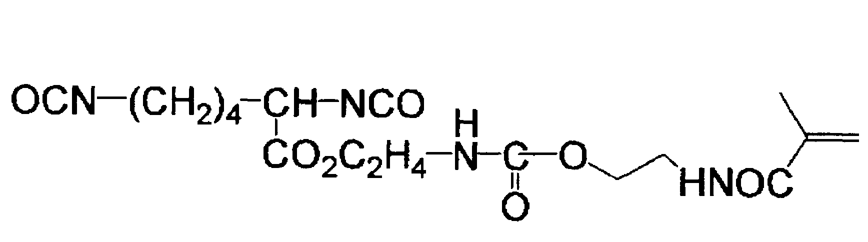

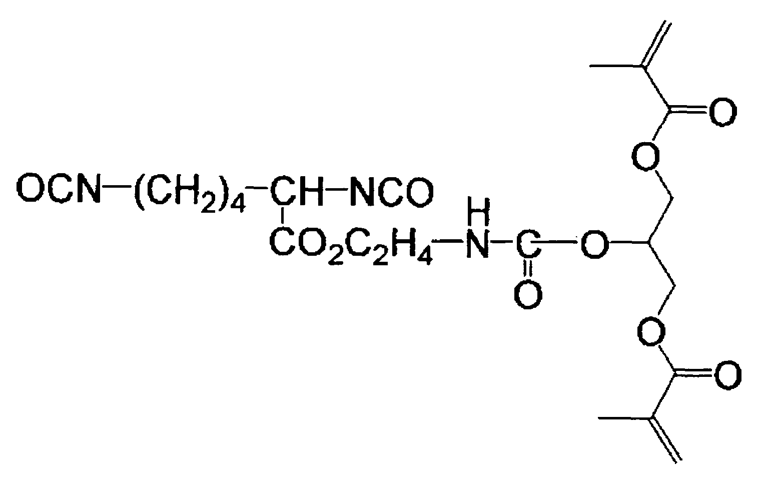

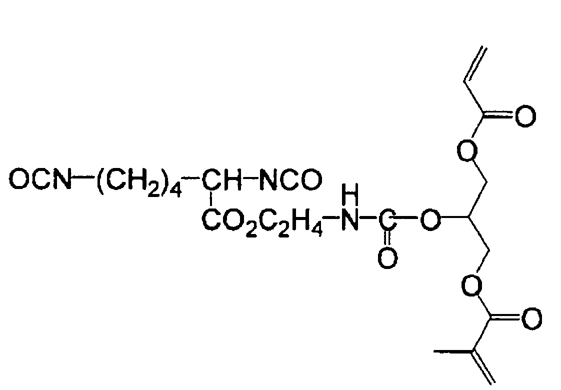

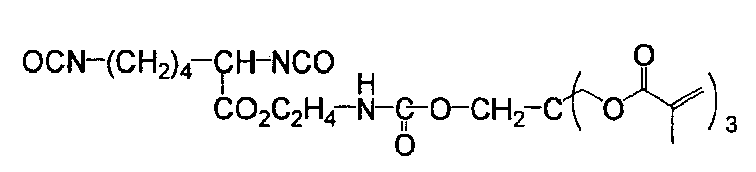

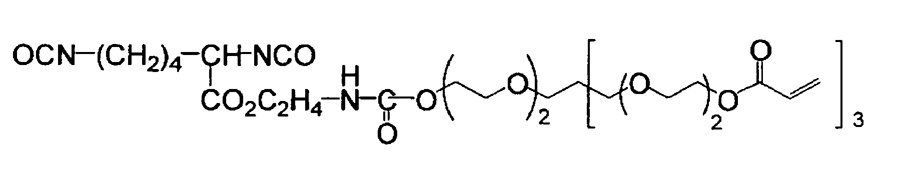

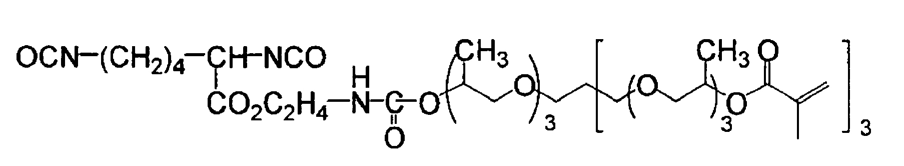

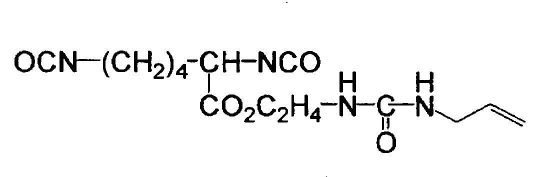

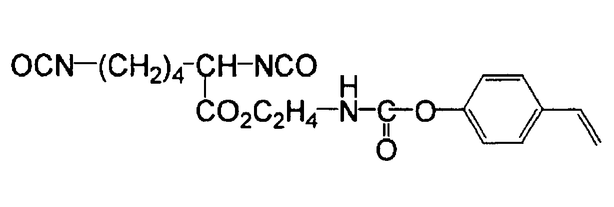

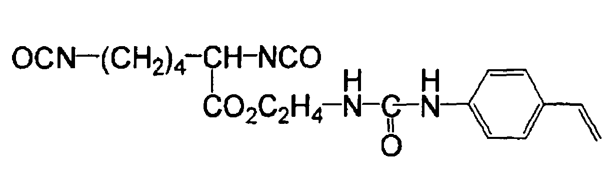

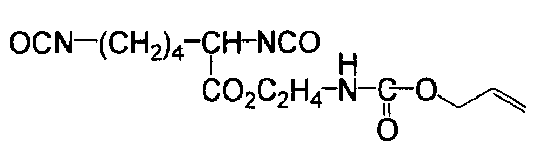

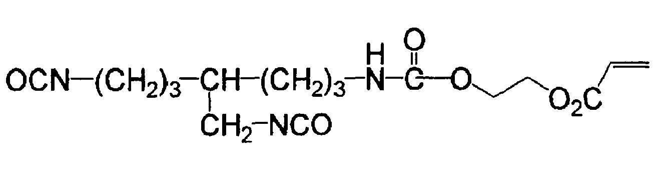

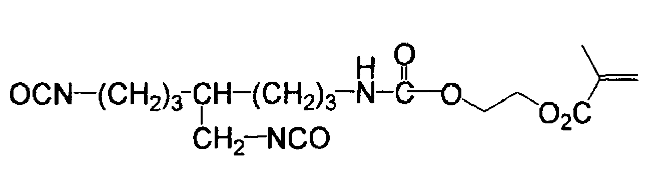

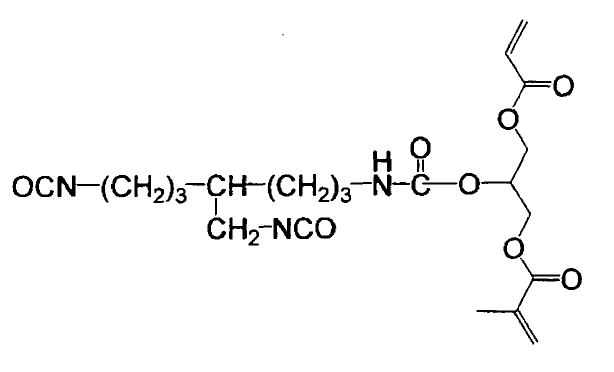

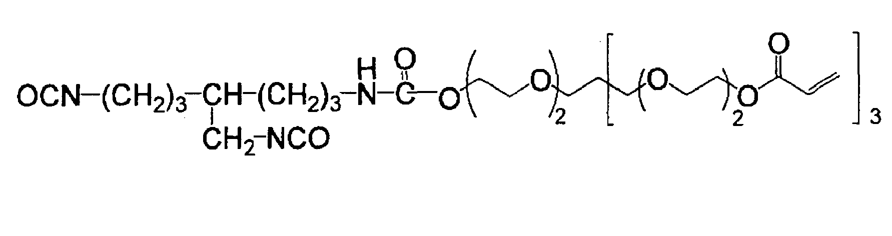

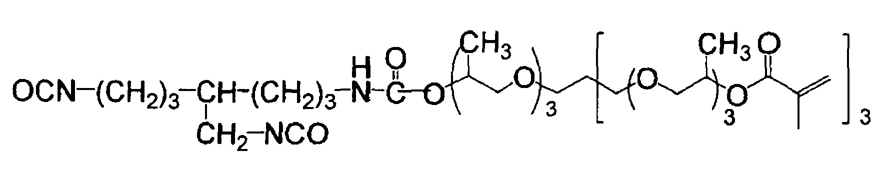

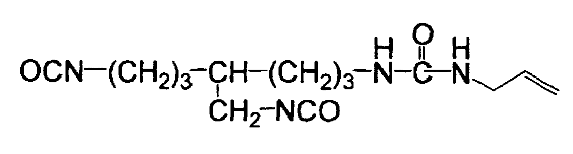

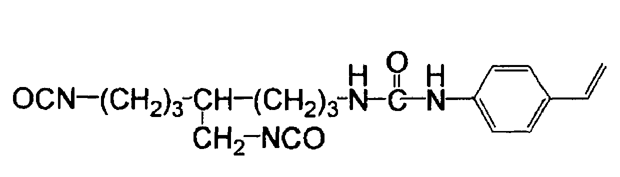

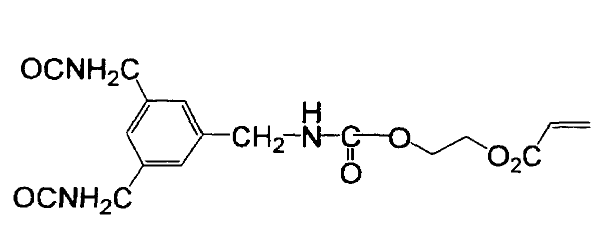

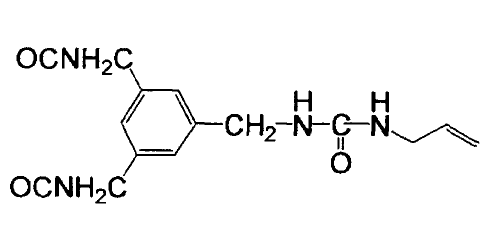

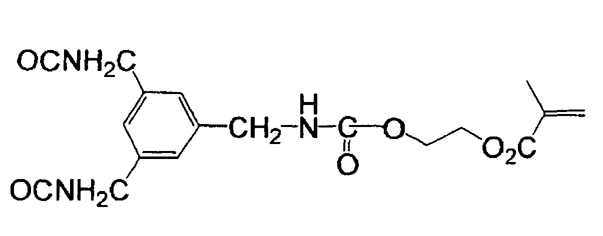

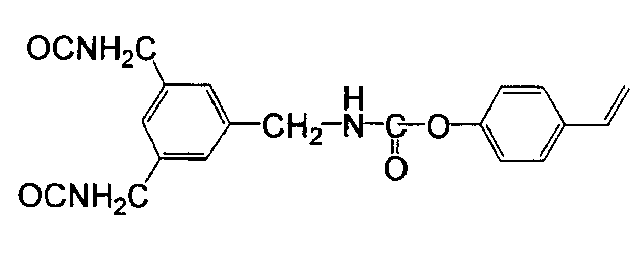

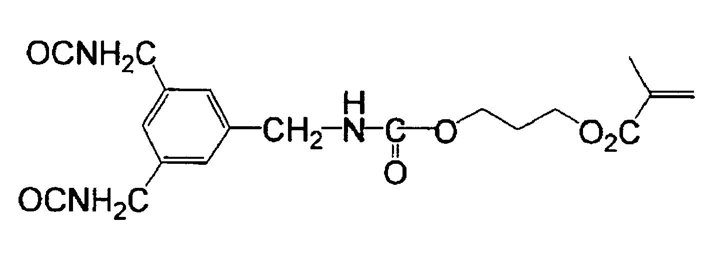

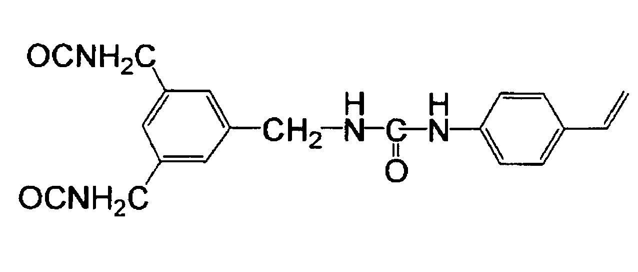

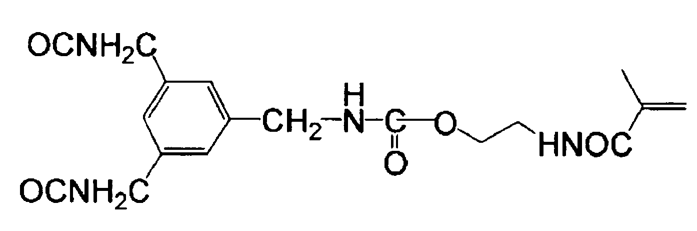

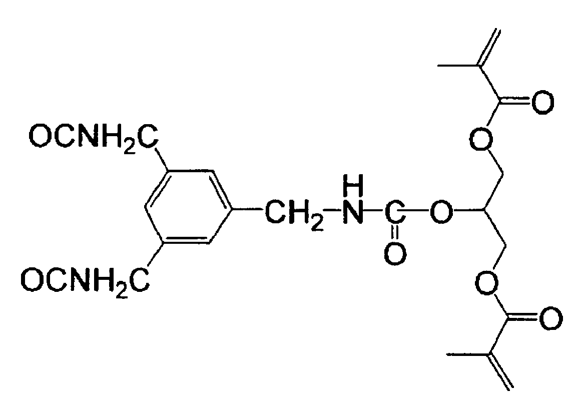

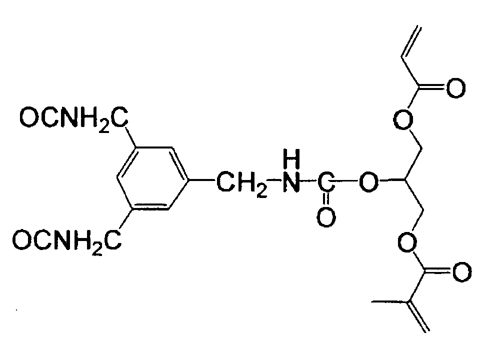

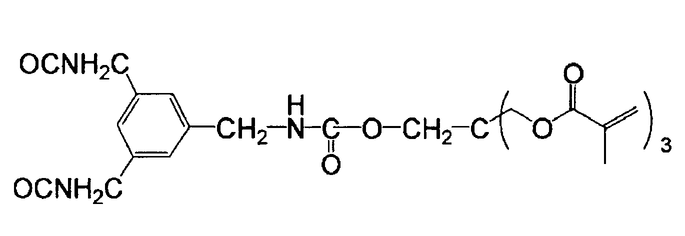

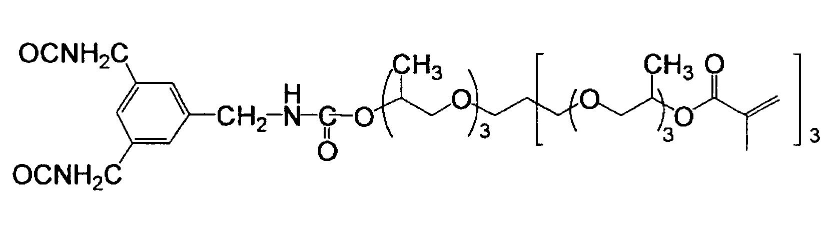

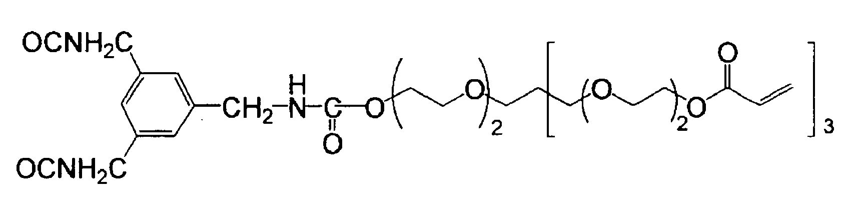

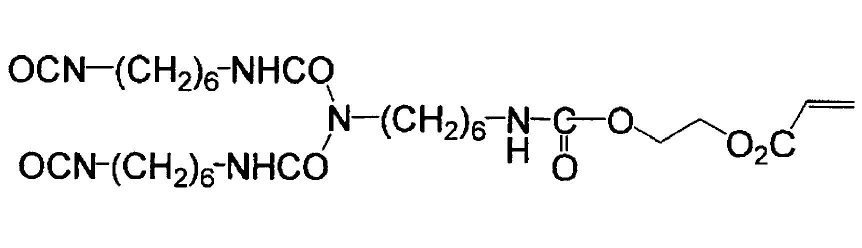

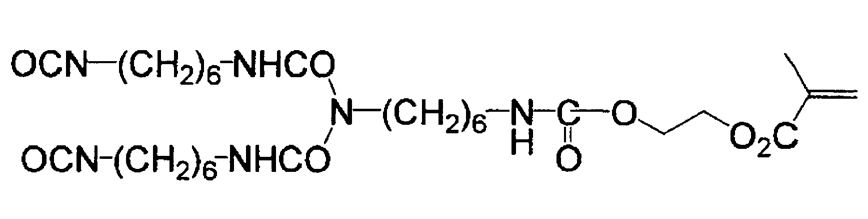

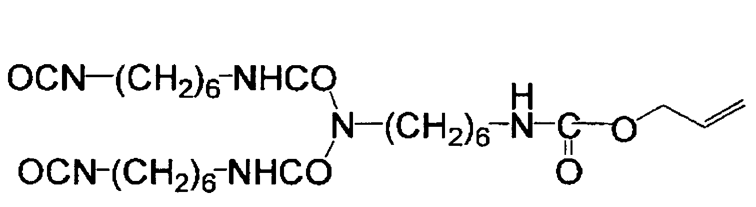

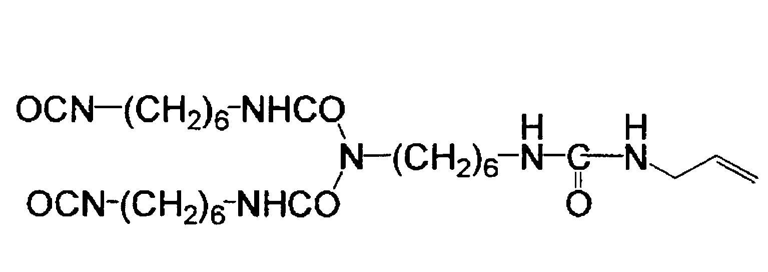

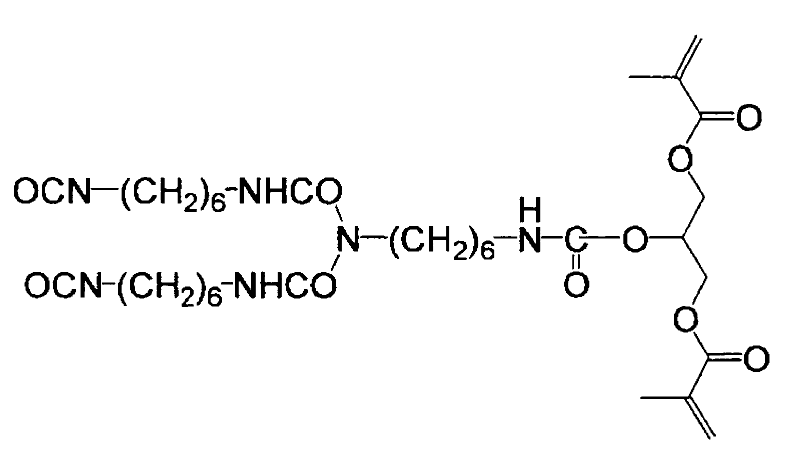

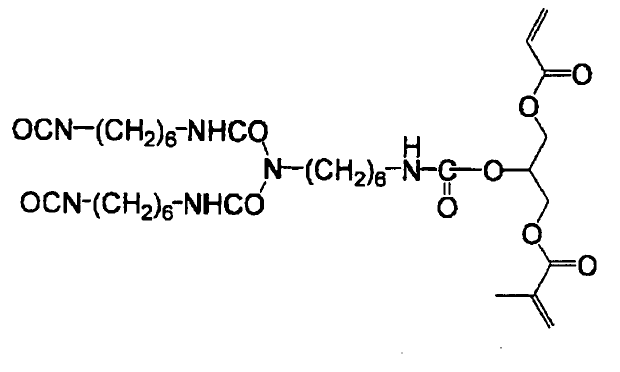

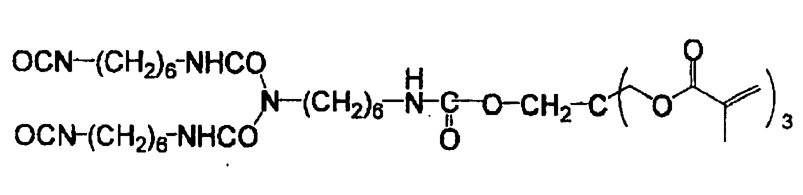

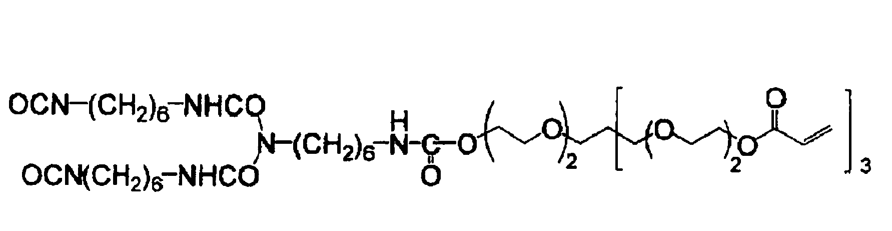

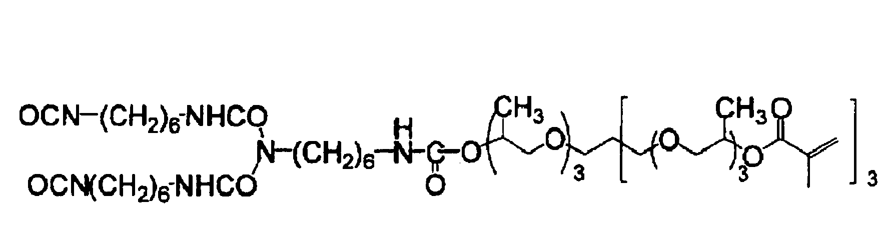

### (iv) Other diol compounds

Besides the method described above, a method of using a diol compound having an unsaturated group in a side chain thereof as a starting material in production of the polyurethane resin is also preferable as the method of introducing an unsaturated group into a side chain of a polyurethane resin. Such diol compounds may be those commercially available as trimethylol propane monoallyl ether or may be compounds produced easily by reacting a halogenated diol compound, a triol compound or an aminodiol compound with an unsaturated group-containing carboxylic acid, acid chloride, isocyanate, alcohol, amine, thiol, or halogenated alkyl compound. Specific examples of these compounds include, but are not limited to, the following compounds.

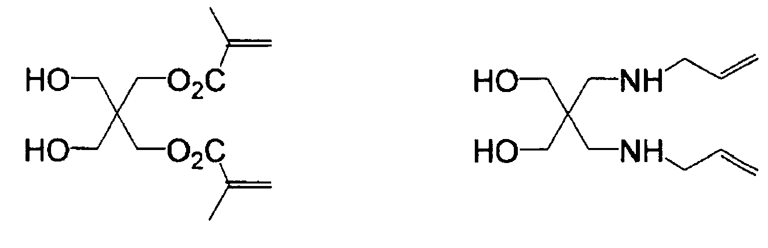

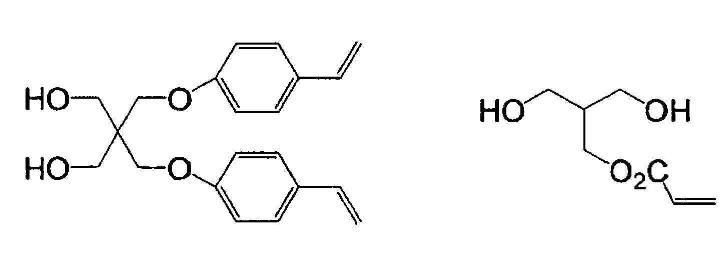

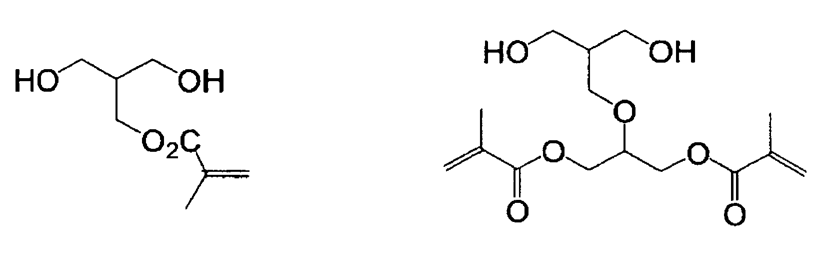

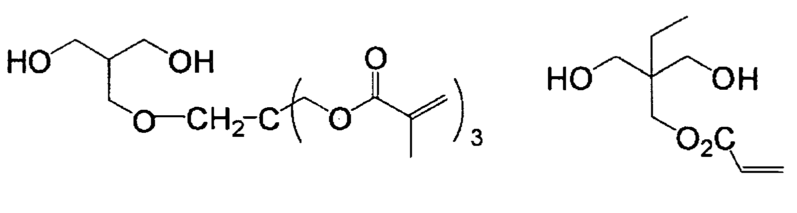

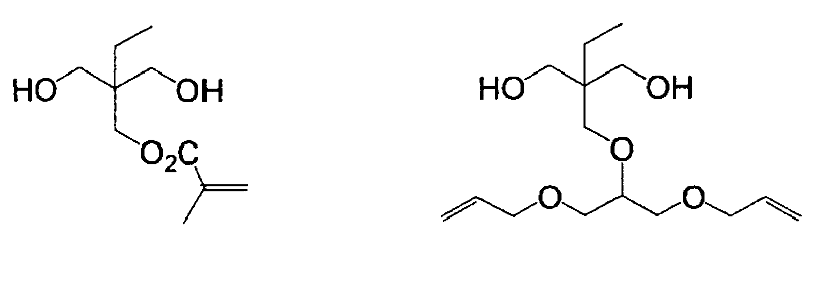

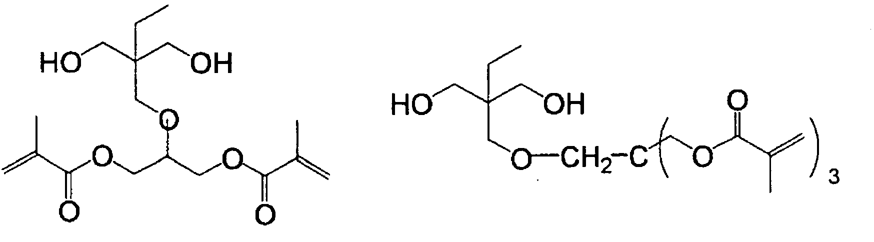

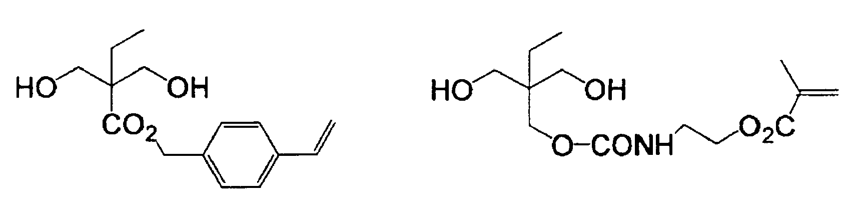

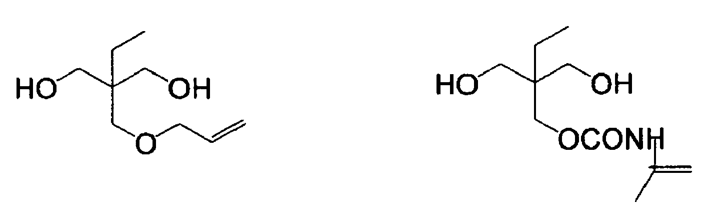

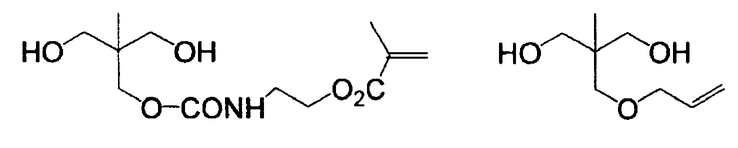

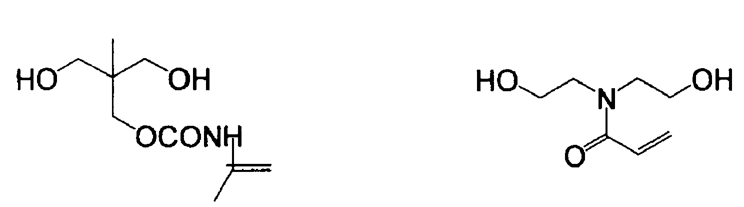

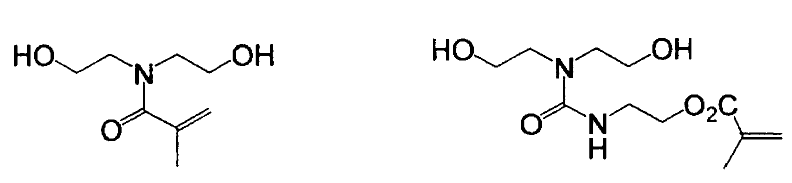

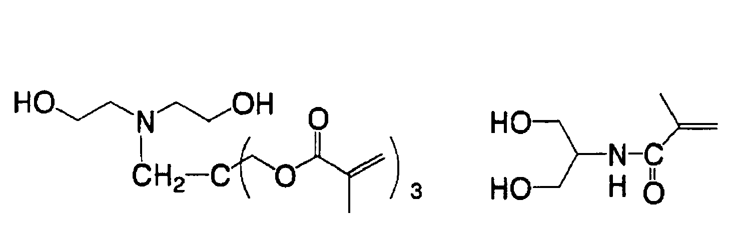

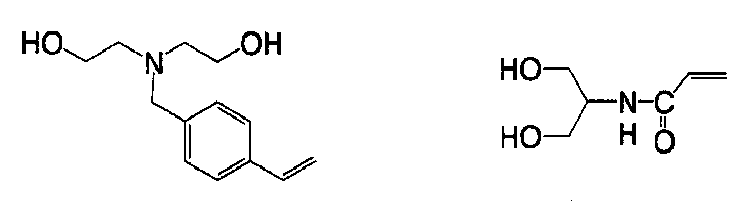

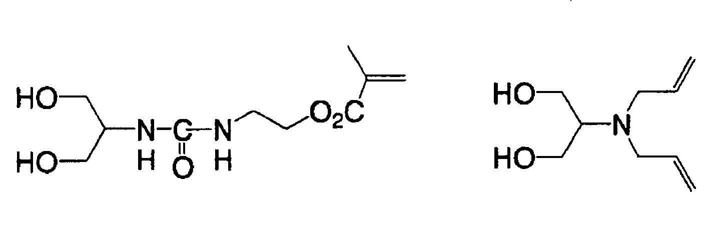

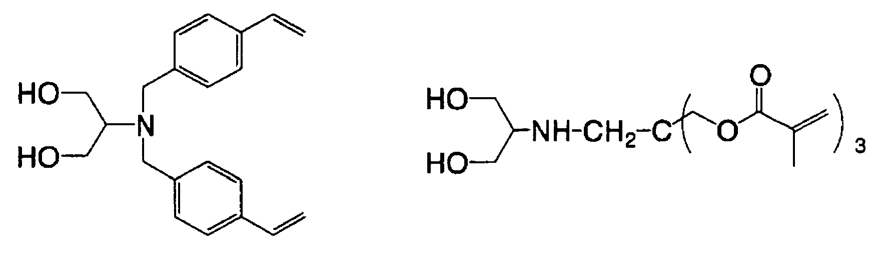

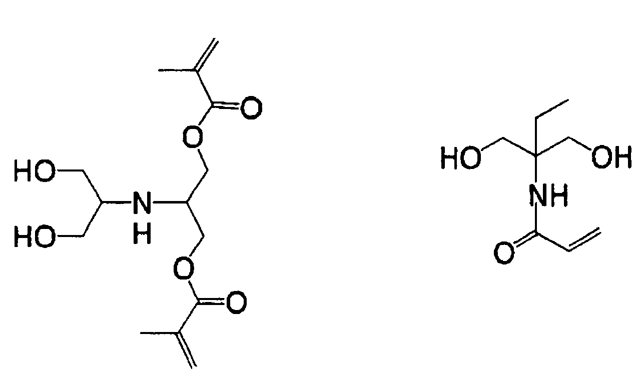

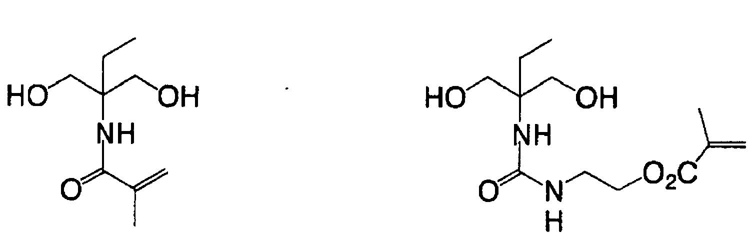

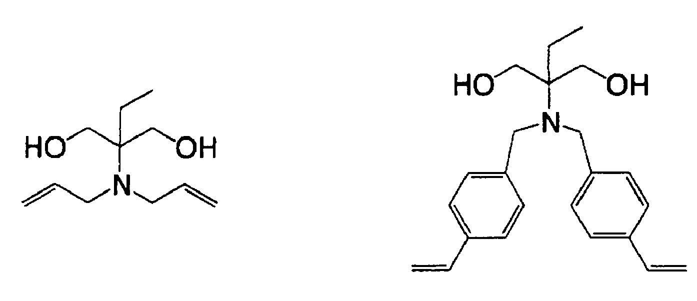

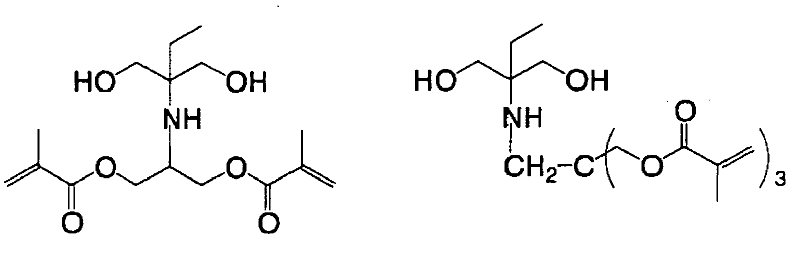

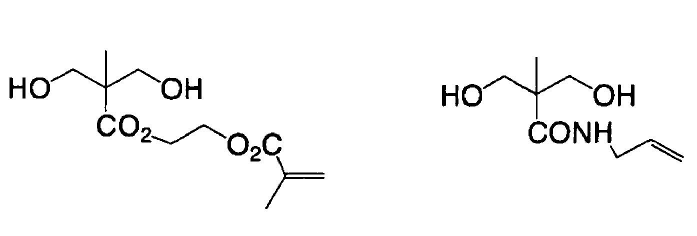

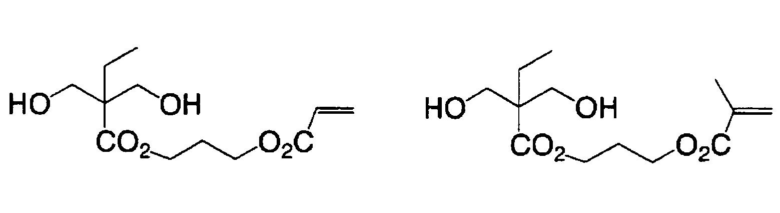

Examples of still other diol compounds include ethylene glycol compounds represented by the following Formula (A'):

HO-(CH₂CH₂O)ₙ-H (A')

wherein n represents an integer of 1 or more.

Other examples include ethylene oxide/propylene oxide random copolymers and block copolymers each having a hydroxyl group at a terminus thereof.

Still other examples of the diol compounds that may be used include an ethylene oxide adduct of bisphenol A (number of ethylene oxide units added: 27 to 100), an ethylene oxide adduct of bisphenol F (number of ethylene oxide units added: 22 to 100), an ethylene oxide adduct of hydrogenated bisphenol A (number of ethylene oxide units added: 23 to 100) and an ethylene oxide adduct of hydrogenated bisphenol F (number of ethylene oxide units added: 18 to 100).
Specifically, the diol compound is preferably the ethylene glycol compound represented by Formula (e-1) from the viewpoint of staining resistance, more preferably the ethylene glycol compound wherein n is 2 to 50, still more preferably the ethylene glycol compound wherein n is 3 to 30, further more preferably the ethylene glycol compound
wherein n is 4 to 10.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1000, polypropylene glycol having an average molecular weight of 2000, polypropylene glycol having an average molecular weight of 3000, polypropylene glycol having an average molecular weight of 4000, neopentyl glycol, 2-butane-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octane diol, cyclohexane dimethanol, tricyclodecane dimethanol, hydrogenated bisphenol A, hydrogenated bisphenol F, an ethylene oxide adduct of bisphenol A (number of ethylene oxide units added: 26 or less), an ethylene oxide adduct of bisphenol F (number of ethylene oxide units added: 21 or less), an ethylene oxide adduct of hydrogenated bisphenol A (number of ethylene oxide units added: 22 or less), an ethylene oxide adduct of hydrogenated bisphenol F (number of ethylene oxide units added: 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethyl sulfone, bis(2-hydroxyethyl)-2,4-tolylene dicarbamate, 2,4-tolylene-bis(2-hydroxyethylcarbamide), bis(2-hydroxyethyl)-m-xylylene dicarbamate, and bis(2-hydroxyethyl)isophthalate. In the specification, the molecular weight of the polypropylene glycol compound refers to weight-average molecular weight (Mw) unless otherwise noted.

Polyether diol compounds represented by Formula (A), (B), (C), (D) and (E) may also be preferably used.

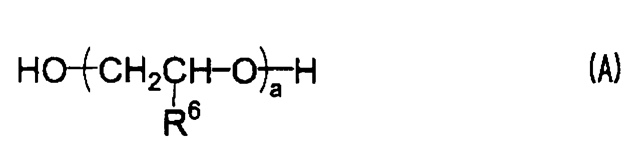

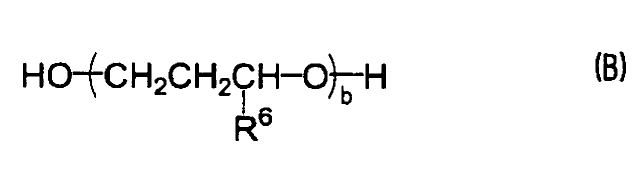

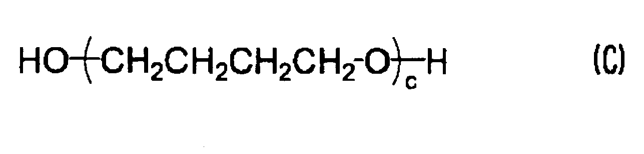

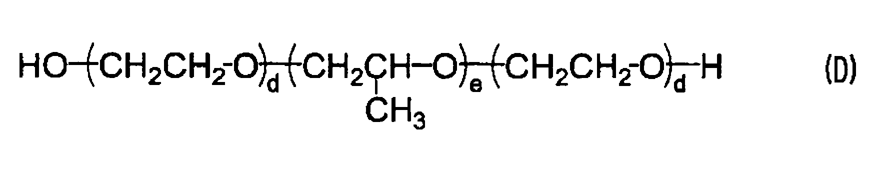

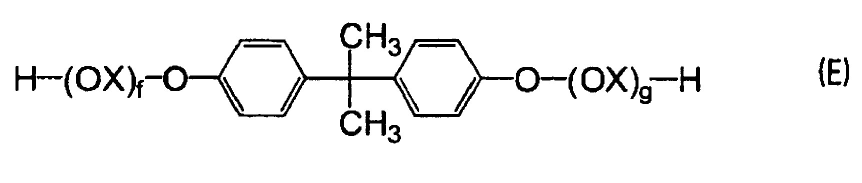

In Formulae (A) to (E), R⁶ represents a hydrogen atom or a methyl group. However, R⁶ in Formula (A) represents a methyl group. X represents the following group.

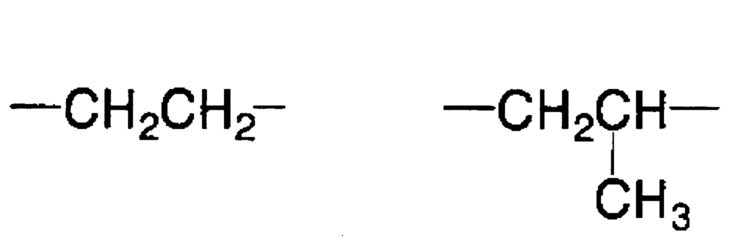

In Formulae (A) to (E), a, b, c, d, e, f, and g each represent an integer of 2 or more, preferably an integer of 2 to 100.

Further, specific examples of the diol compound include the polyester diol compounds represented by the following Formulae (11) and (12).

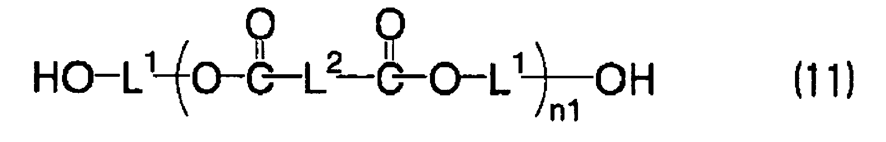

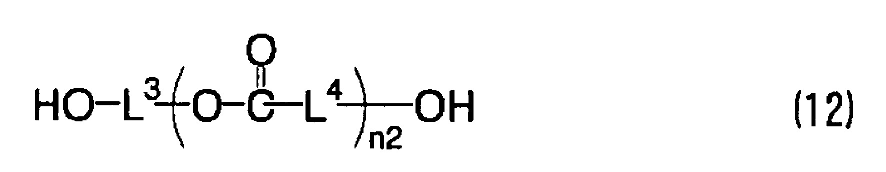

In the formulae, L', L² and L³ may be the same as or different from one another and each represent a divalent aliphatic or aromatic hydrocarbon group, and L⁴ represents a divalent aliphatic hydrocarbon group. Preferably, L', L² and L³ each represent an alkylene group, an alkenylene group, an alkynylene group or an allylene group, and L⁴ represents an alkylene group. In addition, L', L² and L³ and L⁴ may have another functional group that does not react with an isocyanate group, such as an ether group, a carbonyl group, an ester group, a cyano group, an olefin group, a urethane group, an amido group or a ureido group, or a halogen atom. In the formulae, n1 and n2 each represent an integer of 2 or more, preferably an integer of 2 to 100.

Still other specific examples include the polycarbonate diol compounds represented by the following Formula (13).

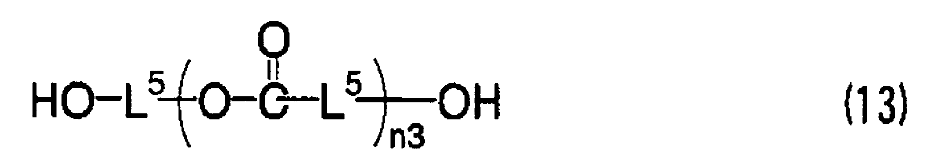

In the formula, L⁵s may be the same as or different from one another and each represent a divalent aliphatic or aromatic hydrocarbon group. Preferably, L⁵ represents an alkylene group, an alkenylene group, an alkynylene group or an allylene group. L⁵ may have another functional group that does not react with an isocyanate group, such as an ether group, a carbonyl group, an ester group, a cyano group, an olefin group, a urethane group, an amido group or a ureido group, or a halogen atom may be present. n3 represents an integer of 2 or more, preferably an integer of 2 to 100.

Specific examples of the diol compounds represented by Formula (11), (12) or (13) include those shown below. In the following examples, n represents an integer of 2 or more.

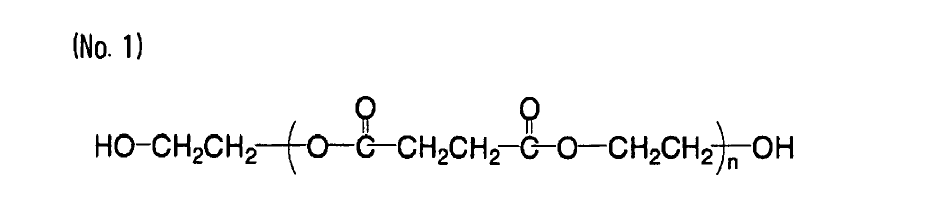

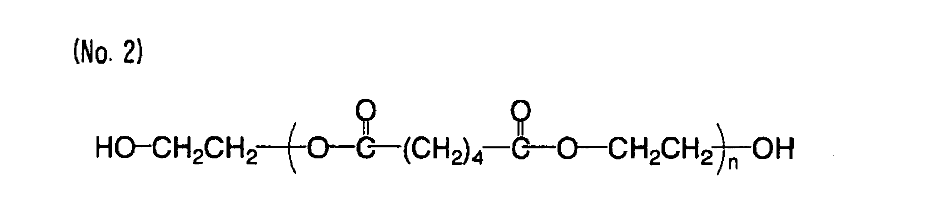

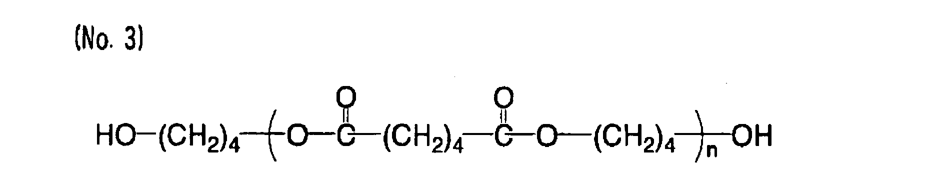

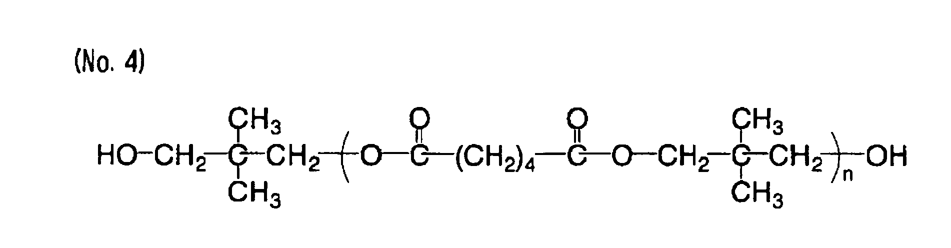

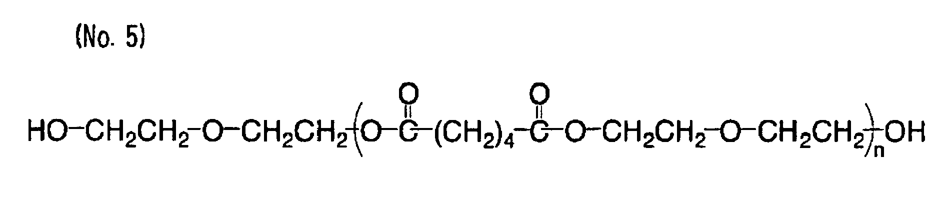

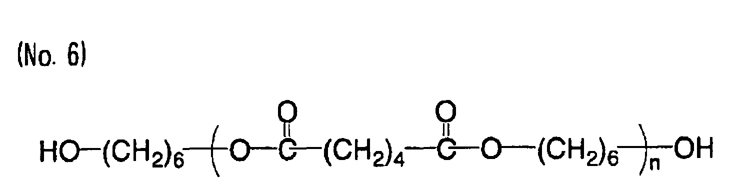

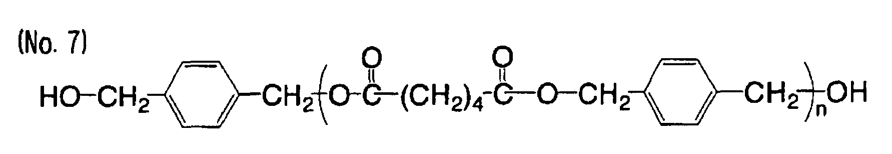

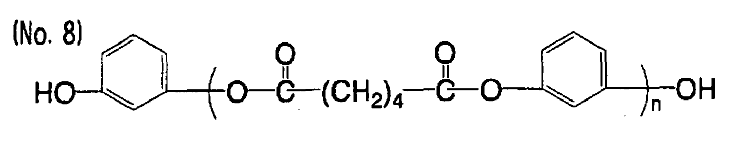

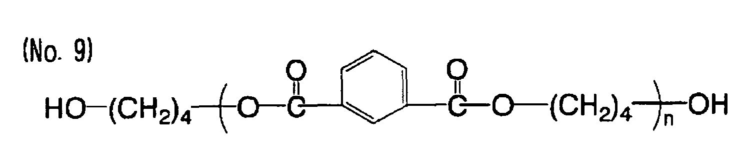

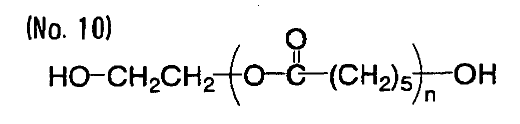

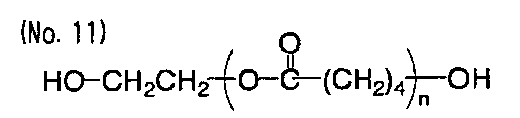

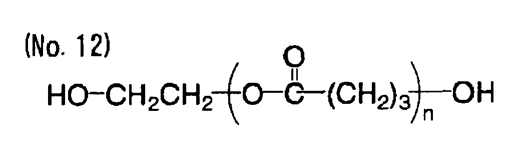

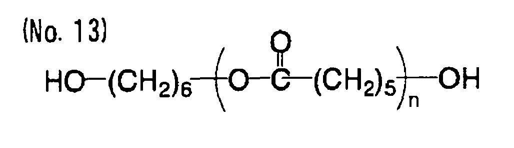

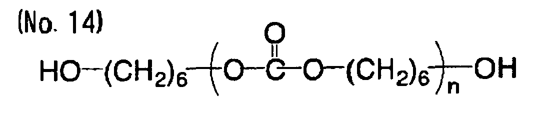

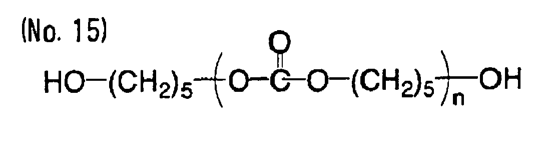

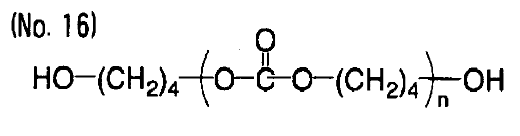

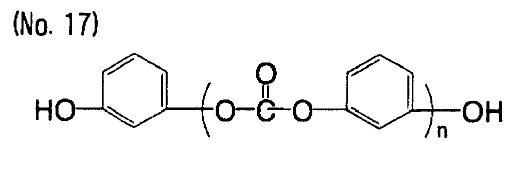

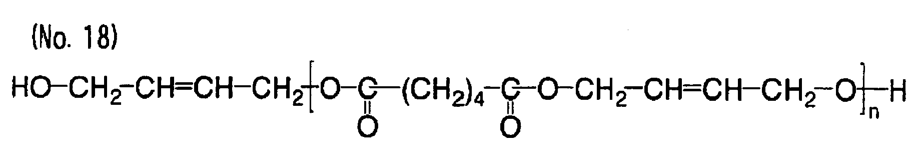

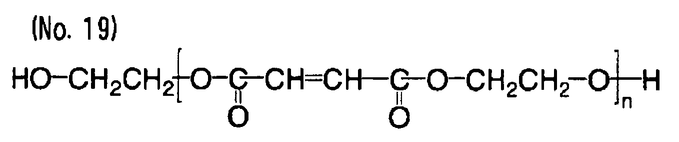

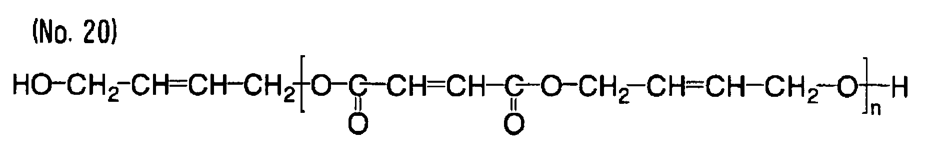

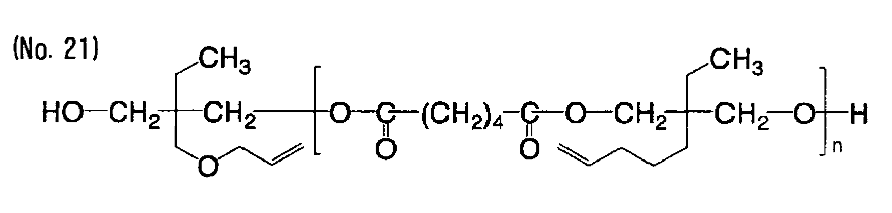

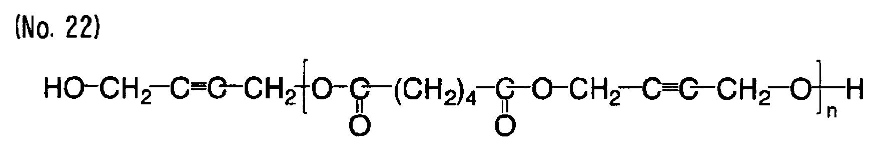

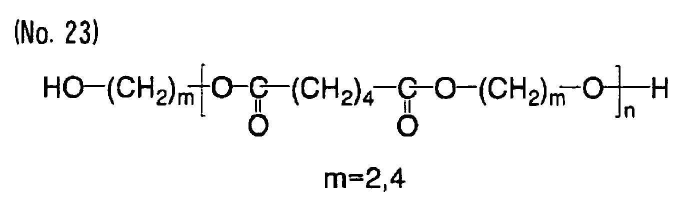

Diol compounds that do not have a carboxyl group and may have another substituent that does not react with an isocyanate may also be used.

Examples of such diol compounds include those represented by the following Formulae (14) and (15).

HO-L⁶-O-CO-L⁷-CO-O-L⁶-OH (14)

HO-L⁷-CO-O-L⁶-OH (15)

In Formulae (14) and (15), L⁶ and L⁷ may be the same as or different from each other and each represent a divalent aliphatic hydrocarbon group, a divalent aromatic hydrocarbon group or a divalent heterocyclic group, which may have a substituent (such as an alkyl group, an aralkyl group, an aryl group, an alkoxy group, an aryloxy group and a halogen atom (-F, -Cl, -Br, -I)). If necessary, L⁶ and L⁷ each may have another functional group that does not react with an isocyanate group, such as a carbonyl group, an ester group, a urethane group, an amido group or a ureido group. L⁶ and L⁷ may be bound to form a ring.

Specific examples of the compounds represented by Formula (14) or (15) include those shown below.

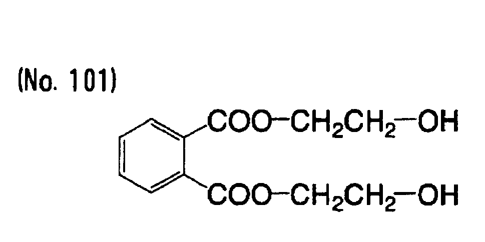

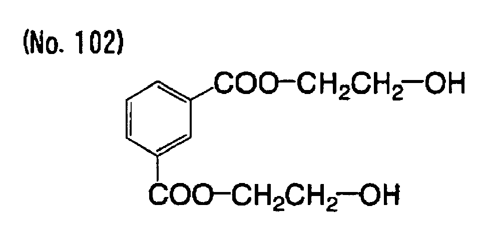

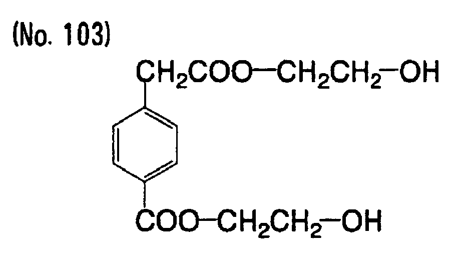

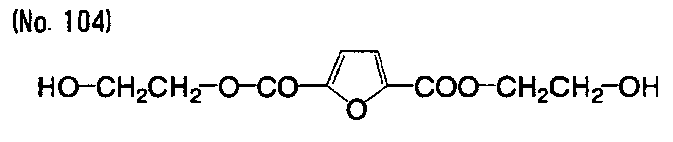

(No. 105) HO-CH₂CH₂-O-CO-CH=CH-COO-CH₂CH₂-OH

(No. 106) HO-CH₂CH₂-O-COC₁₁H₂₂COO-CH₂CH₂-OH

(No. 107) HO-CH₂CH₂-O-COC₁₂H₂₄COO-CH₂CH₂-OH

(No. 108) HO-CH₂CH₂-O-COC₁₄H₂₈COO-CH₂CH₂-OH

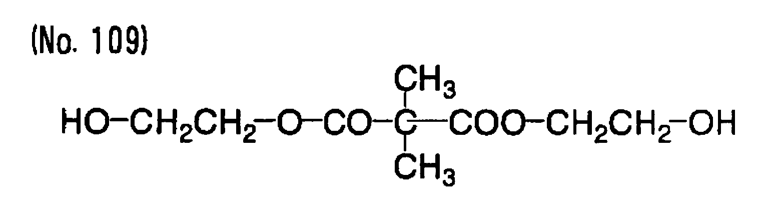

(No. 110) HO-CH₂CH₂-O-CO-C≡CCO-CH₂CH₂-OH

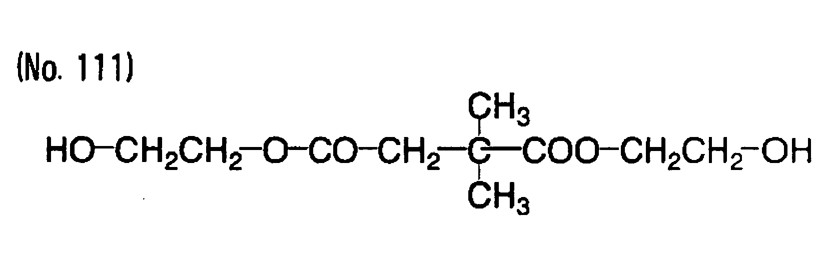

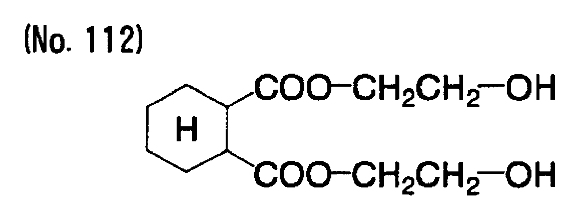

(No. 113) HO-CH₂CH₂-O-CO-CH₂-O-CH₂-COO-CH₂CH₂-OH

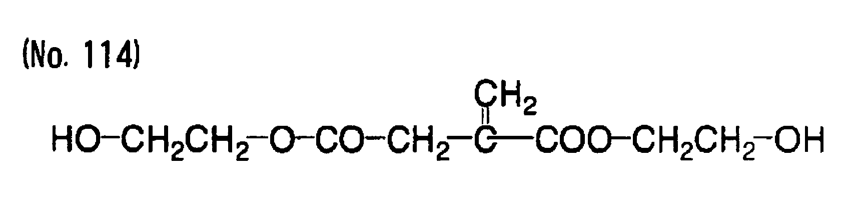

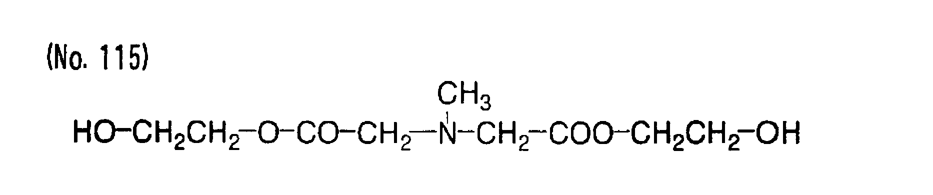

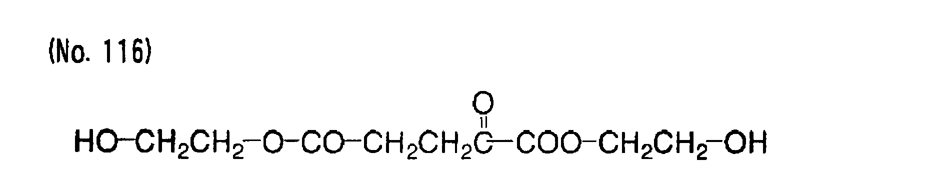

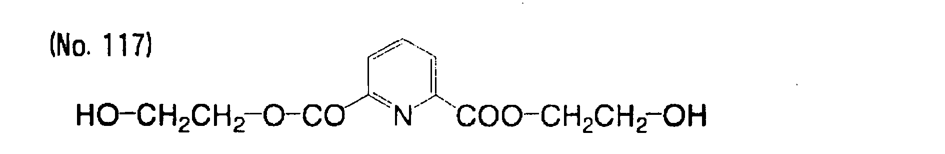

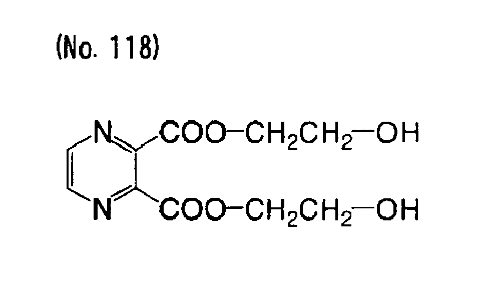

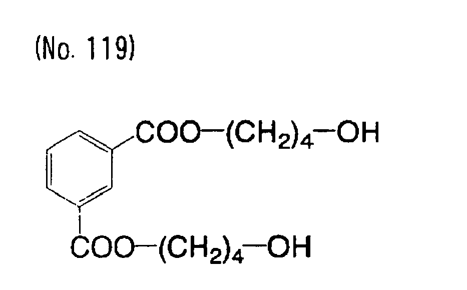

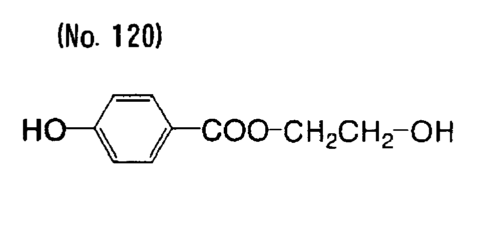

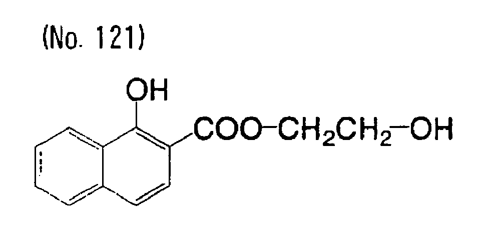

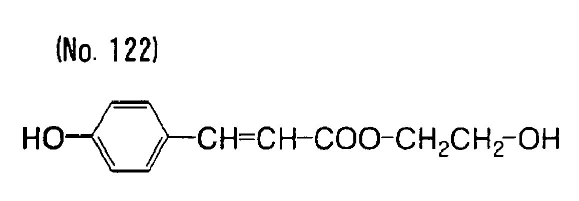

(No. 123) HO-CH₂CH₂-COO-CH₂CH₂-OH

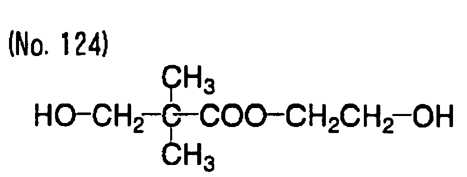

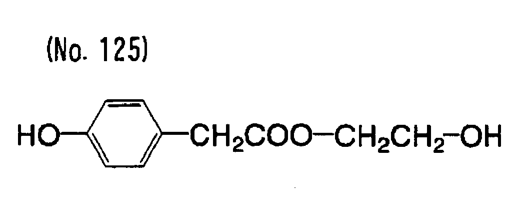

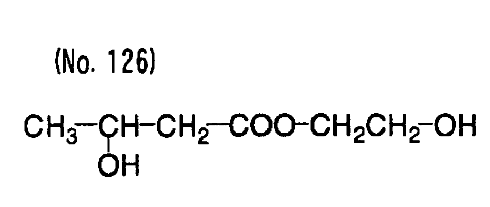

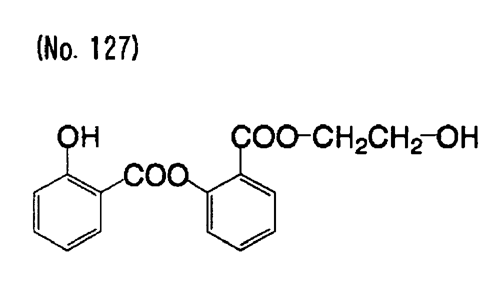

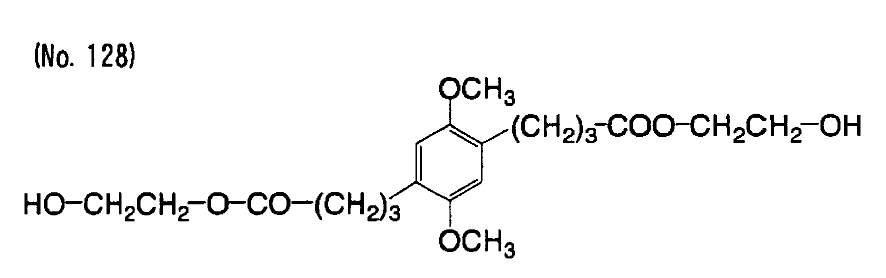

The diol compounds represented by the following Formulae (16) to (18) may also be preferably used.

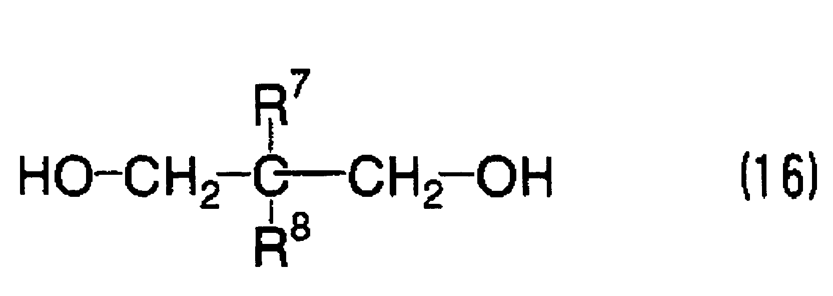

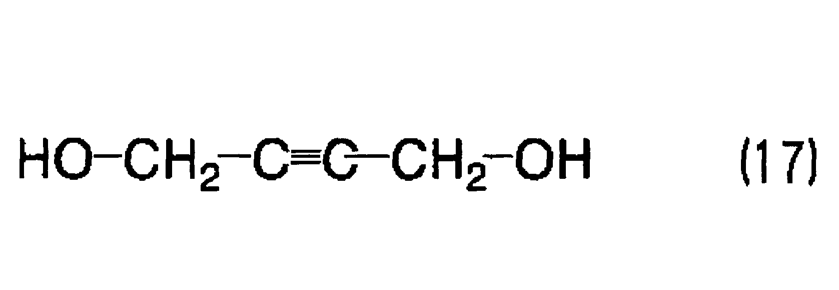

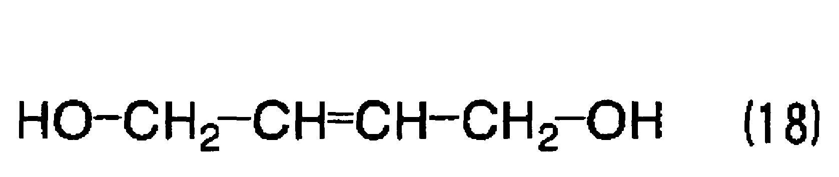

In Formula (16), R⁷ and R⁸ may be the same as or different from each other and each represent an alkyl group which may have a substituent, preferably an alkyl group which has 1 to 10 carbon atoms and may have a substituent such as a cyano group, a nitro group, a halogen atom (-F, -Cl, -Br, -I), -CONH₂, -COOR or -OR wherein R's may be the same as or different from one another and each represent an alkyl group having 1 to 10 carbon atoms, an aryl group having 7 to 15 carbon atoms, or an aralkyl group.
Specific examples of the diol compounds represented by Formula (16) include those shown below.

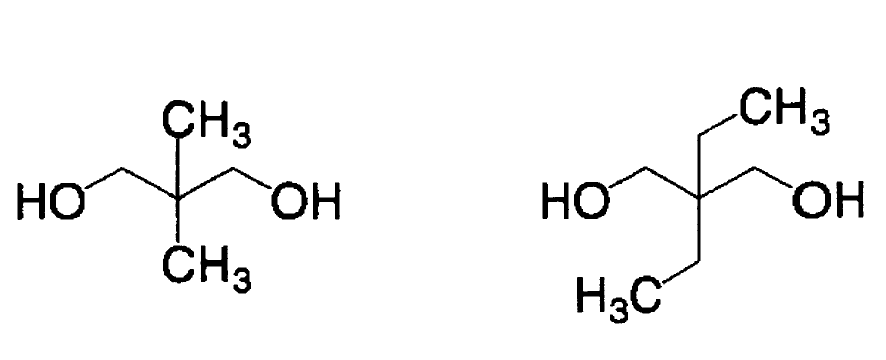

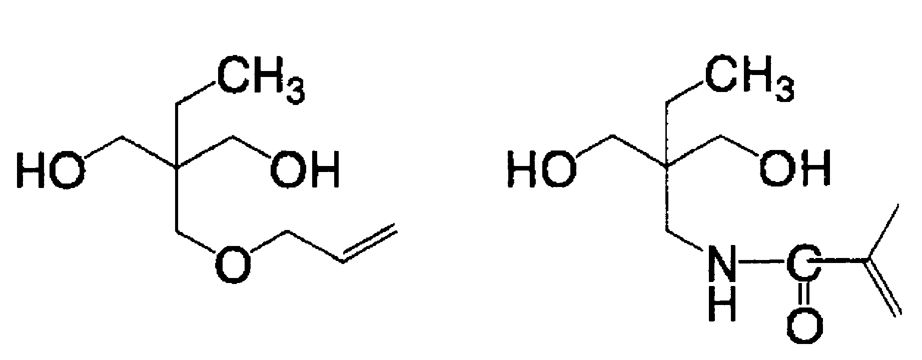

An example of the compounds represented by Formula (17) is 2-butyne-1,4-diol, and examples of the compounds represented by Formula (18) include cis-2-butene-1,4-diol and trans-2-butene-1,4-diol.
The diol compounds represented by the following formulae (19) and (20) may also be preferably used.

HO-L⁸-NH-CO-L⁹-CO-NH-L⁸-OH (19)

HO-L⁹-CO-NH-L⁸-OH (20)

In Formulae (19) and (20), L⁸ and L⁹ may be the same as or different from each other and each represent a divalent aliphatic hydrocarbon group, a divalent aromatic hydrocarbon group or a divalent heterocyclic group, which may have a substituent (such as an alkyl group, an aralkyl group, an aryl group, an alkoxy group, an aryloxy group and a halogen atom (-F, -Cl, -Br, -I)). If necessary, L⁸ and L⁹ may have another functional group that does not react with an isocyanate group, such as a carbonyl group, an ester group, a urethane group, an amido group or a ureido group. L⁸ and L⁹ may be bound to form a ring.
Specific examples of the compounds represented by Formula (19) or (20) include those shown below.

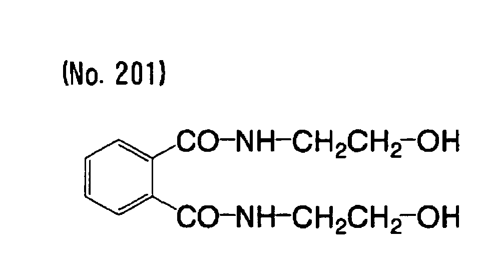

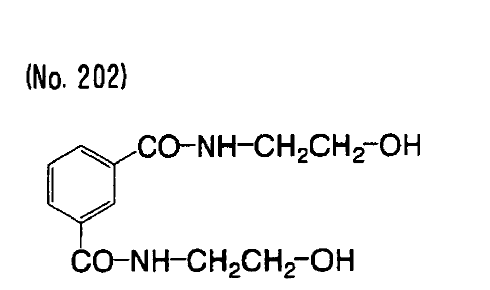

HO-CH₂CH₂-NH-CO-CH=CH-CO-NH-CH₂CH₂-OH (No. 203)

HO-CH₂CH₂-NH-CO-C≡C-CO-NH-CH₂CH₂-OH (No. 204)

HO-CH₂CH₂-NH-CO-(CH₂)₂-CO-NH-CH₂CH₂-OH (No. 205)

HO-CH₂CH₂-NH-CO-(CH₂)₃-CO-NH-CH₂CH₂-OH (No. 206)

HO-CH₂CH₂-NH-CO-(CH₂)₅-CO-NH-CH₂CH₂-OH (No. 207)

HO-CH₂CH₂-NH-CO-(CH₂)₈-CO-NH-CH₂CH₂-OH (No. 208)

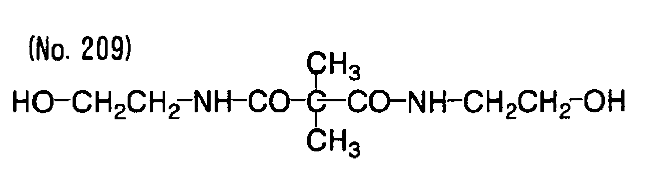

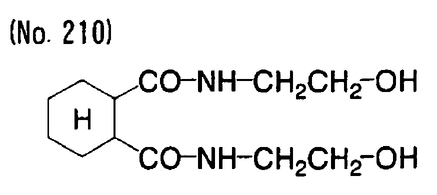

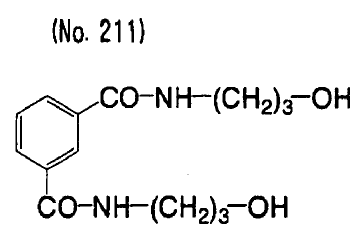

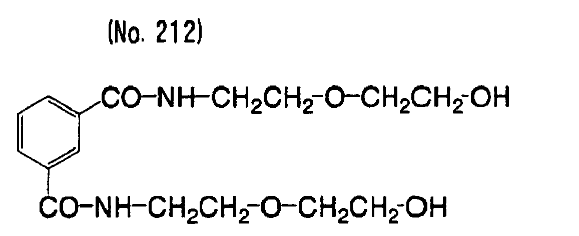

HO-(CH₂)₃-NH-(CH₂)₃-NH-CO-(CH₂)₂-CO-NH-(CH₂)₃-OH (No. 213)

HO-CH₂CH₂-O-CH₂CH₂-NH-CO-(CH₂)₄-CO-NH-CH₂CH₂-O-CH₂CH₂-OH (No. 214)

HO-CH₂CH₂-NH-CO-CH₂-O-CH₂-CO-NH-CH₂CH₂-OH (No. 215)

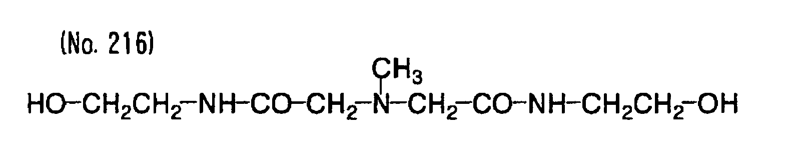

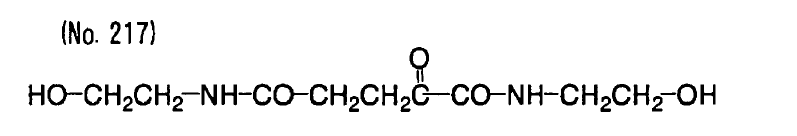

HO-CH₂CH₂-NH-CO-CH₂-S-CH₂-CO-NH-CH₂CH₂-OH (No. 218)

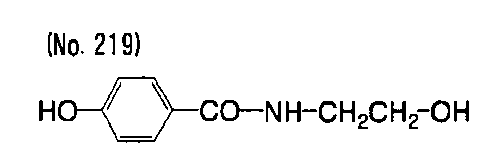

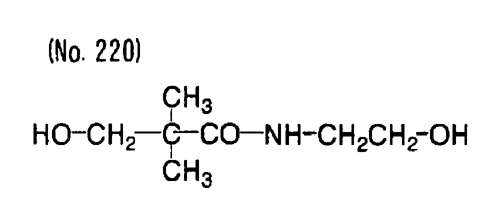

The diol compounds represented by the following Formula (21) or (22) may also be preferably used.

HO-Ar²-(L¹⁶-Ar³)ₙ-OH (21)

HO-Ar²-L¹⁶-OH (22)

In the formulae, L¹⁶ represents a divalent aliphatic hydrocarbon group which may have a substituent preferably such as an alkyl group, an aralkyl group, an aryl group, an alkoxy group, an aryloxy group or a halogeno group. If necessary, L¹⁶ may have another functional group that does not react with an isocyanate group, such as an ester group, a urethane group, an amido group or a ureido group.
Ar² and Ar³ may be the same as or different from each other and each represent an optionally substituted divalent aromatic hydrocarbon group, preferably an aromatic group having 6 to 15 carbon atoms. n represents an integer of 0 to 10.

Specific examples of the diol compounds represented by Formula (21) or (22) include catechol, resorcin, hydroquinone, 4-methyl catechol, 4-t-butyl catechol, 4-acetyl catechol, 3-methoxy catechol, 4-phenyl catechol, 4-methyl resorcin, 4-ethyl resorcin, 4-t-butyl resorcin, 4-hexyl resorcin, 4-chloro resorcin, 4-benzyl resorcin, 4-acetyl resorcin, 4-carbomethoxy resorcin, 2-methyl resorcin, 5-methyl resorcin, t-butyl hydroquinone, 2,5-di-t-butyl hydroquinone, 2,5-di-t-amyl hydroquinone, tetramethyl hydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-(p-hydroxyphenyl)propyl)benzene, bis(4-hydroxyphenyl)methylamine, 1,3-dihydroxy naphthalene, 1,4-dihydroxy naphthalene, 1,5-dihydroxy naphthalene, 2,6-dihydroxy naphthalene, 1,5-dihydroxy anthraquinone, 2-hydroxybenzyl alcohol, 4-hydroxybenzyl alcohol, 2-hydroxy-3,5-di-t-butylbenzyl alcohol, 4-hydroxy-3,5-di-t-butylbenzyl alcohol, 4-hydroxy phenethyl alcohol, 2-hydroxyethyl-4-hydroxybenzoate, 2-hydroxyethyl-4-hydroxyphenyl acetate, and resorcin mono-2-hydroxy ethyl ether. The diol compounds described below may also be preferably used.

### (v) Other amino group-containing compounds

Regarding the polyurethane resin binder in the invention, a urea structure obtained by reacting an amino group-containing compound represented by Formula (31) or (32) with a diisocyanate compound may be incorporated into the structure of the polyurethane resin.

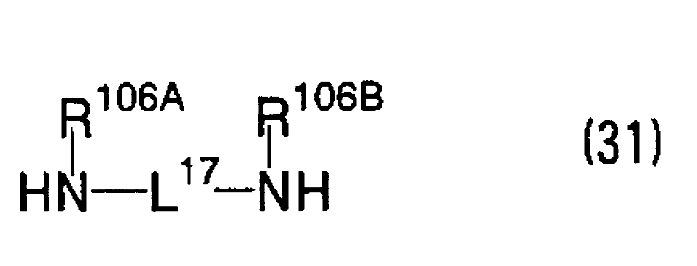

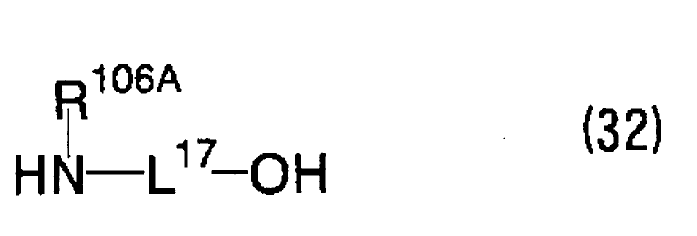

In Formulae (31) and (32), R^{106A} and R^{106B} may be the same as or different from each other and each represent a hydrogen atom or an alkyl, aralkyl or aryl group which may have a substituent (such as an alkoxy group, a halogen atom (-F, -Cl, -Br, -I), an ester group or a carboxyl group), and preferably represent a hydrogen atom or an alkyl group having 1 to 8 carbon atoms or an aryl group having 6 to 15 carbon atoms, which may have a carboxyl group as a substituent. L¹⁷ represents a divalent aliphatic hydrocarbon group, a divalent aromatic hydrocarbon group or a divalent heterocyclic group, which may have a substituent (such as an alkyl group, an aralkyl group, an aryl group, an alkoxy group, an aryloxy group, a halogen atom (-F, -Cl, -Br, -I) or a carboxyl group). If necessary, L¹⁷ may have another functional group that does not react with an isocyanate group, such as a carbonyl group, an ester group, a urethane group or an amido group. Two of R^{106A}, L¹⁷ and R^{106B} may be bound to form a ring.

Specific examples of the compounds represented by Formulae (31) and (32) include: aliphatic diamine compounds such as ethylene diamine, propylene diamine, tetramethylene diamine, pentamethylene diamine, hexamethylene diamine, heptamethylene diamine, octamethylene diamine, dodecamethylene diamine, propane-1,2-diamine, bis(3-aminopropyl)methylamine, 1,3-bis(3-aminopropyl)tetramethylsiloxane, piperazine, 2,5-dimethyl piperazine, N-(2-aminoethyl)piperazine, 4-amino-2,2-6,6-tetramethyl piperidine, N,N-dimethyl ethylene diamine, lysine, L-cystine or isophorone diamine; aromatic diamine compounds such as o-phenylene diamine, m-phenylene diamine, p-phenylene diamine, 2,4-tolylene diamine, benzidine, o-ditoluidine, o-dianisidine, 4-nitro-m-phenylene diamine, 2,5-dimethoxy-p-phenylene diamine, bis-(4-aminophenyl)sulfone, 4-carboxy-o-phenylene diamine, 3-carboxy-m-phenylene diamine, 4,4'-diaminophenyl ether or 1,8-naphthalene diamine; heterocyclic amine compounds such as 2-aminoimidazole, 3-aminotriazole, 5-amino-1H-tetrazole, 4-aminopyrazole, 2-aminobenzimidazole, 2-amino-5-carboxy-triazole, 2,4-diamino-6-methyl-S-triazine, 2,6-diaminopyridine, L-histidine, DL-tryptophan or adenine; and amino alcohol compounds or aminophenol compounds such as ethanolamine, N-methylethanolamine, N-ethylethanolamine, 1-amino-2-propanol, 1-amino-3-propanol, 2-aminoethoxy ethanol, 2-aminothioethoxy ethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenyl glycine, 2-aminobenzyl alcohol, 4-aminophenethyl alcohol, 2-carboxy-5-amino-1-naphthol or L-tyrosine.

From the viewpoints of the image-forming property and printing durability of the precursor, the weight-average molecular weight of the polyurethane binder to be used in the invention is preferably in the range of from 2,000 to 1,000,000, more preferably in the range of from 5,000 to 500,000, and still more preferably in the range of from 10,000 to 200,000.

In the invention, the polyurethane binders may be used alone or in combination of two or more thereof.
From the viewpoints of the image-forming property and printing durability of the precursor, the amount (total amount) of the polyurethane binders is usually in the range of from 10 to 90% by mass, preferably in the range of from 20 to 80% by mass, and still more preferably in the range of from 30 to 70% by mass with respect to the total mass of the non-volatile components in the recording layer.

### (E) Other components

Other components may further be added as appropriate to the composition constituting the specific recording layer of the planographic printing plate precursor according to the intended use thereof, the production method, or the like. Hereinafter, preferable additives will be described.

### (E-1) Co-Sensitizer

Through the use of a certain additive or compound in the polymerizable composition, sensitivity may be further improved. Such a compound will be referred to as a co-sensitizer hereinafter. The working mechanism of co-sensitizers is not clear, but is considered in most cases to be based mainly on the following chemical process. That is, it is thought that a co-sensitizer reacts with various intermediate active species (radicals and cations), which are generated in the photo-reaction initiated by a thermal polymerization initiator, and in the subsequent addition-polymerization reaction, to form new active radicals. The co-sensitizers may be roughly classified into (i) co-sensitizers capable of forming active radicals when reduced, (ii) co-sensitizers capable of forming active radicals when oxidized, and (iii) co-sensitizers which are converted into highly active radicals through reaction with radicals with low activity, or co-sensitizers acting as chain transfer agents. There are also many compounds which are not commonly classified into (i), (ii) or (iii).

### (i) Compound forming active radicals when reduced

Compounds having a carbon-halogen bond: It is considered that the carbon-halogen bond is reductively cleaved to generate active radicals. Specifically, for example, trihalomethyl-s-triazines and trihalomethyl oxadiazoles may be preferably used.
Compounds having a nitrogen-nitrogen bond: It is considered that the nitrogen-nitrogen bond is reductively cleaved to form active radicals. Specifically, hexaryl biimidazoles may be preferably used.
Compounds having an oxygen-oxygen bond: It is considered that the oxygen-oxygen bond is reductively cleaved to generate active radicals. Specifically, organic peroxides may be preferably used.
Onium compounds: It is considered that a carbon-heteroatom bond or an oxygen-nitrogen bond is reductively cleaved to generate active radicals. Specifically, diaryl iodonium salts, triaryl sulfonium salts, and N-alkoxy pyridinium (azinium) salts may be preferably used.
Ferrocene, iron arene complexes: Capable of forming active radicals reductively.

### (ii) Compound forming active radicals when oxidized

Alkylate complexes: It is considered that a carbon-heteroatom bond is oxidatively cleaved to generate active radicals. Specifically, for example, triaryl alkyl borates may be preferably used.
Alkyl amine compounds: It is considered that a C-X bond on a carbon adjacent to the nitrogen is cleaved by oxidation to form active radicals. X is preferably a hydrogen atom, a carboxyl group, a trimethylsilyl group, or a benzyl group. Specifically, ethanol amines, N-phenyl glycines, N-phenyliminodiacetic acid and its derivatives, and N-trimethylsilylmethyl, anilines may be mentioned.
Sulfur- or tin-containing compounds: A compound obtained by replacing the nitrogen atom in any of the above-described amines with a sulfur atom or a tin atom can form active radicals in a similar mechanism. Further, compounds having S-S bonds are known to act as sensitizers by cleavage of the S-S bonds.

α-Substituted methyl carbonyl compounds: Capable of forming active radicals through the cleavage of the carbonyl-α carbon bond upon oxidation. Further, compounds obtained by replacing the carbonyl in such a compound with an oxime ether exhibit the same action. Specifically, examples include 2-alkyl-1-[4-(alkylthio) phenyl]-2-morpholinopronone-1 and derivatives thereof, as well as oxime ethers prepared by reacting such compounds with hydroxy amines and then etherifying N-OH.
Sulfinates: Capable of forming active radicals reductively. Specifically, sodium aryl sulfinates may be mentioned.

(iii) Compound converted into highly active radicals through reaction with radicals, or compounds acting as a chain transfer agent: For example, compounds having SH, PH, SiH or GeH in the molecule are usable. These compounds may form radials by donating hydrogen to radicals having low-activity or by undergoing oxidization and subsequent deprotonation. Specifically, for example, 2-mercaptobenzimidazoles may be mentioned.

In a preferable embodiment, a polycarboxylic acid compound having an aromatic ring or heterocyclic aromatic ring structure to which at least two carboxyl groups are bonded directly or via a divalent linking group is contained for the purpose of improving sensitivity and/or developability. Specific examples of the polycarboxylic acid compound include (p-acetamidophenylimido) diacetic acid, 3-(bis(carboxymethyl)amino) benzoic acid, 4-(bis(carboxymethyl)amino) benzoic acid, 2-[(carboxymethyl)phenylamino] benzoic acid,
2-[(carboxymethyl)phenylamino]-5-methoxybenzoic acid,
3-[bis(carboxymethyl)amino]-2-naphthalene carboxylic acid,
N-(4-aminophenyl)-N-(carboxymethyl) glycine, N,N'-1,3-phenylene-bis-glycine, N,N'-1,3-phenylenebis[N-(carboxymethyl)] glycine,
N,N'-1,2-phenylenebis[N-(carboxymethyl)] glycine,
N-(carboxymethyl)-N-(4-methoxyphenyl) glycine, N-(carboxymethyl)-N-(3-methoxyphenyl) glycine, N-(carboxymethyl)-N-(3-hydroxyphenyl) glycine,
N-(carboxymethyl)-N-(3-chlorophenyl) glycine, N-(carboxymethyl)-N-(4-bromophenyl) glycine, N-(carboxymethyl)-N-(4-chlorophenyl) glycine,

N-(carboxymethyl)-N-(2-chlorophenyl) glycine,
N-(carboxymethyl)-N-(4-ethylphenyl) glycine, N-(carboxymethyl)-N-(2,3-dimethylphenyl) glycine, N-(carboxymethyl)-N-(3,4-dimethylphenyl) glycine,
N-(carboxymethyl)-N-(3,5-dimethylphenyl) glycine,
N-(carboxymethyl)-N-(2,4-dimethylphenyl) glycine,
N-(carboxymethyl)-N-(2,6-dimethylphenyl) glycine, N-(carboxymethyl)-N-(4-formylphenyl) glycine, N-(carboxymethyl)-N-ethylanthranilic acid, N-(carboxymethyl)-N-propylanthranilic acid, 5-bromo-N-(carboxymethyl) anthranilic acid, N-(2-carboxyphenyl) glycine, o-dianisidine-N,N,N',N'-tetraacetic acid, N,N'-[1,2-ethanediylbis(oxy-2,1-phenylene)] bis[N-(carboxymethyl) glycine], 4-carboxyphenoxy acetic acid, cathecol-O,O'-diacetic acid, 4-methylcatechol-O,O'-diacetic acid, resorcinol-O,O'-diacetic acid,
hydroquinone-O,O'-diacetic acid, α-carboxy-o-anisic acid, 4,4'-isopropylidene diphenoxy acetic acid, 2,2'-(dibenzofuran-2,8-diyldioxy) diacetic acid, 2-(carboxymethylthio) benzoic acid, 5-amino-2-(carboxymethylthio) benzoic acid, and 3-[(carboxymethyl)thio]-2-naphthalene carboxylic acid.
In particular, N-arylpolycarboxylic acids represented by the following Formula (VI) or compounds represented by the following Formula (VII) are preferable.

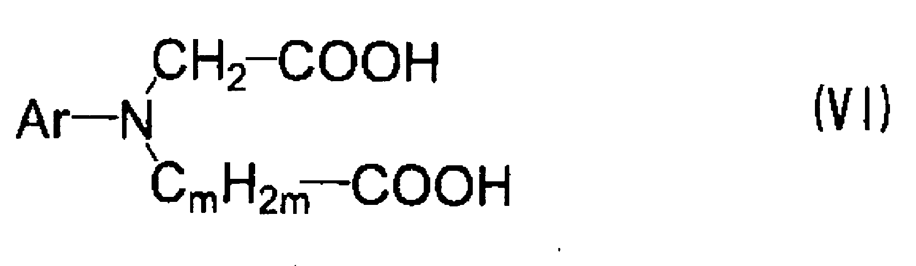

In Formula (VI), Ar represents a monosubstituted, polysubstituted or unsubstituted aryl group, and m represents an integer from 1 to 5.
Examples of a substituent which can be introduced into the aryl group include an alkyl group having 1 to 3 carbon atoms, an alkoxy group having 1 to 3 carbon atoms, a thioalkyl group having 1 to 3 carbon atoms and a halogen atom. This aryl group preferably has 1 to 3 identical or different substituents. m preferably represents 1, and Ar preferably represents a phenyl group.

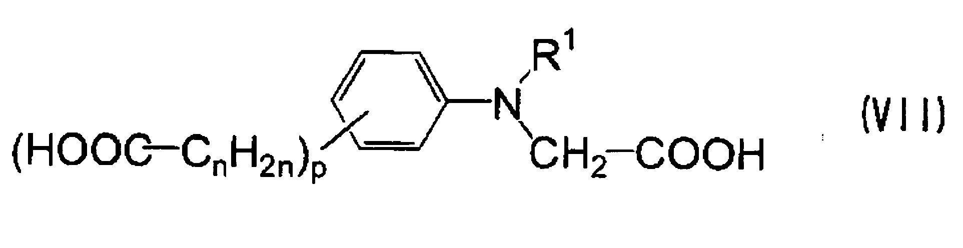

In Formula (VII), R¹ represents a hydrogen atom or an alkyl group having 1 to 6 carbon atoms, and each of n and p represents an integer from 1 to 5.
n preferably represents 1, and R¹ preferably represents a hydrogen atom. The most preferable polycarboxylic acid is anilinodiacetic acid.

Another compound preferable for improving sensitivity and/or developability may be a compound having two or more groups selected from carboxylic acid groups and sulfonic acid groups, and specific examples thereof include 5-aminoisophthalic acid, 5-nitroisophthalic acid, 4-methylphthalic acid, terephthalic acid, 2-bromoterephthalic acid, 2,3-naphthalenedicarboxylic acid, diphenic acid, 1,4,5,8-naphthalenetetracarboxylic acid, N-benzyliminodiacetic acid, N-(2-carboxyphenylglycine), N-phenyliminodiacetic acid, 1,3,5-benzenetricarboxylic acid, 1,2,4,5-benzenetetracarboxylic acid, 5-sulfosalicylic acid, 2-sulfobenzoic acid, 1,5-naphthalenedisulfonic acid, and 4-sulfophthalic acid. The above compound may be further substituted by an alkyl group, an alkenyl group, an alkynyl group, a cyano group, a halogen atom, a hydroxyl group, a carboxyl group, a carbonyl group, an alkoxy group, an amino group, an amide group, a thiol group, a thioalkoxy group, or a sulfonyl group.
Of these, the most preferable compound is a compound represented by Formula (V) or (VI).
The amount of the poly(carboxylic acid/sulfonic acid) compound to be added is preferably 0.5 to 15% by mass, more preferably 1 to 10% by mass, and still more preferably 3 to 8% by mass, with respect to the solid content of the polymerizable composition.

A large number of more specific examples of these co-sensitizers are described, for example, in JP-A No. 9-236913 as additives for improving sensitivity, and such compounds may also be used in the invention.
These co-sensitizers may be used alone or in combination of two or more thereof. The amount of the co-sensitizer to be used is suitably in the range of from 0.05 to 100 parts by mass, preferably in the range of from 1 to 80 parts by mass, and more preferably in the range of from 3 to 50 parts by mass, with respect to 100 parts by mass of the specific polymerizable compound.

### (E-2) Polymerization Inhibitor

In addition to the components described above, it is preferable to add a small amount of a thermal polymerization inhibitor in order to inhibit undesired thermal polymerization of the polymerizable compound having an ethylenically unsaturated bond during the production or storage of the negative planographic printing plate. Preferable examples of the thermal polymerization inhibitor include hydroquinone, p-methoxyphenol, di-t-butyl-p-cresol, pyrogallol, t-butylcatechol, benzoquinone, 4,4-thiobis(3-methyl-6-t-butylphenol), 2,2-methylenebis(4-methyl-6-t-butylphenol), a primary cerium salt of N-nitrosophenylhydroxylamine and an aluminum salt of N-nitrosophenylhydroxylamine The amount of the thermal polymerization inhibitor to be added is preferably about 0.01 % by mass to about 5% by mass with respect to the total solid content constituting the recording layer.

### (E-3) Colorants and the like

A colorant may be added for the purpose of coloring the recording layer. Examples of the colorant include: pigments such as phthalocyanine pigments (C. I. Pigment Blue 15:3, 15:4, 15:6, and the like), azo pigments, carbon black or titanium oxide; and dyes such as ethyl violet, crystal violet, azo dyes, anthraquinone dyes or cyanine dyes. The amount of the dye or pigment to be added is preferably about 0.5% by mass to about 20% by mass with respect to the total solid content of the recording layer. For improving physical properties of a hardened coating, additives such as inorganic fillers or plasticizers such as dioctyl phthalate, dimethyl phthalate or tricresyl phosphate may be added. The amount of these additives is preferably 10% by mass or less with respect to the total solid content of the recording layer.

The specific planographic printing plate precursor may be produced by coating a suitable support with a recording layer coating solution including the components (A) to (D) and, if necessary, with a solution prepared by dissolving, in a solvent, coating solution components used for layers such as a protective layer.
Examples of the solvent used herein include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxy propanol, methoxymethoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethylsulfoxide, γ-butyrolactone, methyl lactate and ethyl lactate. These solvents may be used alone or as a mixture thereof. The solid concentration in a coating solution is preferably 2 to 50% by mass.

It is preferable that the coating amount of the recording layer coating solution on a support described later be determined suitably depending on applications in consideration of the effects on the sensitivity and developability of a recording layer and the strength, printing durability, or the like of a light-exposed film. When the coating amount is too small, printing durability may not be satisfactory. An excessive coating amount is not preferable because sensitivity may be decreased, the time for light exposure may be prolonged, and the development treatment may also take a longer period of time. In the invention, the coating amount of the recording layer coating solution on the planographic printing plate precursor is generally in the range of from about 0.1 to about 10 g/m², and more preferably from 0.5 to 5 g/m², in terms of dry mass.

### Protective layer (oxygen barrier layer)

The specific planographic printing plate precursor may be provided with a protective layer (oxygen barrier layer) on the recording layer in order to prevent diffusion and permeation of oxygen that interferes with the polymerization reaction upon exposure to light. The protective layer used in the invention preferably has an oxygen permeability A of 1.0 to 20 (cc/m²·day) at 25°C at 1 atmospheric pressure. When the oxygen permeability A is 1.0 (cc/m²·day) or more, unnecessary polymerization reaction may not occur during the process of production and stock storage, or problems such as undesirable fogging and thickening of drawn lines may not occur during the image exposure.
When the oxygen permeability A is 20 (cc/m²·day) or less, sensitivity may not be decreased. The protective layer is desirably a layer which has the low oxygen permeability, does not substantially inhibit penetration of light used in light exposure, is excellent in adhesiveness to the recording layer, and may be easily removed in the development after light exposure. Conventionally, the protective layer has been devised in many ways and described in detail in U.S. Patent No. 3,458,311 and Japanese Patent Application Publication (JP-B) No. 55-49729.

A preferable example of a material usable in the protective layer is a water-soluble polymer compound having relatively high crystallinity. Specific examples of the material include water-soluble polymers such as polyvinyl alcohol, a vinyl alcohol/vinyl phthalate copolymer, a vinyl acetate/vinyl alcohol/vinyl phthalate copolymer, a vinyl acetate/crotonic acid copolymer, polyvinyl pyrrolidone, acidic celluloses, gelatin, gum arabic, polyacrylic acid or polyacrylamide. These compounds may be used alone or as a mixture thereof. Among these compounds, polyvinyl alcohol may preferably be used as the major component from the viewpoints of characteristics such as oxygen impermeability and removability at development.

The polyvinyl alcohol to be used in the protective layer may be partially substituted by ester, ether or acetal as long as it has an unsubstituted vinyl alcohol unit which imparts oxygen impermeability and water solubility to the protective layer. Similarly, the polyvinyl alcohol may be a copolymer also containing one or more other copolymerizable components. Examples of the polyvinyl alcohol include one hydrolyzed at a degree of 71 to 100 mol% and having 300 to 2400 polymerization repeating units. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (all trade names, manufactured by Kuraray Co., Ltd.). These may be used singly or in combination. In a preferable exemplary embodiment, the amount of polyvinyl alcohol in the protective layer is 20 to 95% by mass, more preferably 30 to 90% by mass.

Components mixed for use with polyvinyl alcohol are preferably polyvinyl pyrrolidone or modification products thereof, from the viewpoints of oxygen barrier properties and removability at development, and the amount thereof in the protective layer is 3.5 to 80% by mass, preferably 10 to 60% by mass, more preferably 15 to 30% by mass.

The components (selection ofPVAs, use of additives), coating amounts and the like of the protective layer are selected taking into account of the oxygen barrier properties, removing properties at development as well as fogging properties, adhesiveness and scratch resistance. In general, as the hydrolysis ratio of the polyvinyl alcohol (PVA) to be used is higher (that is, as the amount of the unsubstituted vinyl alcohol units in the protective layer is higher), and as the film thickness is larger, oxygen barrier properties may be increased, leading to advantages with respect to sensitivity. However, excessively increased oxygen barrier properties cause problems of unnecessary polymerization reaction to occur during the process of production and stock storage, or undesirable fogging and thickening of drawn lines to occur during the image exposure. The protective layer in the invention at 25°C at 1 atmospheric pressure has an oxygen permeability A in the range of preferably from 1.0 to 20 (cc/m²·day), more preferably in the range of from 1.5 to 12 (cc/m²·day), still more preferably and in the range of from 2.0 to 8.0 (cc/m²·day). The molecular weight (weight-average molecular weight) of the (co)polymer such as polyvinyl alcohol (PVA) is in the range of from 2000 to 10,000,000, and preferably in the range of from 20,000 to 3,000,000.

As other additional components of the protective layer, glycerin, dipropylene glycol or the like may be added in an amount of several % by mass with respect to the (co)polymer for improving flexibility. In addition, a surfactant may be included in the protective layer in an amount of several % by mass with respect to the (co)polymer, and examples of the surfactant include: anionic surfactants such as sodium alkylsulfate or sodium alkylsulfonate; amphoteric surfactants such as alkylamino carboxylate salts or alkylamino dicarboxylate salts; and nonionic surfactants such as polyoxyethylene alkylphenyl ether. The thickness of the protective layer is preferably 0.5 to 5 µm, more preferably 1 to 3 µm.

The adhesiveness to an image portion of the recording layer and the scratch resistance are extremely important characteristics of the protective layer from the viewpoint of handling of the printing plate. That is, when a hydrophilic layer including a water-soluble polymer is laminated on a lipophilic recording layer, layer separation easily occurs due to insufficient adhesiveness, and the released portion causes deficiency such as insufficient layer curing attributable to polymerization inhibition by oxygen. Regarding the problems, various proposals for improving the adhesion between the two layers have been made. For example, US Patent Application Nos. 292,501 and 44,563 disclose that an acrylic emulsion, a water-insoluble vinyl pyrrolidone-vinyl acetate copolymer or the like is mixed in an amount of 20 to 60% by mass in a hydrophilic polymer mainly composed of polyvinyl alcohol, and then the resultant composition is laminated on a recording layer, whereby satisfactory adhesiveness is obtained. Any one of the conventionally-known methods may be applied to the protective layer in the invention, and details of these methods are described in U.S. Patent No. 3,458,311, JP-B No. 55-49729 and the like.

A colorant (water-soluble dye) excellent in transmittance to the light used for exposure of the recording layer and capable of effectively absorbing light of a wavelength that does not participate in exposure may be added to the protective layer. Safelight compatibility may thereby be increased without reducing sensitivity.

The amount of the protecting layer is generally 0.1 to 10 g/m², preferably 0.5 to 5 g/m², in terms of dry mass.

### Hydrophilic support

The hydrophilic support of the specific planographic printing plate precursor may be any of known hydrophilic supports used in planographic printing plates. The support to be used is preferably a dimensionally stable plate. Examples thereof include paper, paper with plastics (e.g., polyethylene, polypropylene, polystyrene etc.) laminated thereon, a metal plate (e.g., aluminum, zinc, copper etc.), a plastic film (e.g., cellulose diacetate, cellulose triacetate, cellulose propionate, cellulose butyrate, cellulose butyrate acetate, cellulose nitrate, polyethylene terephthalate, polyethylene, polystyrene, polypropylene, polycarbonate, polyvinyl acetal etc.), and paper and a plastic film which have the metal laminated or vapor-deposited thereon. If necessary, the surface of the support may be subjected to an appropriate known physical or chemical treatment for the purpose of imparting hydrophilicity, improving the strength or the like.

Preferable examples of the hydrophilic support include paper, a polyester film, and an aluminum plate, among which an aluminum plate, which is superior in dimensional stability and relatively cheap, and whose surface may be provided with superior hydrophilicity and strength by surface treatment as needed, is particularly preferable. In addition, the hydrophilic support may also be preferably a composite sheet in which an aluminum sheet is laminated on a polyethylene terephthalate film, such as those disclosed in JP-B No. 48-18327.

The aluminum substrate is a metal plate including dimensionally stable aluminum as a main component, and examples thereof include a pure aluminum plate as well as an alloy plate which includes aluminum as a main component and an extremely small amount of different elements, and a plastic film or paper having aluminum (alloy) laminated or vapor-deposited thereon.

Hereinafter, substrates made of aluminum or aluminum alloys as described above are referred to collectively as the aluminum substrate. Examples of one or more different elements that may be included in the aluminum alloy include silicon, iron, manganese, copper, magnesium, chromium, zinc, bismuth, nickel, and titanium. The amount of the one or more different elements that may be included in the alloy is 10% by mass or less. In the invention, a pure aluminum plate is particularly preferably used. However, because production of absolutely pure aluminum is difficult in terms of refining techniques, aluminum may include an extremely small amount of one or more different elements.

The composition of the aluminum plate used in the invention is not limited, and any aluminum plates made of known and conventionally used materials, such as those defined by JIS A1050, JIS A1100, JIS A3103 and JIS A3005, may appropriately be used. The thickness of the aluminum substrate used in the invention is about 0.1 mm to 0.6 mm, preferably 0.15 mm to 0.4 mm, and more preferably 0.2 mm to 0.3 mm. The thickness may be appropriately changed depending on the size of the printing machine used, the size of the printing plate used, and the needs of the user. The aluminum substrate may appropriately be subjected to a surface treatment described below, if needed. However, such a treatment is not always necessary.

The surface of the aluminum substrate may be roughened. Examples of a method for roughening a surface include mechanical surface roughening, chemical etching, and electrolytic graining as disclosed in JP-A No. 56-28893; an electrochemical surface roughening method of electrochemically roughening a surface in a hydrochloric acid or nitric acid electrolyte; and a mechanical surface roughening method such as a wire brush graining method of scratching an aluminum surface with a metal wire, a ball graining method of roughening an aluminum surface with a polishing ball and an abrasive, and a brush graining method of roughening a surface with a nylon brush and an abrasive. One of these roughening methods may be used, or a combination of two or more of them may be used. Among these, the surface roughening method is preferably an electrochemical method of chemically roughening a surface in a hydrochloric acid or nitric acid electrolyte. A suitable electric quantity is in the range of from 50 to 400 C/dm², when the support serves as an anode. More specifically, alternate and/or direct current electrolysis is preferably carried out in an electrolyte having a hydrochloric acid or nitric acid content of 0.1 to 50% by mass at a temperature in the range of from 20 to 80°C at an electric current density of 100 to 400 C/dm² for 1 second to 30 minutes.

The aluminum substrate thus surface-roughened may be chemically etched in an acid or alkaline solution. Preferable examples of an etching agent include sodium hydroxide, sodium carbonate, sodium aluminate, sodium metasilicate, sodium phosphate, potassium hydroxide, and lithium hydroxide. The concentration of the etching agent is preferably 1 to 50% by mass, and the temperature of the etching agent is preferably 20 to 100°C. In order to remove stains (smuts) that remain on the etched surface, the substrate may be washed with acid. Typical examples of the acid to be used include nitric acid, sulfuric acid, phosphoric acid, chromic acid, hydrofluoric acid, and fluoroboric acid. A method for removing smuts on an electrochemically roughened surface is preferably a method described in JP-A No. 53-12739 in which a surface is brought into contact with 15 to 65% by mass of sulfuric acid at a temperature in the range of from 50 to 90°C, or a method described in JP-B 48-28123 in which a surface is etched with alkali. The method and conditions are not particularly limited, as long as the surface roughness Ra of the roughened surface is about 0.2 µm to 0.5 µm after the treatment.

The thus-treated aluminum substrate may then be subjected to anodizing treatment to form an oxide layer thereon. In the anodizing treatment, an aqueous solution of any one of sulfuric acid, phosphoric acid, oxalic acid, boric acid, or sodium borate may be used alone, or an aqueous solution of a combination of two or more of such substances may be used as the major component in an electrolytic bath. In this case, the electrolytic solution may, of course, include at least components normally included in the Al alloy plate, the electrodes, tap water and underground water. Second components, or second and third components may also be included. Examples of the second components or second and third components referred to herein include: cations of metals such as Na, K, Mg, Li, Ca, Ti, Al, V, Cr, Mn, Fe, Co, Ni, Cu or Zn, and ammonium ions; and anions such as a nitrate ion, a carbonate ion, a chlorine ion, a phosphate ion, a fluorine ion, a sulfite ion, a titanate ion, a silicate ion or a borate ion. The concentration of the cation or the anion in the electrolytic solution may be from about 0 to 10000 ppm. Although the conditions for the anodizing treatment are not particularly limited, the plate is preferably treated with a 30 to 500 g/L aqueous solution of at least one of sulfuric acid, phosphoric acid, oxalic acid, boric acid, and sodium borate, at a temperature of 10 to 70°C by direct current or alternating current electrolysis in a range of an electric current density of 0.1 to 40 A/m². The thickness of the anodized layer thus formed may be in the range of from 0.5 µm to 1.5 µm, preferably in the range of from 0.5 µm to 1.0 µm.

After these treatments are conducted, the aluminum substrate is preferably primed with a water-soluble resin, for example, polyvinylphosphonic acid, a polymer or copolymer having a sulfo group in a side chain thereof, polyacrylic acid, a water-soluble metal salt (for example, zinc borate) or a yellow dye or an amine salt. A sol-gel treated substrate to which functional groups capable of addition reaction by radicals are covalently bound as disclosed in JP-ANo. 7-159983 is also preferably used.

Another preferable substrate is the one having a water-resistant hydrophilic layer arranged as a surface layer on an arbitrary support. Examples of such surface layer include a layer including an inorganic pigment and a binder as described in U.S. Patent No. 3055295 and JP-A No. 56-13168, a hydrophilic swollen layer described in JP-A No. 9-80744, and a sol-gel film including titanium oxide, polyvinyl alcohol and silicates as described in Japanese Patent Application National Publication (Laid-Open) No. 8-507727. These hydrophilization treatments are conducted not only for rendering the surface of a support hydrophilic but also for preventing a harmful reaction of a recording layer arranged thereon and simultaneously improving the adhesiveness and the like of the recording layer.

### Intermediate layer

For the purpose of improving the adhesiveness between the recording layer and the support and stain resistance, the specific planographic printing plate precursor may have an intermediate layer. Specific examples of the intermediate layer include those described in JP-B No. 50-7481, JP-ANo. 54-72104, JP-ANo. 59-101651, JP-ANo. 60-149491, JP-ANo. 60-232998, JP-A 3-56177, JP-A No. 4-282637, JP-A No. 5-16558, JP-A No. 5-246171, JP-A No. 7-159983, JP-A No. 7-314937, JP-A No. 8-202025, JP-A No. 8-320551, JP-A No. 9-34104, JP-A No. 9-236911, JP-A No. 9-269593, JP-A No. 10-69092, JP-A No. 10-115931, JP-A No. 10-161317, JP-A No. 10-260536, JP-A No. 10-282682, JP-A No. 11-84674, JP-A No. 11-38635, JP-A No. 11-38629, JP-A No. 10-282645, JP-A No. 10-301262, JP-A No. 11-24277, JP-A No. 11-109641, JP-A No. 10-319600, JP-A No. 11-327152, JP-A No. 2000-10292, JP-A No. 2000-235254, JP-A No. 2000-352824, and JP-A No. 2001-209170.

### Method of producing a negative planographic printing plate

The method of producing a negative planographic printing plate of the invention includes exposing the planographic printing plate precursor as described above to infrared laser light, and then developing the precursor with a developer that has pH in the range of from 11.5 to 12.8 and includes an alkali silicate and an anionic surfactant, the alkali silicate having an SiO₂/M₂O molar ratio of 0.75 to 4.0 wherein M represents an alkali metal or an ammonium group.
As described above, it may be anticipated that a planographic printing plate with high sensitivity and high printing durability may include a photopolymerization initiation system including a urethane monomer, a polyurethane binder, an infrared absorber and an onium salt. However, when an infrared absorber containing an ion pair, or an onium salt is introduced into a urethane compound having strong hydrogen bonding, the interaction therebetween is increased during, in particular, long-term storage, thereby causing deterioration in developability giving rise to a problem of printing stains on a non-image region and development scums. There is another problem of development scums at the time of a running treatment because of the low solubility of the infrared absorber in a developer.
By development with the developer used in the invention, development scums or printing stains are hardly generated at the time of a running treatment and even after long-term storage, owing to a synergistic effect brought about by the hydrophilization effect of the silicate compound on the surface of a support and the dispersion effect of the anionic surfactant on an infrared absorber.

### Developer

### [1] Anionic surfactant

The anionic surfactant used in the invention may be a compound having at least one anion group in a molecule thereof. Examples of the anion group include a carboxylate anion, a sulfonate anion, a sulfinate anion, a sulfate anion, a sulfite anion, a phosphate anion, a phosphite anion, a phosphonate anion and a phosphinate anion, among which a sulfonate anion or a sulfate anion is preferable. Specifically, the anionic surfactant is preferably a compound having at least one group selected from a sulfonate anion group and a sulfate anion group, more preferably a compound having a sulfonate anion group or a sulfate monoester anion group, still more preferably a compound represented by the following Formula (XI) or (XII).

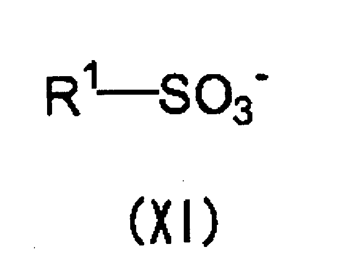

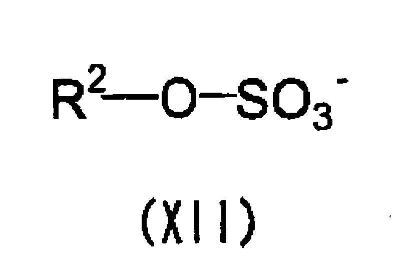

In Formulae (XI) and (XII), R¹ and R² each represent an optionally substituted alkyl, cycloalkyl, alkenyl, aralkyl or aryl group. The alkyl group is preferably an alkyl group having 1 to 20 carbon atoms, and specific examples thereof include a methyl group, an ethyl group, a propyl group, an n-butyl group, a sec-butyl group, a hexyl group, a 2-ethylhexyl group, an octyl group, a decyl group, a dodecyl group, a hexadecyl group and a stearyl group.

The cycloalkyl group represented by R¹ or R² may be a monocyclic or polycyclic group. The monocyclic group preferably has 3 to 8 carbon atoms, and preferable examples thereof include a cyclopropyl group, a cyclopentyl group, a cyclohexyl group and a cyclooctyl group. Preferable examples of the polycyclic group include an adamantyl group, a norbornyl group, an isobornyl group, a camphanyl group, a dicyclopentyl group, an a-pinnell group and a tricyclodecanyl group.

The alkenyl group represented by R¹ or R² is, for example, an alkenyl group having 2 to 20 carbon atoms, and specific examples thereof include a vinyl group, an allyl group, a butenyl group and a cyclohexenyl group.

Preferably, the aralkyl group represented by R¹ or R² is, for example, an aralkyl group having 7 to 12 carbon atoms, and specific examples thereof include a benzyl group, a phenethyl group and a naphthylmethyl group.

The aryl group represented by R¹ or R² is, for example, an aryl group having 6 to 15 carbon atoms, and specific examples thereof include a phenyl group, a tolyl group, a dimethylphenyl group, a 2,4,6-trimethylphenyl group, a naphthyl group, an anthryl group and a 9,10-dimethoxyanthryl group. The substituent may be a monovalent nonmetallic atomic group excluding a hydrogen atom, and preferable examples of the substituent include a halogen atom (F, Br, Cl, I), a hydroxyl group, an alkoxy group, an aryloxy group, an acyl group, an amido group, an ester group, an acyloxy group, a carboxy group, a carbonate anion group and a sulfonate anion group.

Specific examples of the alkoxy group used as the substituent include alkoxy groups having 1 to 20 carbon atoms, such as a methoxy group, an ethoxy group, a propyloxy group, an isopropyloxy group, a butyloxy group, a pentyloxy group, a hexyloxy group, a dodecyloxy group, a stearyloxy group or a methoxyethoxy group. Examples of the aryloxy group include aryloxy groups having 6 to 18 carbon atoms, such as a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group or a naphthyloxy group. Examples of the acyl group include acyl groups having 2 to 24 carbon atoms, such as an acetyl group, a propanoyl group, a butanoyl group, a benzoyl group or a naphthoyl group. Examples of the amido group include amido groups having 2 to 24 carbon atoms, such as an acetamido group, a propionic acid amide group, a dodecanoic acid amide group, a palmitic acid amide group, a stearic acid amide group, a benzoic acid amide group or a naphthoic acid amide group. Examples of the acyloxy group include acyloxy groups having 2 to 20 carbon atoms, such as an acetoxy group, a propanoyloxy group, a benzoyloxy group or a naphthoyloxy group. Examples of the ester group include ester groups having 1 to 24 carbon atoms, such as a methyl ester group, an ethyl ester group, a propyl ester group, a hexyl ester group, an octyl ester group, a dodecyl ester group or a stearyl ester group.

Examples of the compounds represented by Formula (XI) or (XII) are shown below, but the invention is not limited thereto.

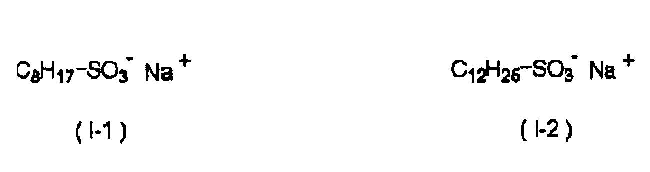

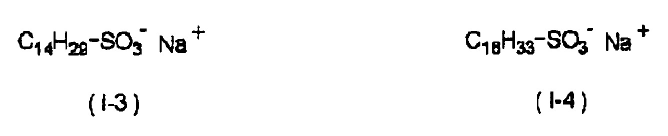

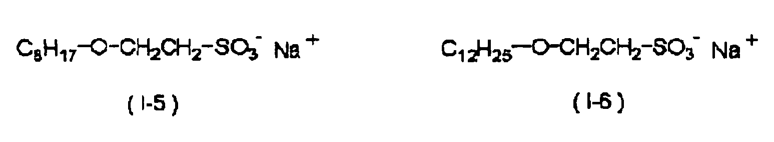

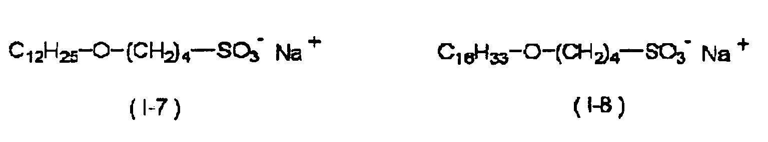

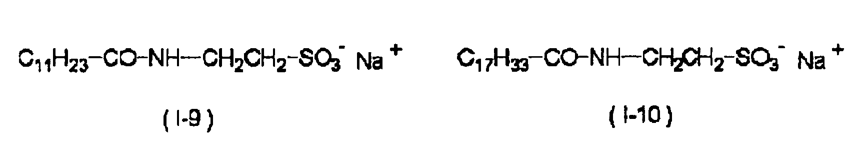

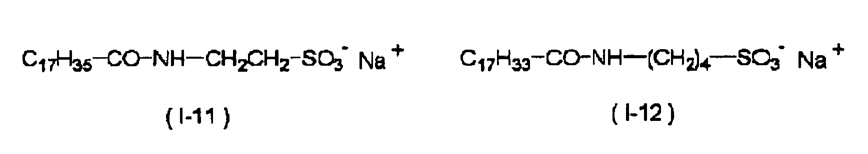

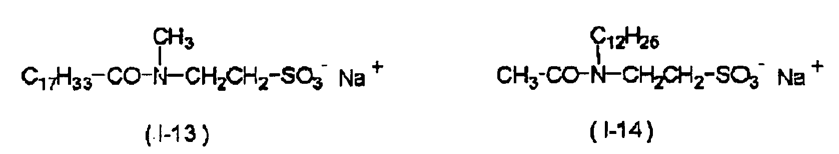

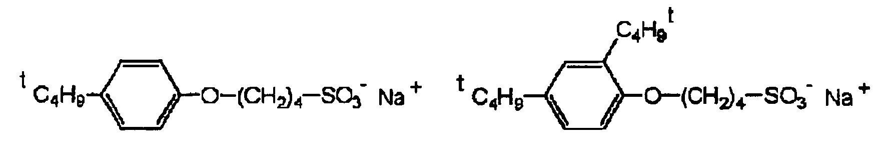

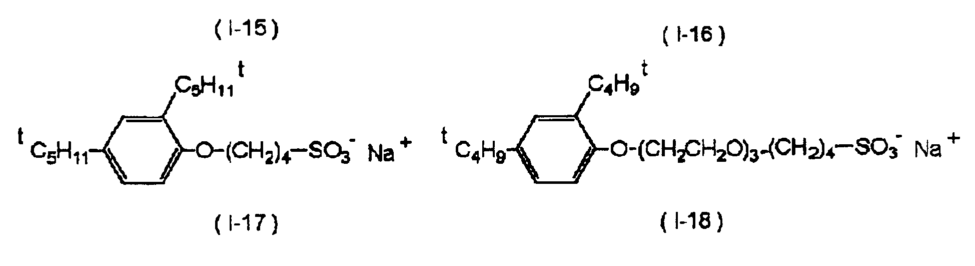

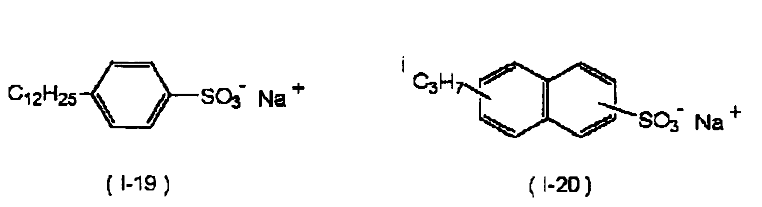

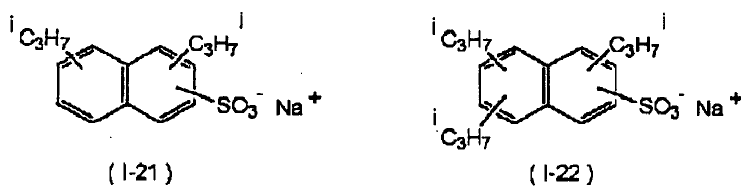

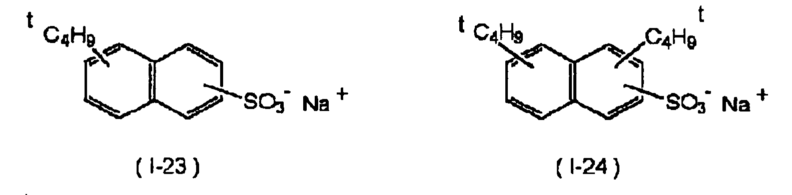

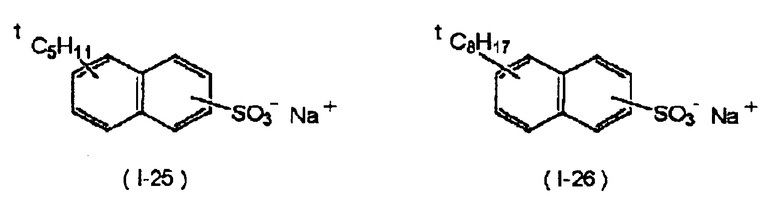

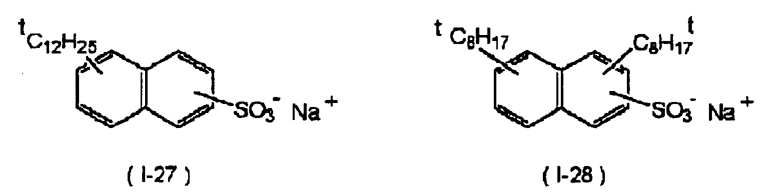

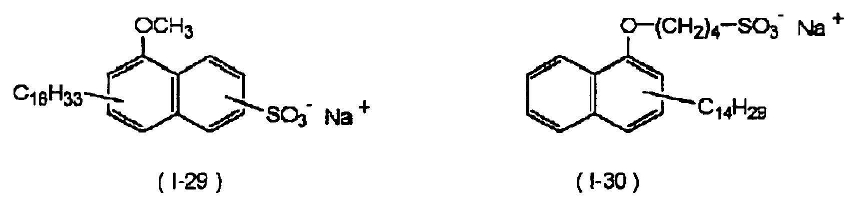

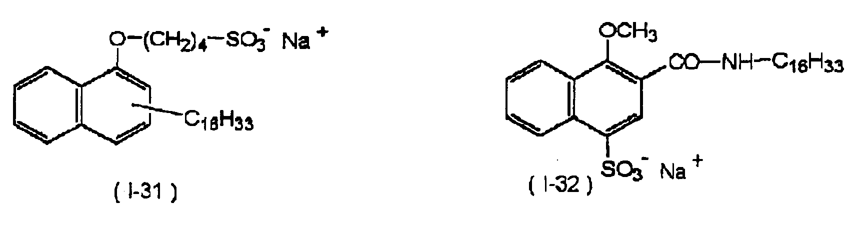

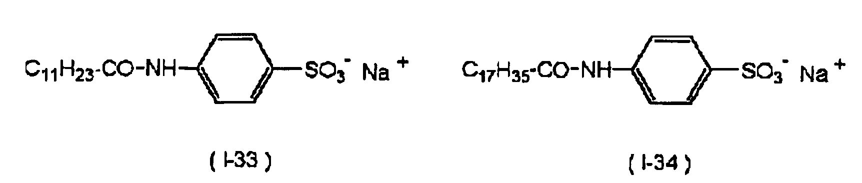

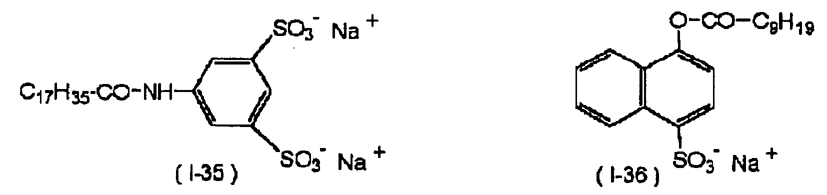

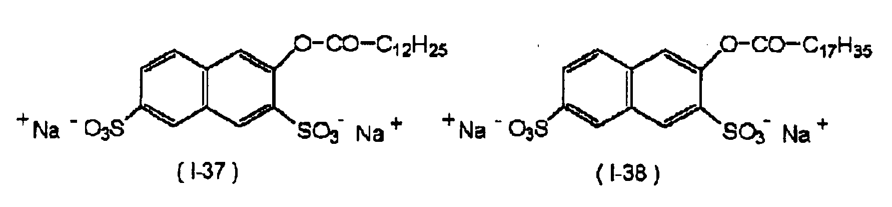

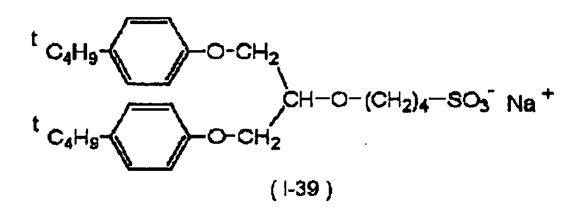

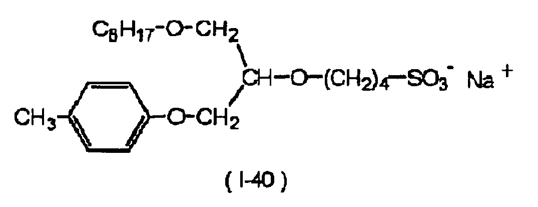

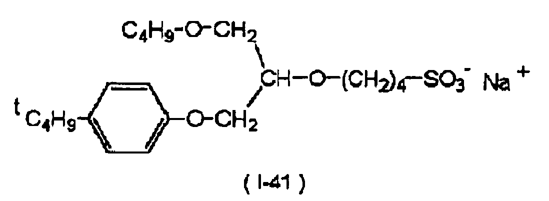

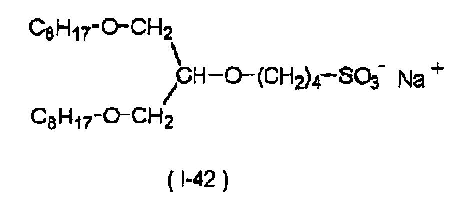

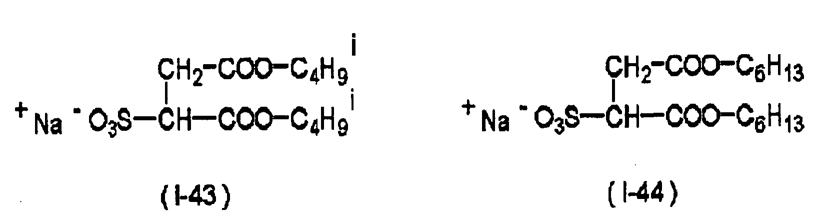

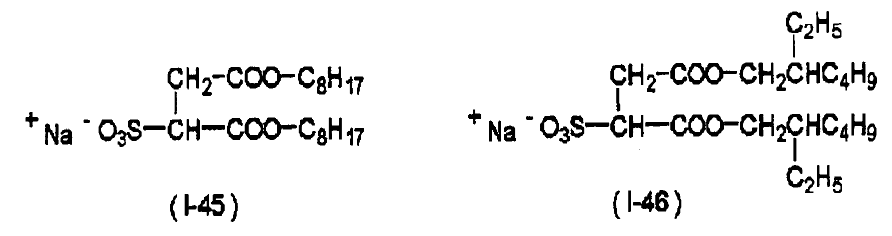

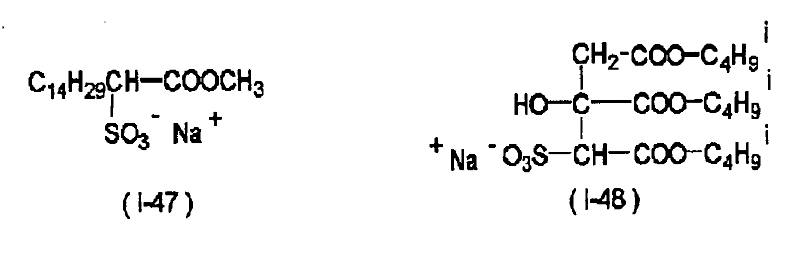

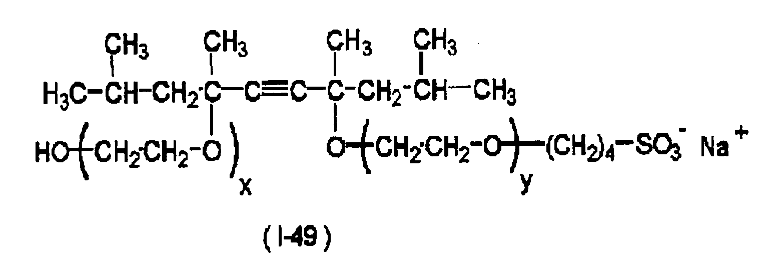

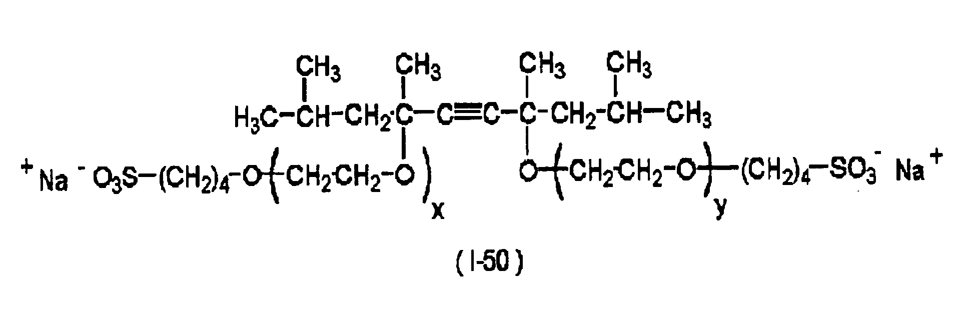

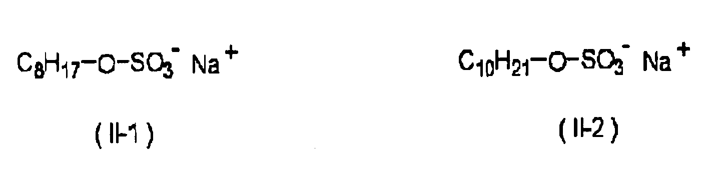

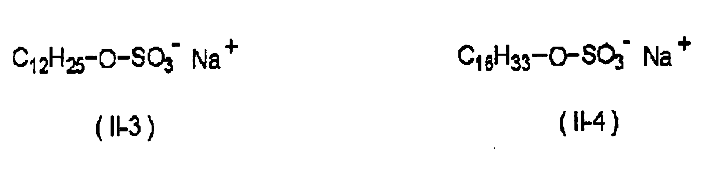

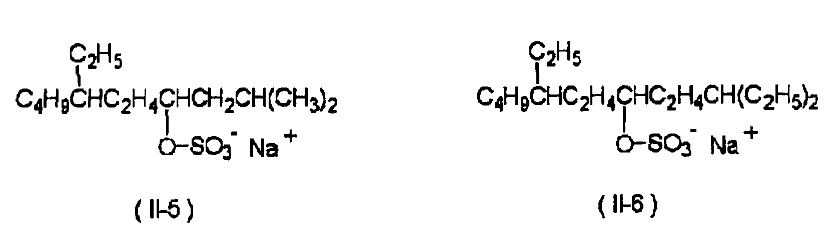

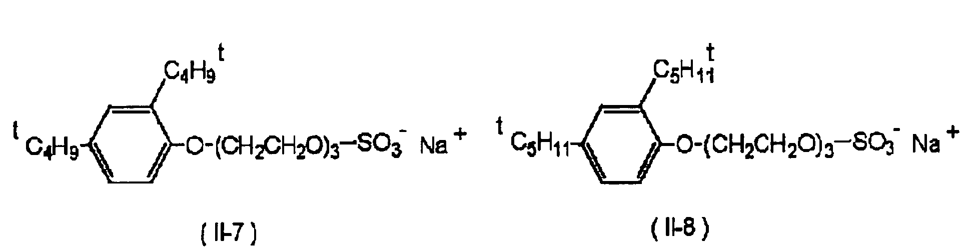

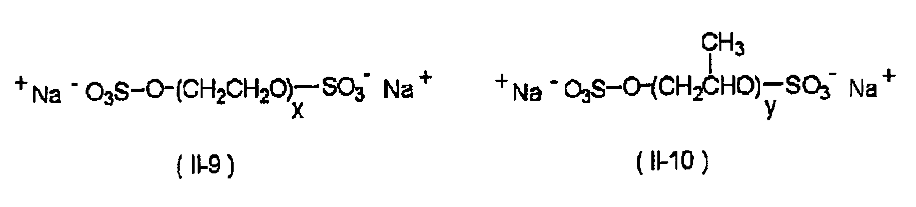

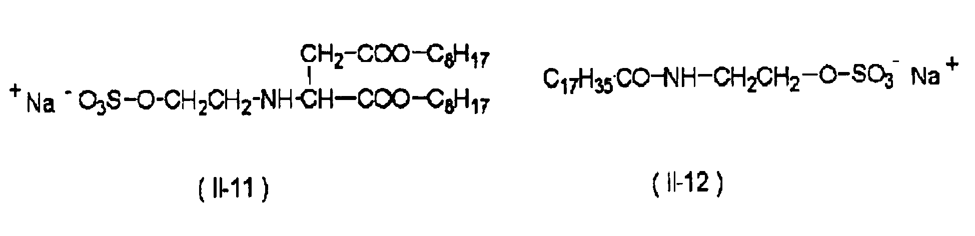

In the specific examples shown above, x and y each represent the repeating number of an ethylene oxide chain and the repeating number of a propylene oxide chain respectively, and each represent an integer of 1 to 20 on average. The compound represented by Formula (XI) or (XII) is added in an amount of preferably 0.01 to 20% by mass, more preferably 0.1 to 15% by mass, even more preferably 0.5 to 10% by mass, with respect to the developer, in order to exhibit its effect. A too small amount of the compound added causes deterioration in developability and in the solubility of the components in the recording layer, while an excess amount thereof causes deterioration in the printing durability of the printing plate.
The compounds represented by Formula (XI) or (XII) may be generally available in the marker. Examples of commercial products of the compounds include those manufactured by Asahi Denka Co., Ltd., Kao Corporation, Sanyo Chemical Industries, Ltd., New Japan Chemical Co., Ltd., Dai-ichi Kogyo Seiyaku Co., Ltd., Takemoto Oil & Fat Co., Ltd., Toho Chemical Industry Co., Ltd., and NOF Corporation.

### [2] Alkali silicate having an SiO₂/M₂O molar ratio of 0.75 to 4.0

The developer used in the invention may be an alkaline aqueous solution including at least an alkali silicate having an SiO₂/M₂O molar ratio of 0.75 to 4.0 (hereinafter referred to sometimes as "specific alkali silicate") and the anionic surfactant. M represents an alkali metal or an ammonium group.

Usually, the specific alkali silicate is used in combination with a base so that the pH of the developer is from 12.0 to 12.8. The alkali silicate is a salt that becomes alkaline when dissolved in water, and examples thereof include sodium silicate, potassium silicate, lithium silicate, and ammonium silicate.

One of the specific alkali silicates may be used or two or more of them may be used in combination. The developer used in the invention may be optimally adjusted by controlling the mixing ratio and the concentrations of silicon oxide (SiO₂), which is a component of the silicate salt used as a hydrophilizing component for a substrate, and an alkali oxide (M₂O, wherein M represents an alkali metal or an ammonium group) which is used as an alkali component. The mixing ratio of silicon oxide (SiO₂) to alkali oxide (M₂O) (SiO₂/M₂O molar ratio) is in the range of from 0.75 to 4.0, preferably in the range of from 0.75 to 3.0, and more preferably in the range of from 0.75 to 1.5. When the SiO₂/M₂O ratio is less than 0.75, there may arise a problem, namely that the alkalinity becomes so strong that an anodic oxide film on an aluminum substrate, which is a support of the planographic printing plate precursor, is excessively dissolved (etched) by the solution, generating stains when the support is left unused, or generating insoluble smuts caused by the formation of a complex of the dissolved aluminum and silicate. When the SiO₂/M₂O ratio is more than 4.0, or even more than 3.0, there may arise problems of deteriorated developability and the generation of insoluble smuts formed by the condensation of silicates. The concentration of the alkali silicate in the developer is preferably in the range of 0.5 to 10% by mass, more preferably 3 to 8% by mass, with respect to the mass of the alkali aqueous solution. When the concentration is less than 0.5% by mass, developability and development processability may be deteriorated, while when the concentration is more than 10% by mass, precipitates or crystals may easily be formed, and gelling may easily occur upon the neutralization of a waste liquid, which hinders waste liquid treatment.

### [3] Other components included in the developer used in the invention

### (1) Alkali agent

The developer used in the invention may include an alkali agent. Examples of the alkali agent include those derived from alkali oxide M₂O, and also include: inorganic alkali agents such as sodium tertiary phosphate, potassium tertiary phosphate, ammonium tertiary phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, potassium hydroxide, ammonium hydroxide, or lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, or tetramethylammonium hydroxide. These alkali agents may be used alone or as a combination of two or more thereof.

### (2) Chelating agent

The developer in the invention may also include a chelating agent. Examples of the chelating agent include: polyphosphates such as Na₂P₂O₇, Na₅P₃O₃, Na₃P₃O₉, Na₂O₄P(NaO₃P)PO₃Na₂, and Calgon (sodium polymetaphosphate); amino-polycarboxylic acids such as ethylenediamine tetraacetic acid and potassium and sodium salts thereof, diethylenetriamine pentaacetic acid and potassium and sodium salts thereof, triethylenetetramine hexaacetic acid and potassium and sodium salts thereof, hydroxyethylethylenediamine triacetic acid and potassium and sodium salts thereof, nitrilotriacetic acid and potassium and sodium salts thereof, 1,2-diaminocyclohexane tetraacetic acid and potassium and sodium salts thereof, or 1,3-diamino-2-propanol tetraacetic acid and potassium and sodium salts thereof; and organic phosphonic acids such as 2-phosphonobutane tricarboxylic acid-1,2,4 and potassium and sodium salts thereof, 2-phosphonobutanone tricarboxylic acid-2,3,4 and potassium and sodium salts thereof, 1-phosphonoethane tricarboxylic acid-1,2,2 and potassium and sodium salts thereof, 1-hydroxyethane-1,1-diphosphonic acid and potassium and sodium salts thereof, and aminotri(methylenephosphonic acid) and potassium and sodium salts thereof. The optimum amount of the chelating agent varies depending on the hardness and the amount of hard water used. However, the amount of the chelating agent in the developer is generally in the range of 0.01 to 5% by mass and preferably 0.02 to 1% by mass.

### (3) Surfactant

The developer used in the invention may also include other surfactants in addition to the surfactant described above. Examples of the other surfactants include: nonionic surfactants such as ethylene oxide and/or propylene oxide adducts of long-chain alcohol or polyhydric alcohol having, in a molecule thereof, an ethylene oxide chain and/or a propylene oxide chain, specifically polyoxyethylene alkyl esters such as polyoxyethylene stearate, ethylene oxide and/or propylene oxide adducts such as sorbitan monolaurate, sorbitan monostearate, sorbitan distearate, sorbitan monooleate, sorbitan sesquioleate, or sorbitan trioleate, ethylene oxide and/or propylene oxide adducts such as glycerol monostearate or glycerol monooleate; and amphoteric surfactants such as alkyl betaines such as lauryl betaine and stearyl betaine, and amino acids, among which nonionic surfactants such as ethylene oxide and/or propylene oxide adducts of long-chain alcohol or polyhydric alcohol are particularly preferable. These surfactants may be used alone or in combination thereof. The amount of the surfactants in the developer is preferably 0.1 to 20% by mass in terms of active components.

### (4) Other components

The developer used in the invention may further include the following components in addition to the components described above, as required. Examples of such components include organic carboxylic acids such as benzoic acid, phthalic acid, p-ethylbenzoic acid, p-n-propylbenzoic acid, p-isopropylbenzoic acid, p-n-butylbenzoic acid, p-t-butylbenzoic acid, p-2-hydroxyethylbenzoic acid, decanoic acid, salicylic acid or 3-hydroxy-2-naphthoic acid; organic solvents such as isopropyl alcohol, benzyl alcohol, ethyl cellosolve, butyl cellosolve, phenyl cellosolve, propylene glycol or diacetone alcohol; reducing agents; dyes; pigments; water-softening agents; and preservatives. When development treatment is conducted with an automatic developer in the plate-making method of the invention, the developer is exhausted depending on throughput. Therefore, processing power may be recovered by using a replenisher or a fresh developer.

Now, the properties of the developer are described in detail. pH
In requirements of the developer, in the above measurement and in evaluation of printing performance, the developer for the negative planographic printing plate has a pH preferably in the range of 11.5 to 12.8, more preferably in the range of 11.8 to 12.7, even more preferably in the range of 12.2 to 12.7, thereby producing the best results. When the pH is less than 11.5, development deficiency may easily occur and stains may be easily generated during printing. When the pH is more than 12.8, the developer may easily penetrate into a film photopolymerized by exposure to light, whereby an image region is damaged, and deterioration in printing durability at the time of printing may apt to occur.

### Electrical conductivity

The electrical conductivity of the developer used in the invention is preferably in the range of 3 to 40 mS/cm, preferably 10 to 30 mS/cm, more preferably 15 to 30 mS/cm. When the electrical conductivity is less than 3 mS/cm, the alkali strength may be so low that developability may be deteriorated, and the processing ability of the developer may be deteriorated when the developer is exhausted or stored for a long period of time. When the electrical conductivity is more than 40 mS/cm, even than 30 mS/cm, the alkali strength may be so high that a photopolymerized image region may be highly damaged, while the salt concentration may be increased, resulting in salt precipitation or the like between extremely small image regions to cause a residual film in some cases.

### Foaming ability

The forming ability of the developer in the invention is preferably low. Specifically, when the defoaming time of the developer is 5 minutes or less, the developer may be prevented from being foamed during development, thus preventing the development step from being troubled. The foaming ability may be measured by the following method. 30 ml of the developer is introduced into a 100-ml transparent glass bottle having an inner diameter of 3 cm, and then the glass bottle is shaken up and down 3 times per second at 25°C for 1 minute. Thereafter, the bottle is left stand, and the time (defoaming time) until the foam disappears is determined. A shorter defoaming time is preferable because it indicates lower foaming ability (i.e., higher defoaming ability).

### Color

The developer used in the invention may be colorless, but is preferably colored to such a degree as to attain visibility, for the purpose of preventing it from false recognition for water.
The developer in the invention may be prepared just before use by diluting its concentrate with water. In the invention, the viscosity of the developer in a state diluted with water is preferably 1.0 to 10.0 cp at 25°C in order to facilitate development treatment.

### Light exposure

The light source used in light exposure may be any device capable of emitting light having a wavelength of from 750 nm to 1400 nm, and an example thereof is an infrared laser. In particular, image exposure is preferably conducted using a solid laser or a semiconductor laser that emits an infrared ray having a wavelength of from 750 nm to 1400 nm. The laser preferably has an output of 100 mW or more, and a multi-beam laser device may preferably be used for reducing the light exposure time. The light exposure time for one pixel is preferably 20 microseconds or less. The amount of radiation energy applied per unit area of the planographic printing plate precursor is preferably from 10 to 300 mJ/cm².

The light exposure can be carried out by overlapping beams from a light source. The term "overlapping" means that exposure is conducted under such a condition that the sub-scanning pitch is smaller than the beam diameter. For example, when the beam diameter is expressed in terms of full-width at half-maximum (FWHM) of the beam intensity, overlapping can be quantitatively expressed in FWHM/sub-scanning pitch (overlapping coefficient). In the invention, the overlapping coefficient is preferably 0.1 or more.
The scanning system for a light source in the light exposure device is not particularly limited, and a drum outer surface scanning method, a drum inner surface scanning method, a flatbed scanning method, or the like may be used. The channel of the light source may be a single channel or a multi-channel, but in the case of the drum outer surface scanning method, a multi-channel is preferably used.

For the purpose of increasing the degree of curing of the recording layer, a heating process at a temperature of 50°C to 140°C for 1 second to 5 minutes may be conducted after image exposure until development. When the heating temperature is within this range, the degree of curing may be increased, and a residual film formed by polymerization of a light-unexposed region in the dark may not be generated.

As described above, an oxygen barrier layer (protective layer) is arranged on the recording layer of the negative planographic printing plate in the invention. There is known a method of removing an oxygen barrier layer and simultaneously removing a light-unexposed region of a recording layer by using a developer, or a method of first removing an oxygen barrier layer by using water or hot water and then removing a recording layer on a light-unexposed region by development. The water or hot water may include a preservative or the like described in JP-A No. 10-10754, an organic solvent or the like described in JP-A No. 8-278636, or the like.

The development, by using the developer, of the negative planographic printing plate in the invention may be conducted in a usual manner, for example, by immersing the exposed negative planographic printing plate in the developer and dipping it at a temperature of 0 to 60°C, preferably at a temperature of about 15 to 40°C.

When the development is conducted with an automatic developing machine, the developer is exhausted depending on throughput. Therefore, processing capability may be recovered by using a replenisher or a fresh developer. The negative planographic printing plate thus developed is then post-treated with washing water, a rinse including a surfactant or the like, or a desensitizing solution including gum arabic, starch derivative or the like as described in JP-A No. 54-8002, JP-A No. 55-115045 and JP-A No. 59-58431. In the invention, a combination of these treatments may be used in the post-treatment of the negative planographic printing plate.

The printing plate obtained by these treatments may be subjected to a post-exposure treatment or heating treating such as burning as described in JP-A 2000-89478, whereby printing durability of the printing plate may be improved. The planographic printing plate obtained by such treatment may be loaded onto an offset printing machine and used for printing of a large number of sheets.

Hereinafter, exemplary embodiments of the present invention are described.
(1) A method of producing a negative planographic printing plate, comprising:
   exposing, to an infrared laser, a negative planographic printing plate precursor at least having a hydrophilic support, and on the hydrophilic support, a polymerizable recording layer including (A) an infrared absorber, (B) an onium salt, (C) a polymerizable compound having a urethane bond and a plurality of ethylenically unsaturated bonds, and (D) a polyurethane binder, and
   developing the precursor by using a developer which has a pH of from 11.5 to 12.8 and includes an alkali silicate and an anionic surfactant, the alkali silicate having an SiO₂/M₂O molar ratio of 0.75 to 4.0, wherein M represents an alkali metal or an ammonium group.
(2) The method of producing a negative planographic printing plate of item (1),
   wherein the anionic surfactant comprises a compound including a sulfonate anion group or a sulfate monoester anion group.
(3) The method of producing a negative planographic printing plate of item (2),
   wherein the compound including a sulfonate anion group or a sulfate monoester anion group is represented by Formula (XI) or (XII): 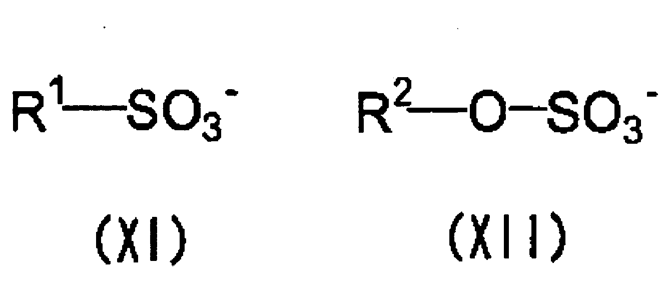 wherein R¹ and R² each represent an optionally substituted alkyl group, an optionally substituted cycloalkyl group, an optionally substituted alkenyl group, an optionally substituted aralkyl group or an optionally substituted aryl group.
(4) The method of producing a negative planographic printing plate of item (1),
   wherein the alkali silicate is selected from the group consisting of sodium silicate, potassium silicate, lithium silicate, and ammonium silicate.
(5) The method of producing a negative planographic printing plate of item (1),
   wherein the (D) polyurethane binder has a polymerizable group in a side chain thereof.
(6) The method of producing a negative planographic printing plate of item (5),
   wherein the polymerizable group is selected from the group consisting of an ethylenically unsaturated binding group, an amino group, and an epoxy group.
(7) The method of producing a negative planographic printing plate of item (6),
   wherein the polymerizable group comprises a functional group represented by any one of Formulae (41) to (43): 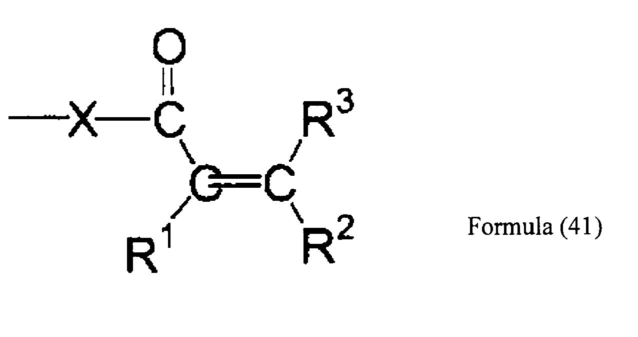 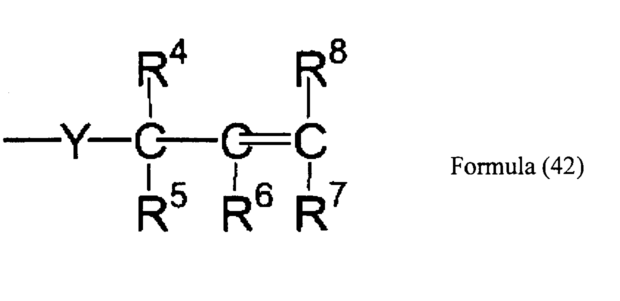 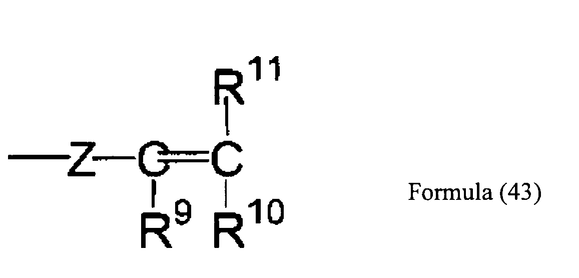 wherein in Formula (41), R¹ to R³ each independently represent a hydrogen atom or a monovalent organic group; and X represents an oxygen atom, a sulfur atom or N(R¹²)
   wherein R¹² represents a hydrogen atom or a monovalent organic group;
   in Formula (42), R⁴ to R⁸ each independently represent a hydrogen atom or a monovalent organic group; and Y represents an oxygen atom, a sulfur atom, or N(R¹²)
   wherein R¹² represents a hydrogen atom or a monovalent organic group; and
   in Formula (43), R⁹ represents a hydrogen atom or an optionally substituted alkyl group; R¹⁰ to R¹¹ each independently represent a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group; and Z represents an oxygen atom, a sulfur atom, N(R¹²) or an optionally substituted phenylene group wherein R¹² represents a hydrogen atom or a monovalent organic group.
(8) The method of producing a negative planographic printing plate of item (1),
   wherein the (D) polyurethane binder is obtained by a polyaddition reaction of (i) a diisocyanate compound, (ii) a diol compound having at least one carboxyl group, and (iii) another diol compound not having a carboxyl group.
(9) The method of producing a negative planographic printing plate of item (I),
   wherein the (D) polyurethane binder has a weight-average molecular weight of 2,000 to 1,000,000.
(10) The method of producing a negative planographic printing plate of item (1), wherein the (C) polymerizable compound having a urethane bond and a plurality of ethylenically unsaturated bonds is represented by Formula (1):

   X-R-U-A-U-R-X Formula (1)

   wherein A represents an alkylene group, an aralkylene group, an arylene group or an oxyalkylene group; U represents a urethane bond; X represents a methacryloyl group, an acryloyl group or a vinyl group; and R represents a divalent linking group.
(11) The method of producing a negative planographic printing plate of item (1), wherein the (C) polymerizable compound having a urethane bond and a plurality of ethylenically unsaturated bonds is represented by Formula (3):

   D-(-U-R-(X)ₘ)ₙ Formula (3)

   wherein m represents 2 or 3; n represents 2 or 3; D represents a divalent or trivalent group; U represents a urethane bond; R represents a trivalent or tetravalent linking group including a carbon atom or a combination of carbon and oxygen atoms; and X represents a methacryloyl group, an acryloyl group or a vinyl group.
(12) The method of producing a negative planographic printing plate of item (1), wherein the amount of the (C) polymerizable compound having a urethane bond and a plurality of ethylenically unsaturated bonds is 10 to 60% by mass with respect to the total solid content of the recording layer.
(13) The method of producing a negative planographic printing plate of item (1),
wherein the developer has an electrical conductivity of from 3 to 40 mS/cm.

### EXAMPLES

Hereinafter, the invention is described in detail by referring to the Examples, but the invention is not limited thereto.

### Preparation of an aluminum support (hydrophilic support)

An aluminum plate having a thickness of 0.3 mm was subjected to etching by dipping it in a 10% by mass aqueous sodium hydroxide solution at 60°C for 25 seconds, then washed with running water, neutralized and washed with a 20% by mass aqueous nitric acid solution, and then washed with water. The resultant aluminum plate was subjected to an electrolytic surface roughening process with a sinusoidal AC waveform current under the condition of an electric quantity of 300 C/dm² (when the plate serves as an anode) in a 1% by mass aqueous nitric acid solution. Subsequently, the aluminum plate was dipped in a 1% by mass aqueous sodium hydroxide solution at 40°C for 5 seconds, and then subjected to desmutting treatment by dipping it in a 30% by mass aqueous sulfuric acid solution at 60°C for 40 seconds. Thereafter, the aluminum plate was subjected to anodizing treatment for 2 minutes in a 20% by mass aqueous sulfuric acid solution under the condition of an electric current density of 2 A/dm² so that the thickness of the resultant anodized film was 2.7 g/m². The surface roughness was measured and was found to be 0.3 µm (expressed in Ra in accordance with JIS B0601 (ISO 4287 (1997)).

### Formation of an intermediate layer

An intermediate layer solution described below was applied by using a bar coater onto the electrically roughened aluminum plate and then dried at 80°C for 20 seconds. The weight of the intermediate layer after drying was 25 mg/m².

Intermediate layer solution
- Sol liquid described below 100 g
- Methanol 900 g

Sol liquid
- Phosmer PE (trade name, manufactured by Unichemical Co.) 5 g
- Methanol 45 g
- Water 10 g
- 85% by mass phosphoric acid 5 g
- Tetraethoxysilane 20 g
- 3-Methacryloxypropyltrimethoxysilane 15 g

### Formation of a recording layer

A high-sensitivity photopolymerizable composition P-1 having the following composition was applied onto the intermediate layer formed on the support in such an amount that the weight of the dried coating of the composition became 1.4 g/m², and then the composition was dried at 100°C for 1 minute, to thereby form a recording layer. Separately, a photopolymerizable composition P-2 described below and a photopolymerizable composition P-3 described below were prepared for comparative examples.

### Photopolymerizable composition P-1

- (C) Polymerizable compound having a urethane bond and plural ethylenically unsaturated bonds (AM-1) 4.2 parts by mass
- (D) Polyurethane binder (BT-1) 3.6 parts by mass
- (A) Infrared absorber (IR-1) 0.31 part by mass
- (B) Onium salt (OS-12) 1.2 parts by mass
- ε-Phthalocyanine dispersion 0.92 part by mass
- Fluorine-containing nonionic surfactant Megafac F780 (registered name, manufactured by Dainippon Ink and Chemicals, Inc.) 0.05 part by mass
- Methyl ethyl ketone 62 parts by mass
- Propylene glycol monomethyl ether acetate 57 parts by mass

### Photopolymerizable composition P-2

A photopolymerizable composition P-2 was prepared which had the same composition as that of the photopolymerizable composition P-1 except that an ethylenically unsaturated bond-containing polymerizable compound (AM-2) was used in place of the (C) polymerizable compound having a urethane bond and plural ethylenically unsaturated bonds (AM-1) used for the photopolymerizable composition P-1.

### Photopolymerizable composition P-3

A photopolymerizable composition P-3 was prepared which had the same composition as that of the photopolymerizable composition P-1 except that an acrylic binder (BT-2) was used in place of the (D) polyurethane binder (BT-1) used for the photopolymerizable composition P-1.
Hereinafter, the structures of the compounds used for the photopolymerizable compositions P-1 to P-3 are shown below. In (BT-2), numerical values next to round brackets indicate mole fraction.

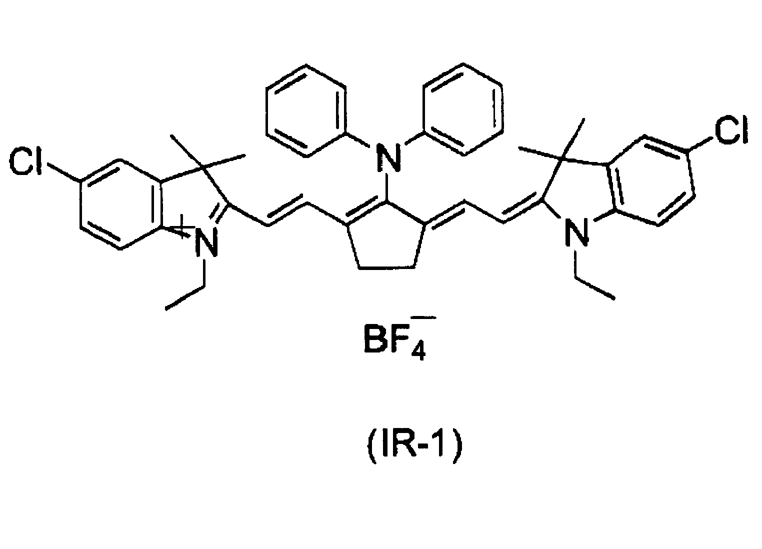

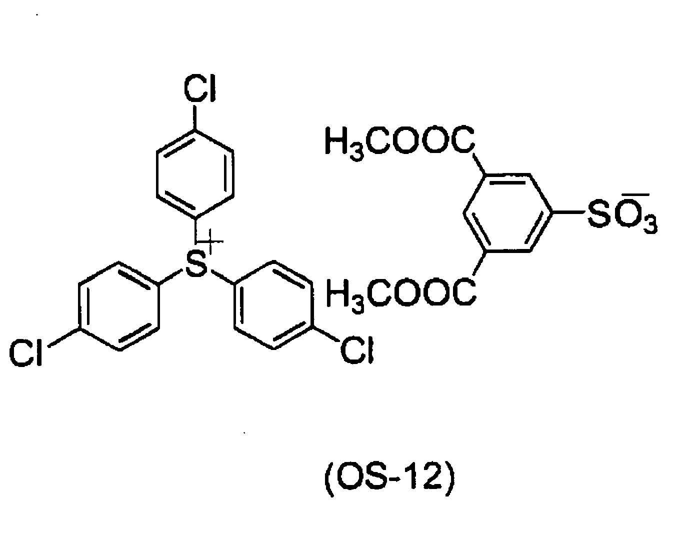

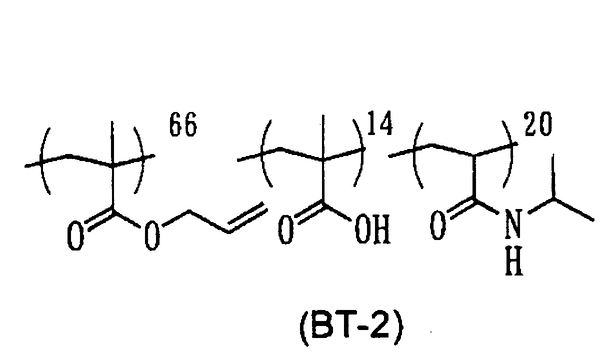

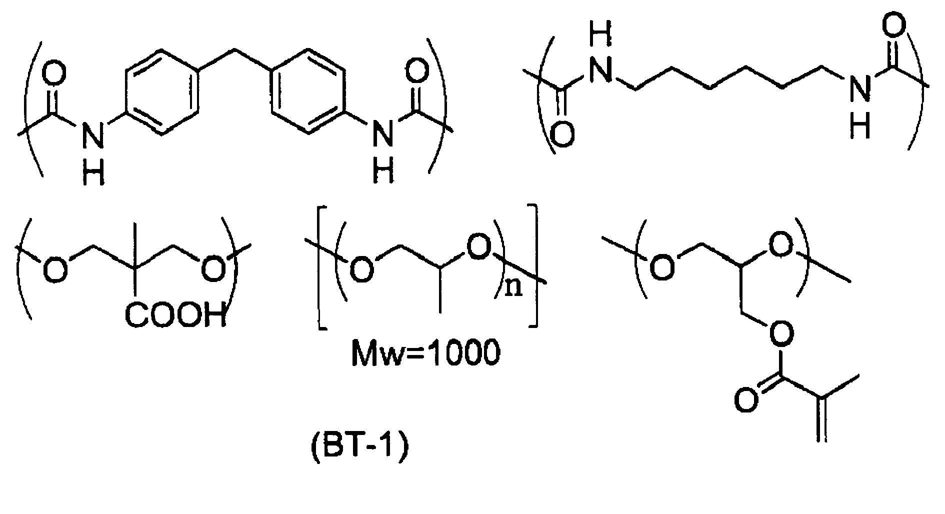

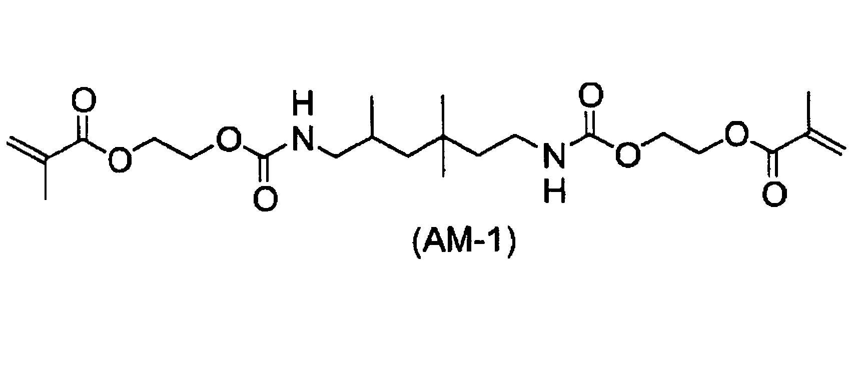

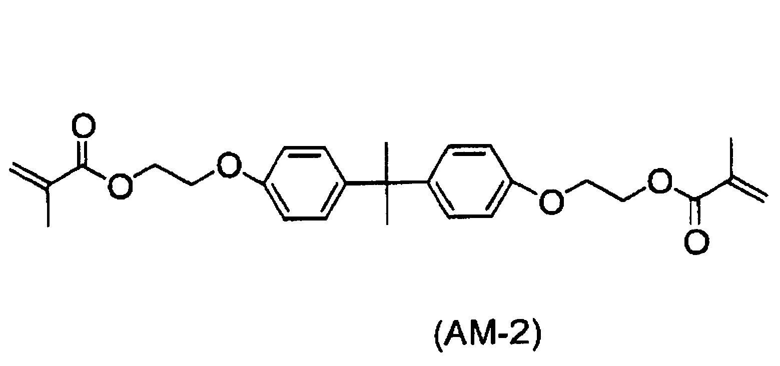

### Formation of a protective layer

An aqueous mixed solution of polyvinyl alcohol (degree of saponification: 98 mole%; degree of polymerization: 500) and polyvinyl pyrrolidone (Rubiscol K-30, registered name, manufactured by BASF) was applied by using a wire bar onto the surface of the recording layer and dried at 125°C for 75 seconds in a hot-air drying oven to form a protective layer, whereby a planographic printing plate precursor (negative planographic printing plate precursor) was prepared. The ratio of polyvinyl alcohol to polyvinyl pyrrolidone (polyvinyl alcohol/polyvinyl pyrrolidone) included in the protective layer was 4/1 (mass ratio), and the coating amount of the aqueous mixed solution (coating amount after drying) was 2.45 g/m².

Further, alkali developers 1 to 7 (of those, alkali developers 4 to 7 are for comparative examples) were prepared.
Alkali developer 1
- Potassium hydroxide 0.40 g
- Potassium carbonate 0.17 g
- Anionic surfactant (K-1) 4.1 g
- Chelest 400 (chelating agent, manufactured by Chelest Corp.) 0.1 g
- 1 K potassium silicate (50%) (manufactured by Nippon Chemical Industrial Co., Ltd.) SiO₂/M₂O = 1.7 1.5 g
- Water 93.73 g
The alkali developer 1 including the above composition was prepared, and the alkali developer 1 had a pH of 12.30 (at 25°C).

### Alkali developer 2

An alkali developer 2 (pH 12.30 (at 25°C)) was prepared which had the same composition as that of the alkali developer 1 except that an anionic surfactant (K-2) was used in place of the anionic surfactant (K-1).

### Alkali developer 3

An alkali developer 3 (pH 12.30 (at 25°C)) was prepared which had the same composition as that of the alkali developer 1 except that an anionic surfactant (K-3) was used in place of the anionic surfactant (K-1).

### Alkali developer 4

An alkali developer 4 (pH 12.30 (at 25°C)) was prepared which had the same composition as that of the alkali developer 1 except that a nonionic surfactant (K-4) was used in place of the anionic surfactant (K-1).

### Alkali developer 5

An alkali developer 5 (pH 12.30 (at 25°C)) was prepared which had the same composition as that of the alkali developer 1 except that a nonionic surfactant (K-5) was used in place of the anionic surfactant (K-1).

### Alkali developer 6

An alkali developer 6 (pH 12.30 (at 25°C)) was prepared which had the same composition as that of the alkali developer 1 except that a nonionic surfactant (K-6) was used in place of the anionic surfactant (K-1).

### Alkali developer 7

An alkali developer 7 was prepared which had the same composition as that of the alkali developer 1 except that 1K potassium silicate (50%) was not used, and the amount of potassium hydroxide was changed to such an amount that the pH of the alkali developer 7 is 12.05 (at 25°C).

### Alkali developer 8

An alkali developer 8 was prepared which had the same composition as that of the alkali developer 1 except that the amount of potassium hydroxide was changed to such an amount that the pH of the alkali developer 8 is 11.0 (at 25°C).

### Alkali developer 9

An alkali developer 9 was prepared which had the same composition as that of the alkali developer 1 except that the amount of potassium hydroxide was changed to such an amount that the pH of the alkali developer 9 is 13.0 (at 25°C).

### Alkali developer 10

An alkali developer 10 was prepared which had the same composition as that of the alkali developer 1 except that 1K potassium silicate was changed to that having a SiO₂/M₂O ratio of 0.5.

### Alkali developer 11

An alkali developer 11 was prepared which had the same composition as that of the alkali developer 1 except that 1K potassium silicate was changed to that having a SiO₂/M₂O ratio of 4.5.
The structures of the compounds used in the alkali developers 1 to 11 are shown below.

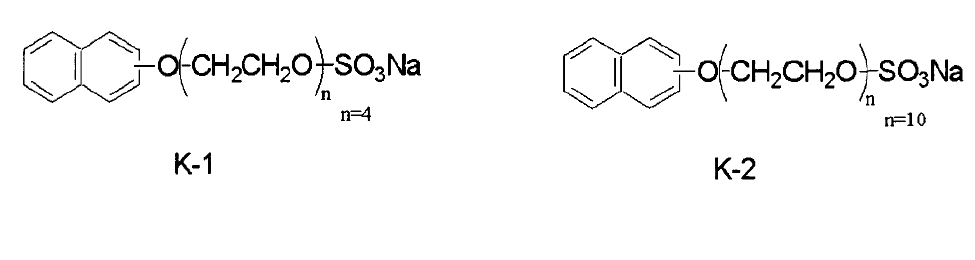

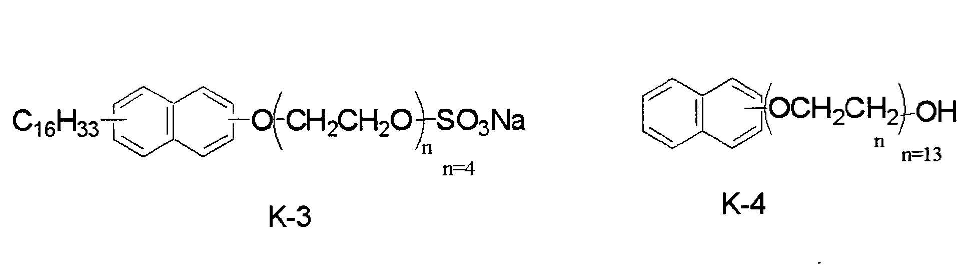

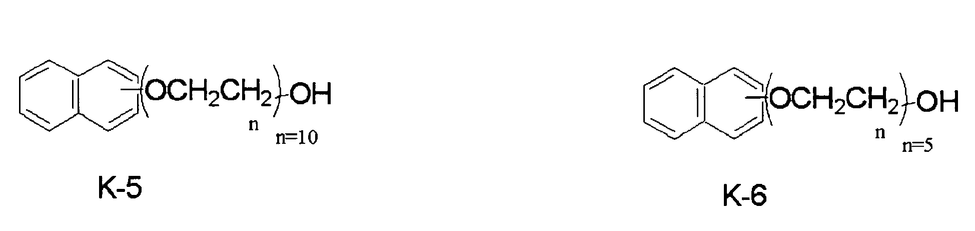

### Example 1

### Evaluation

### (1) Printing durability

The resultant planographic printing plate precursor was exposed to light at an output power of 4.5 W, an external drum rotation speed of 150 rpm, and a plate surface energy of 70 mJ/cm², to form a 80% halftone tint image having a resolution of 2400 dpi, with Trendsetter 3244 (trade name, manufactured by Creo Products, Inc.) Light exposure was carried out at 25°C at 50% RH. By using a PS processor IP850HD (trade name, manufactured by G&J) charged with the alkali developer 1 having the composition described above, the planographic printing plate precursor was developed under the conditions of a developing time of 28 seconds, a preheat temperature of 115°C, and a liquid temperature of 25°C. The planographic printing plate obtained by development was used in printing with a LITHRONE printing machine (trade name, manufactured by Komori Corporation) with a DIC-GEOS(N) Sumi ink (trade name, manufactured by Dainippon Ink And Chemicals, Inc.) The printing durability of the solid image region was evaluated in terms of the number of printed sheets obtained up to the point when the image was observed to be thinned upon visual examination. The results of this evaluation are shown in Table 1.

### (2) Staining resistance

The resultant planographic printing plate precursor was subjected to exposure and development in the same manner as in the evaluation of the printing durability except that the precursor was sealed with an aluminum craft paper together with an interleaving paper therebetween, and left in such a state at 60°C for 3 days before exposure and development thereof. The planographic printing plate obtained by the same treatment as described above was used in printing with a LITHRONE printing machine (manufactured by Komori Corporation) to evaluate staining resistance on a non-image region. The results are shown in Table 1. The stain on the non-image region was sensorily evaluated under the following criteria wherein a score of 3 indicates the lowest level for practical use, and a score of 2 or less indicates a level unacceptable in practice.
5: No problems
4: Slight staining discernible with a magnifying glass
3: Staining on a small portion, discernible by close observation with the naked eye
2: Partial staining discernible with the naked eye
1: Overall staining discernible at a glance

### Development scum

A planographic printing plate precursor with no image in the whole area thereof (a light-unexposed plate) was developed using the above developing bath at an amount of 60 to 70 m² per day for 2 months, and then scums adhering to the plate, and staining on a nip roller at the discharge side of the developing bath, were visually evaluated based on the following criteria. The results of this evaluation are shown in Table 1. In the evaluation results, a score of 3 indicates the lowest level for practical use, and a score of 2 or less indicates a level unacceptable in practice.
5: No problems.
4: No scum adhering on the plate; slight staining on the nip roller at the discharge side of the developing bath; slight staining on the bottom of the developing bath, which may be easily washed away with running water.
3: No scum adhering on the plate; slight staining on the nip roller at the discharge side of the developing bath; moderate staining on the bottom of the developing bath, which may be easily washed away with running water.
2: No scum adhering on the plate; slight staining on the nip roller at the discharge side of the developing bath; significant staining on the bottom of the developing bath, which cannot be washed away unless it is strongly rubbed.
1: Scums in many places; severe staining on the developing machine.

### Examples 2 to 3 and Comparative Examples 1 to 10

Planographic printing plate precursors were prepared and evaluated in the same manner as in Example 1, except that the photopolymerizable composition used in the formation of the recording layer of the planographic printing plate precursor, and the alkali developer, were respectively changed to those shown in Table 1. The results of this evaluation are shown in Table 1.

**Table 1**

| | Photopolymerizable composition | Alkali developer | Evaluation results | | |
|---|---|---|---|---|---|
| | | | Printing durability | Staining resistance | Development scum |
| Example 1 | Photopolymerizable composition P-1 | Alkali developer 1 | 300,000 | 5 | 5 |
| Example 2 | Photopolymerizable composition P-1 | Alkali developer 2 | 250,000 | 5 | 5 |
| Example 3 | Photopolymerizable composition P-1 | Alkali developer 3 | 250,000 | 5 | 4 |
| Comparative example 1 | Photopolymerizable composition P-1 | Alkali developer 4 | 300,000 | 5 | 3 |
| Comparative example 2 | Photopolymerizable composition P-1 | Alkali developer 5 | 250,000 | 5 | 2 |
| Comparative example 3 | Photopolymerizable composition P-1 | Alkali developer 6 | 250,000 | 5 | 2 |
| Comparative example 4 | Photopolymerizable composition P-1 | Alkali developer 7 | 300,000 | 3 | 5 |
| Comparative example 5 | Photopolymerizable composition P-2 | Alkali developer 1 | 150,000 | 5 | 5 |
| Comparative example 6 | Photopolymerizable composition P-3 | Alkali developer 1 | 150,000 | 5 | 5 |
| Comparative example 7 | Photopolymerizable composition P-1 | Alkali developer 8 | 300,000 | 2 | 2 |
| Comparative example 8 | Photopolymerizable composition P-1 | Alkali developer 9 | 200,000 | 2 | 5 |
| Comparative example 9 | Photopolymerizable composition P-1 | Alkali developer 10 | 300,000 | 4 | 2 |
| Comparative example 10 | Photopolymerizable composition P-1 | Alkali developer 11 | 200,000 | 5 | 4 |

As shown in Table 1, Examples 1 to 3 have excellent printing durability and staining resistance, and have less development scum.

## Claims

1. A method of producing a negative planographic printing plate, comprising:
exposing, to an infrared laser, a negative planographic printing plate precursor at least having a hydrophilic support, and on the hydrophilic support, a polymerizable recording layer including (A) an infrared absorber, (B) an onium salt, (C) a polymerizable compound having a urethane bond and a plurality of ethylenically unsaturated bonds, and (D) a polyurethane binder, and
developing the precursor by using a developer which has a pH of from 11.5 to 12.8 and includes an alkali silicate and an anionic surfactant, the alkali silicate having an SiO₂/M₂O molar ratio of 0.75 to 4.0, wherein M represents an alkali metal or an ammonium group.

2. The method of producing a negative planographic printing plate of claim 1, wherein the anionic surfactant comprises a compound including a sulfonate anion group or a sulfate monoester anion group.

3. The method of producing a negative planographic printing plate of claim 2, wherein the compound including a sulfonate anion group or a sulfate monoester anion group is represented by Formula (XI) or (XII): 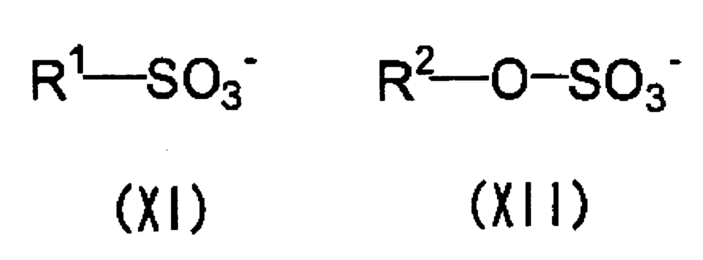 wherein R¹ and R² each represent an optionally substituted alkyl group, an optionally substituted cycloalkyl group, an optionally substituted alkenyl group, an optionally substituted aralkyl group or an optionally substituted aryl group.

4. The method of producing a negative planographic printing plate of claim 1,
wherein the alkali silicate is selected from the group consisting of sodium silicate, potassium silicate, lithium silicate, and ammonium silicate.

5. The method of producing a negative planographic printing plate of claim 1, wherein the (D) polyurethane binder has a polymerizable group in a side chain thereof.

6. The method of producing a negative planographic printing plate of claim 5, wherein the polymerizable group is selected from the group consisting of an ethylenically unsaturated binding group, an amino group, and an epoxy group.

7. The method of producing a negative planographic printing plate of claim 6, wherein the polymerizable group comprises a functional group represented by any one of Formulae (41) to (43): 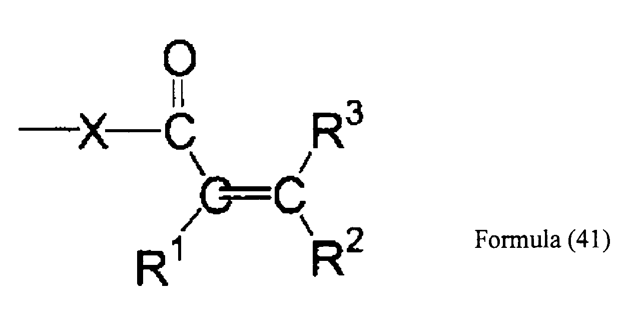 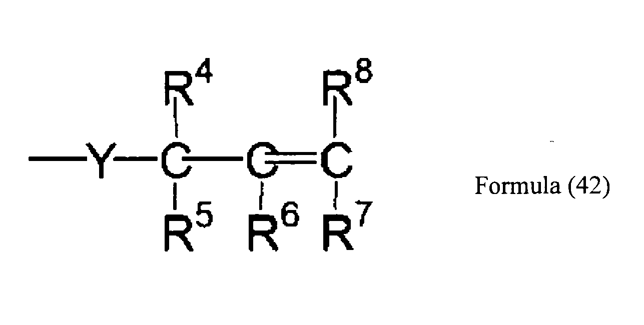 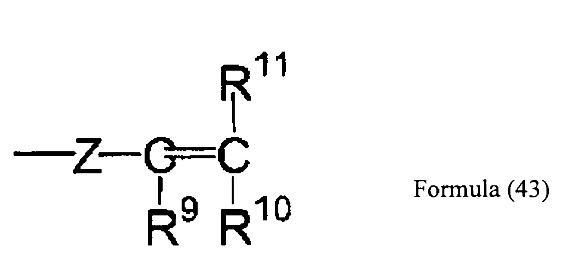 wherein
in Formula (41), R¹ to R³ each independently represent a hydrogen atom or a monovalent organic group; and X represents an oxygen atom, a sulfur atom or N(R¹²) wherein R¹² represents a hydrogen atom or a monovalent organic group;
in Formula (42), R⁴ to R⁸ each independently represent a hydrogen atom or a monovalent organic group; and Y represents an oxygen atom, a sulfur atom, or N(R¹²) wherein R¹² represents a hydrogen atom or a monovalent organic group; and
in Formula (43), R⁹ represents a hydrogen atom or an optionally substituted alkyl group; R¹⁰ to R¹¹ each independently represent a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group; and Z represents an oxygen atom, a sulfur atom, N(R¹²) or an optionally substituted phenylene group wherein R¹² represents a hydrogen atom or a monovalent organic group.

8. The method of producing a negative planographic printing plate of claim 1, wherein the (D) polyurethane binder is obtained by a polyaddition reaction of (i) a diisocyanate compound, (ii) a diol compound having at least one carboxyl group, and (iii) another diol compound not having a carboxyl group.

9. The method of producing a negative planographic printing plate of claim 1, wherein the (D) polyurethane binder has a weight-average molecular weight of 2,000 to 1,000,000.

10. The method of producing a negative planographic printing plate of claim 1, wherein the (C) polymerizable compound having a urethane bond and a plurality of ethylenically unsaturated bonds is represented by Formula (1):
X-R-U-A-U-R-X Formula (1)
wherein A represents an alkylene group, an aralkylene group, an arylene group or an oxyalkylene group; U represents a urethane bond; X represents a methacryloyl group, an acryloyl group or a vinyl group; and R represents a divalent linking group.

11. The method of producing a negative planographic printing plate of claim 1, wherein the (C) polymerizable compound having a urethane bond and a plurality of ethylenically unsaturated bonds is represented by Formula (3):
D-(-U-R-(X)ₘ)ₙ Formula (3)
wherein m represents 2 or 3; n represents 2 or 3; D represents a divalent or trivalent group; U represents a urethane bond; R represents a trivalent or tetravalent linking group including a carbon atom or a combination of carbon and oxygen atoms; and X represents a methacryloyl group, an acryloyl group or a vinyl group.

12. The method of producing a negative planographic printing plate of claim 1, wherein the amount of the (C) polymerizable compound having a urethane bond and a plurality of ethylenically unsaturated bonds is 10 to 60% by mass with respect to the total solid content of the recording layer.

13. The method of producing a negative planographic printing plate of claim 1, wherein the developer has an electrical conductivity of from 3 to 40 mS/cm.
